(19) Europäisches Patentamt / European Patent Office / Office européen des brevets

(11) **EP 4 646 075 A1**

(12) **EUROPEAN PATENT APPLICATION**


(43) Date of publication:
**05.11.2025 Bulletin 2025/45**

(21) Application number: **24173160.3**

(22) Date of filing: **29.04.2024**

(51) International Patent Classification (IPC):
***H10K 30/30*** ***(2023.01)*** ***H10K 30/86*** ***(2023.01)***
***H10K 85/60*** ***(2023.01)***

(52) Cooperative Patent Classification (CPC):
**H10K 30/30; H10K 30/86; H10K 85/621; H10K 85/657; H10K 85/658;** H10K 30/85; H10K 39/34

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**



(71) Applicant: **Novaled GmbH**
**01099 Dresden (DE)**

(72) Inventors:
- **RUNGE, Steffen**
  **01099 Dresden (DE)**
- **WERNER, Ansgar**
  **01099 Dresden (DE)**

(74) Representative: **Michalski Hüttermann & Partner Patentanwälte mbB**
**Kaistraße 16A**
**40221 Düsseldorf (DE)**


(54) **ORGANIC PHOTODETECTOR, ORGANIC ELECTRONIC DEVICE COMPRISING THE ORGANIC PHOTOTECTOR AS WELL AS A DISPLAY DEVICE COMPRISING THE ORGANIC ELECTRONIC DEVICE**


(57) The present invention relates to an organic photodetector comprising an interlayer comprising a compound of formula (I), an organic electronic device comprising the organic phototector as well as an display device comprising the organic electronic device.


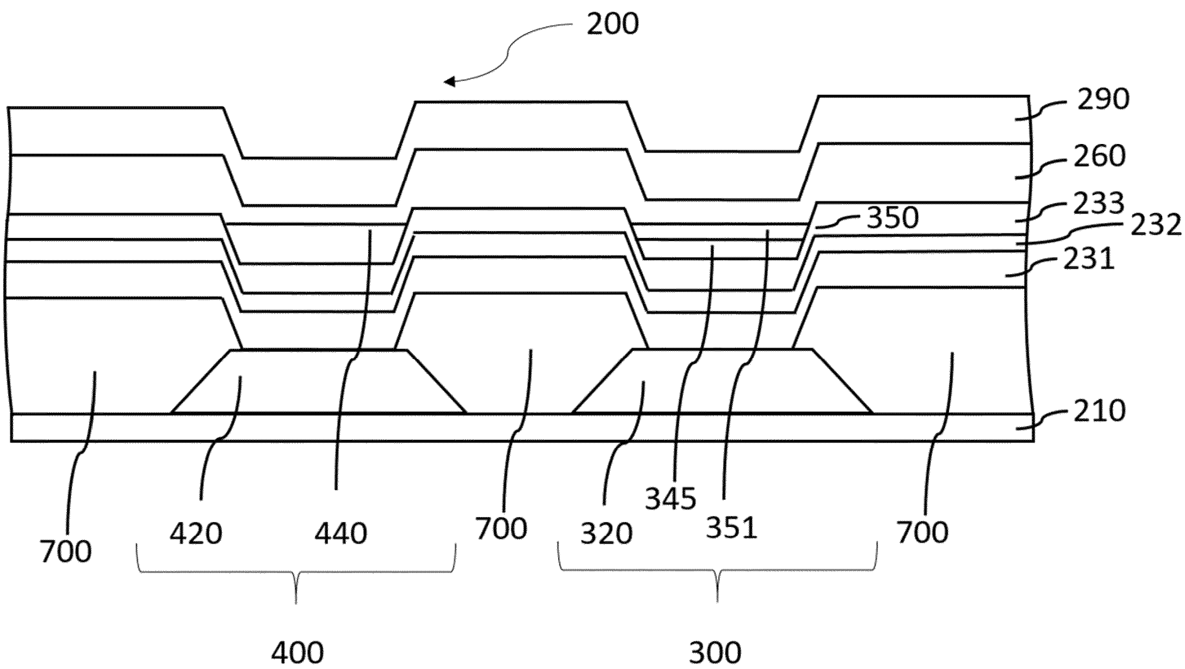


Fig. 11




Processed by Luminess, 75001 PARIS (FR)

## Description

### Technical Field

The present invention relates to an organic photodetector, an organic electronic device comprising the organic phototector as well as a display device comprising the organic electronic device

### Background Art

Organic photodetectors have been developed inter alia for use in organic electronic devices such as displays. However, there is a constant need for improved photodetectors and materials for such photodetectors, especially in view of improving the photocurrent density and improving the signal-to-noise ratio.

### DISCLOSURE

An aspect of the present invention provides an organic photodetector comprising an anode layer, a cathode layer, photoconversion unit comprising one or more layer, an interlayer, and an organic semiconductor layer;

wherein the photoconversion unit comprises a donor compound, and an acceptor compound,
wherein the photoconversion unit is arranged between the anode layer and the organic semiconductor layer,
wherein the organic semiconductor layer is arranged between the photoconversion unit and the cathode layer,
wherein the interlayeris arranged between the anode layer and the photoconversion unit;
wherein the interlayer is in direct contact to the photoconversion unit
wherein the interlayer comprises an interlayer compound that either

- has a root mean square of atomic force microscopy of ≥7 nm and an enthalpy of fusion $\Delta H_{fus}$ of ≥ 60 J/g; or
- is a compound of formula (I):

$$Ar^1\text{-}L\text{-}Ar^2 \qquad (I)$$

wherein $Ar^1$, and $Ar^2$ are independently selected from formula (II)

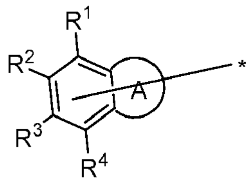

(II),

wherein the asterisk "*" denotes the binding position to L;
wherein L can be bound to A or one of $R^1$ to $R^4$;
wherein

A is a substituted or unsubstituted 5-membered carbocycle or a substituted or unsubstituted 5-membered heterocycle; wherein optionally one or more additional rings can be fused to A to form a ring system;
L is independently selected from a bond, a substituted or unsubstituted $C_6$ to $C_{30}$ aryl, a substituted or unsubstituted $C_2$ to $C_{24}$ heteroaryl,
wherein one or more substituents on L are independently selected from D, halogen, F, nitro, CN, a substituted or unsubstituted branched or unbranched $C_1$ to $C_{20}$ alkyl, a substituted or unsubstituted $C_6$ to $C_{12}$ aryl, a substituted or unsubstituted $C_3$ to $C_{12}$ heteroaryl, a substituted or unsubstituted $C_3$ to $C_{12}$ carbocyclyl, a substituted or unsubstituted $C_2$ to $C_{12}$ heterocyclyl,
wherein the one or more substituents of the one or more substituents on $L^1$ or $L^2$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^1$ to $R^4$ are independently selected from H, D, a substituted or unsubstituted branched or unbranched $C_1$ to $C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen,

F, nitro, or CN,
wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN; with the proviso that when L is bound to one of $R^1$ to $R^4$, then said one of $R^1$ to $R^4$ to which L is bound to is a bond.

It should be noted that throughout the application and the claims any $R^k$ etc. always refer to the same moieties, unless otherwise noted.

It should be noted that throughout the application and the claims the term "substituents", when referring to Formula (I) and/or ligand L always are meant to be selected from H, D, halogen, Cl, F, CN, $NO_2$, $C_1$ to $C_{12}$ alkyl, $C_1$ to $C_{12}$ alkoxy, partially or perfluorinated $C_1$ to $C_{12}$ alkyl, $CF_3$, $CF_2H$, partially or perfluorinated $C_1$ to $C_{12}$ alkoxy, or a combination thereof.

Throughout the applications and the claims the term "ring system" shall especially mean that adjacent rings share two common atoms.

In the present specification, when a definition is not otherwise provided, "partially fluorinated" refers to an alkyl group or an alkoxy group in which only part of the hydrogen atoms are replaced by fluorine atoms.

In the present specification, when a definition is not otherwise provided, "perfluorinated" refers to an alkyl group or an alkoxy group in which all hydrogen atoms are replaced by fluorine atoms.

In the present specification, when a definition is not otherwise provided, "substituted" refers to one substituted with a deuterium, $C_1$ to $C_{12}$ alkyl and $C_1$ to $C_{12}$ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an iso-propyl group, a butyl group, an iso-butyl group, a tert-butyl group, a pentyl group, a hexyl group.

In the context of the present invention, "'$C_nH_{(2n+1)}$" denotes an iso-alkyl group and "$^1C_nF_{(2n+1)}$" denotes a perfluorinated iso-alkyl group.

The term "cycloalkyl" refers to saturated hydrocarbyl groups derived from a cycloalkane by formal abstraction of one hydrogen atom from a Atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluorenyl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common $sp^2$-hybridized carbon atoms

In the present specification, the single bond refers to a direct bond.

In the context of the present invention, "different" means that the compounds do not have an identical chemical structure.

The term "free of", "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The term "adjacent" in the context of layers especially means that one or two layers may be present between the adjacent layers.

The term "shared" and/or "common" in the context of layers especially means that the layer that is "shared" or "common" forms part of the device(s) that share the layer.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms anode, anode layer and anode electrode are used synonymously.

The terms cathode, cathode layer and cathode electrode are used synonymously.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

The term "LUMO level" is understood to mean the lowest unoccupied molecular orbital and is determined in eV (electron volt). The LUMO may also be named "LUMO" or "LUMO energy level".

The term "LUMO level further away from vacuum level" is understood to mean that the absolute value of the LUMO level is higher than the absolute value of the LUMO level of the reference compound.

The term "HOMO level" is understood to mean the highest occupied molecular orbital and is determined in eV (electron volt).

The term "HOMO level further away from vacuum level" is understood to mean that the absolute value of the HOMO level is higher than the absolute value of the HOMO level of the reference compound. For example, the term "further away from vacuum level than the HOMO level of N2,N2,N2',N2',N7,N7,N7',N7'-octakis(4-methoxyphenyl)-9,9'-spirobi [fluorene] - 2,2',7,7'-tetraamine is understood to mean that the absolute value of the HOMO level of the matrix compound of the hole injection layer is higher than the HOMO level of N2,N2,N2',N2', N7,N7, N7',N7'-octakis(4-methoxyphenyl)-9,9'-spirobi[fluorene]-2,2',7,7'-tetraamine.

The term "absolute value" is understood to mean the value without the "- "symbol. According to one embodiment of the present invention, the HOMO level of the matrix compound of the hole injection layer may be calculated by quantum mechanical methods.

The term "hole extraction layer" especially means a layer which facilitates the extraction of holes from the photoconversion unit.

In other words, a hole extraction layer especially means a layer which facilitates the entry of an electron into the photoconversion unit.

The term "electron extraction layer" especially means a layer which facilitates the extraction of electrons from the photoconversion unit.

In other words, the term "electron extraction layer" especially means a layer which facilitates an electron to leave the photoconversion unit, while a positive charge will be formed in the photoconversion unit.

The term "electron extraction material" especially means a material which facilitates the extraction of electrons from the photoconversion unit.

In other words, the term "electron extraction material" especially means a material which facilitates an electron to leave the photoconversion unit in the direction of the cathode layer..

The term "root mean square roughness" refers to one of the dispersion parameters for characterizing the surface roughness, which is obtained via the square root of the arithmetic mean of the squares of each measured height of a measuring point of the total number of measuring points. The root mean square roughness is especially determined by the following formula:

- $$\sqrt{\frac{1}{n}\sum_{i=1}^{n} y_i^2}$$ ,

with $y_i$ measured height of specific measuring point with index i and n total number of measuring points. "Root mean square" and "RMS" are used synonymously. "Root mean square" is also known as "RMS".

"Atomic force microscopy" and "AFM"are used synonymously. "Atomic force microscopy" is also known as AFM.

"Differential scanning calorimetry" and DSC are used synonymously. "Differential scanning calorimetry" is also known as "DSC".

"Enthalpy of fusion" and "$\Delta H_{fus}$ are used synonymously. "Enthalpy of fusion" is also known as"$\Delta H_{fus}$".

The "thickness" or "thickness" of a respective layer especially means a nominal layer thickness, such nominal layer thickness is usually calculated from the mass deposited on a certain area by the knowledge of the material's density. For example, with vacuum thermal evaporation VTE, the nominal thickness is the value indicated by the thickness monitor equipment.

## Advantageous Effects

Surprisingly, it was found that many organic photodetectors according to the present invention have an improved photocurrent and/or an improved signal-to-noise ratio.

According to one embodiment, the interlayer compound has a root mean square roughness measured by atomic force microscopy of ≥7 nm and an measured by differential scanning calorimetry $\Delta H_{fus}$ of ≥ 60 J/g and is a compound of formula (I).

The root mean square RMS of atomic force microscopy AFM is especially measured according to the following:

### Sample preparation

A quartz glass substrate was cut to a size of 50 mm × 50 mm × 0.7 mm, ultrasonically washed with water for 60 minutes and then with isopropanol for 20 minutes. The liquid film was removed in a nitrogen stream.

Then Ag:Mg (90:10 vol.-%) was evaporated at a rate of 0.01 to 1 Å/s at $10^{-7}$ mbar to form a metallic layer with a thickness of 13 nm on the quartz substrate.

Then, the first organic compound N4,N4"-bis(4-(benzo[d]oxazol-2-yl)phenyl)-N4,N4"-diphenyl-[1,1':4',1"-terphenyl]-4,4"-diamine was deposited in vacuum at a rate of 1 Å/s at $10^{-7}$ mbar on the metallic layer, to form a neutral amorphous layer having a thickness of 30nm.

Then the sample to be measured was deposited in vacuum at a rate of 2 Å/s at $1\times10^{-7}$ mbar to $5\times10^{-7}$ mbar on the neutral amorphous layer, having a thickness of 45 nm.

After deposition, the sample is annealed for 1 hour at 100 °C on a hot plate in a glovebox under nitrogen. If the sample is not measured immediately after preparation, the sample is protected from ambient conditions by sealing in a transportation bag under pure $N_2$ conditions until bag is opened to air for analysis.

### Sample measurement

The lab where the samples are measured is held stable at a room temperature of approximately 21 degrees ±0.5 and relative humidity around 40% ±10%. The system is allowed to reach thermal equilibrium before starting measurements.

The measurement of AFM samples for the determining the root mean square roughness of the additional compound was conducted with a Park Systems XE-100 machine.

The PARK system is placed on an optical table with passive acoustic isolation system. The sample is mounted to a glass slide using double sided adhesive tape. The glass slide is permanently glued to a steel sample holder disc, which allows the sample to be held by the AFMs magnetic chuck.

To adjust the laser position on the cantilever, tune the cantilever, detect the resonance frequency, and perform approach of the cantilever 5-15min are generally required. The cantilever is held to a small cantilever holder via a mechanical clip.

The photodiode of the AFM is set to have a sum voltage of 2.4V and the A-B signal voltage is set between 0V and

-0.5V based on the manufacturers specification, wherein the A-B signal voltage is the voltage applied for the vertical and lateral currents of the photodiode sensor.

Measurement is done in a dynamic atomic force microscopy technique that images the sample topography by scanning the surface with an oscillating cantilever. The cantilever is excited at a frequency slightly less than the specific resonance frequency, but where the slope of phase response is still maximum.

The frequency slightly less than the specific resonance frequency is determined automatically using the software provided from Park Systems XE-100 machine. In the software the module "AFM tuning" needs to be selected and executed with default setting by machine provider. Settings are then used for sample measurements.

After approaching the cantilever (SEIHR from Nanoworld) to the sample surface, the ProportionalIntegral controller values and scan speed are set to maximize sample surface tracking (based on consistency between the forward and reverse scans of the same line) without introducing unnecessary noise. The cantilever oscillation amplitude set-point is set as high as possible, i.e. the largest sample-tip distant and least amount of contact force, to minimize tip wear while still maintaining stable contact with the sample.
The parameters will be set to a scan size 10 $\mu$m $\times$ 10 $\mu$m.

If the scanning behavior indicates surface charge effects, as evidenced by an inability for the system to establish contact with the sample or wildly different forward and reverse scan curves, a Zerostat static pistol is used to try and dissipate the charge such that system achieves contact with the sample and the forward and reverse scan curves match.

Evaluation:

Determining RMS and max. peak height which are statistical values (standard deviation) on the whole surface area 10 $\mu$m $\times$ 10 $\mu$m; in particular by using the open source software Gwyddion free software for the statistical evaluation of the surface parameter (including the average and the range).

"Root Means Square roughness is calculated using the known formula RMS

$$\text{thickness} = \sqrt{\frac{1}{n}\sum_{i=1}^{n} y_i^2}$$

, with $y_i$ measured height of specific measuring point with index i and n total number of measuring points."

The enthalpy of fusion $\Delta H_{fus}$ measured by differential scanning microscopy DSC is especially measured according to the following measurement procedure:

**Measurement procedure:**

**I) Sample preparation**

Step 1 to 9: to determine the melting point ($T_m$) of measurement sample, which is required to determine temperature scanning range
Step 10 to 13: to ensure same thermal pre-treatment of measurement sample

**II) Sample measurement**

Step 14 to 15: to determine Enthalpy of fusion $\Delta$Hfus of measurement sample

**I) Sample preparation**

*Step 1 to 9 are performed to determine the melting point (Tm) of the measurement sample to determine the temperature scanning range for subsequent DSC scans.*

*Step 1:*

Baking step of DSC oven to eliminate any organic residues from previous measurements, i.e. a heating step of the crucible without sample.

Baking step is done for 300-500°C at 10K/min, over 15 min under air 200ml/min.

*Step 2:*

The AL lid (AL = aluminum) and the standard 40μl AL crucible are placed together on the previously tared scale (m=0.00mg) using tweezers and the tare weight is determined.

*Step 3:*

The AL crucible is then placed on a clean surface from the weighing plate (here the edge of the die). The lid remains on the weighing plate.

Now, 4 to 6 mg of sample is poured into the crucible, avoiding any contamination of the outer crucible surface and the crucible ring (sealing surface).

*Step 4:*

Use the tweezers to place the filled crucible into the die. The lid is placed in the middle of the crucible using tweezers.

*Step 5:*

The die with the crucible "capped" in this way is placed in the crucible press. Before pressing, the exact fit of the crucible lid must be checked again.

If everything is correctly placed, slowly move the lever on the press to lower the stamp towards the crucible until you feel a slight resistance.

This resistance must be overcome by continuing to press the lever so that the lid is pressed/welded to the crucible itself.

*Step 6:*

The welded crucible containing the sample must be removed from the die with tweezers and placed on the scales again in order to accurately determine the weighed weight of the sample (e.g. 5.66 mg).

*Step 7:*

It is then ready for the DSC experiment and can be placed on the sample plate of the autosampler. The lid is automatically punched when inserted using a built-in lid piercer (called a wasp).

*Step 8:*

The DSC scan can be executed and the following standards are applied:

| | |
|---|---|
| Crucible + reference | Reference crucible 40 μL Al with a small hole (< 1 mm) in the lid |
| Sample preparation | under normal conditions |
| Sample quantity | 4-6 mg |
| measuring cell condition | N2 80 mL/min |
| Heating rate | 10 K/min |
| Temperature range | 50°C to 600°C |

*Step 9:*

From the scan the melting point peak $T_m$ is determined using the pre-installed programs in the DSC measuring device Mettler Toledo DSC3+

*Step 10 to 13 are performed to ensure same pre-treatment conditions for measurement sample allowing reliable determination of Enthalpy of fusion ΔHfus*

*Step 10:*

Baking step of DSC oven to eliminate any organic residues from previous measurements, i.e. a heating step of the crucible without sample.

Baking step is done for 300-500°C at 10K/min, over 15 min under air 200ml/min.

*Step 11:*

Since a high temperature is applied for the sample use in step 1-9, sample may be damaged by decomposition processes of the material. Thus a new sample is required and needs to be prepared following step 2 to 7, accordingly.

Repeat step 2 to 7

*Step 12:*

The DSC scan is executed and the following standards are applied:

| | |
|---|---|
| Crucible + reference | Reference crucible 40 μL Al with a small hole (< 1 mm) in the lid |
| Sample preparation | under normal conditions |
| Sample quantity | 4-6 mg |
| measuring cell condition | N2 80 mL/min |
| Heating rate | 10 K/min |
| Temperature range | 50°C to +20 K after the melting point peak ($T_m$) |

*Step 13:*

Crucible is put out of the heater to the sample plate and cooled down at the following conditions for 10-15min: Room temperature ~22°C (+/-1K), humidity 30-40%.

Roughly 10-15min are required that heater is cooled down to 50°C.

**II) Sample measurement**

Step 14 to 15 are performed to determine Enthalpy of fusion ΔHfus of measurement sample. On the sample used for step 10-13 the further steps 14-15 are applied.

*Step 14:*

DSC scan starts right after previous is finished and as soon the heater has reached 50°C the crucible is place automatically again in the heater.

The DSC scan is executed and the following standards are applied:

| | |
|---|---|
| Crucible + reference | Reference crucible 40 μL Al with a small hole (< 1 mm) in the lid |
| Sample preparation | under normal conditions |
| Sample quantity | 4-6 mg |
| measuring cell condition | N2 80 mL/min |
| Heating rate | 10 K/min |

(continued)

| | |
|---|---|
| Temperature range | 50°C to +20 K after the melting point peak ($T_m$); Tm + 20K |

*Step 15:*

The calculation of the Enthalpy of fusion $\Delta H_{fus}$ then occurs using the pre-installed programs in the DSC measuring device Mettler Toledo DSC3+.

According to one embodiment, the interlayer compound has a root mean square roughness measured by atomic force microscopy of ≥10 nm, preferably ≥ 25 nm, more preferred of ≥40 nm.

According to one embodiment, the interlayer compound has a root mean square roughness measured by atomic force microscopy of ≤500 nm; preferably ≤250 nm; and more preferably ≤100 nm.

According to one embodiment, the interlayer compound has a root mean square roughness measured by atomic force microscopy of ≥7 nm to 500 nm; ≥25 nm to 250 nm; ≥30 nm to 150 nm; ≥40 nm to 100 nm.

According to one embodiment, the interlayer compound has a root mean square roughness measured by atomic force microscopy of is ≥7 nm to 500 nm; preferably ≥7 nm to 250 nm; more preferably ≥7 nm to 150 nm, and most preferably ≥7 nm to 100 nm.

According to one embodiment, the interlayer compound has an enthalpy of fusion ΔHfus measured by differential scanning calorimetry of ≥75 J/g, preferably ≥90 J/g and most preferred of ≥100 J/g.

According to one embodiment, the interlayer compound has an enthalpy of fusion ΔHfus measured by differential scanning calorimetry of ≤500 J/g; preferably ≤250 J/g, and more preferably ≤180 J/g.

According to one embodiment, the interlayer compound has an enthalpy of fusion ΔHfus measured by differential scanning calorimetry of ≥ 60 J/g to ≤500 J/g, more preferred ≥75 J/g to ≤250 J/g, yet more preferred ≥90 J/g to ≤180 J/g and most preferred ≥100 J/g to ≤180 J/g.

According to one embodiment, the interlayer compound has an enthalpy of fusion ΔHfus measured by differential scanning calorimetry of ≥60 J/g to ≤500 J/g; preferably ≥60 J/g to ≤250 J/g; more preferably ≥60 J/g to ≤ 200 J/g; and most preferably ≥60 J/g to ≤180 J/g..

According to an embodiment, the interlayer compound has a LUMO energy level in the range of ≥ -3.10 eV to ≤ -0.6eV, preferably ≥ -2.50 eV to ≤ -0.7eV; wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the interlayer compound has an energy gap $E_{gap}$ between its LUMO energy level and its HOMO energy level of ≥2.6 eV, preferably ≥ 3.0 eV, more preferably ≥ 3.25 eV and most preferably ≥ 3.5 eV, wherein the LUMO energy level, the HOMO energy level and the energy gap Egap are calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the interlayer compound has a molecular weight of 200 g/mol to 650 g/mol, preferably 225 g/mol to 600 g/mol, more preferably 250 g/mol to 550 g/mol, and most preferably 300 g/mol to 500 g/mol.

A certain range of the molecular weight may ensure a certain range of the TGA5% value. A TGA5% value within a certain range implies a sufficiently low volatility enabling precisely controlled evaporation and a sufficiently high volatility limiting thermal stress during the evaporation, respectively.

A certain range of the molecular weight may ensure a certain range of the rate onset temperature. If the rate onset temperature is too low the evaporation may be too rapid and therefore difficult to control. If the rate onset temperature is too high the evaporation rate may be too low which may result in low tact time and decomposition of the organic compound in VTE source may occur due to prolonged exposure to elevated temperatures.

According to an embodiment, the interlayer compound has a molecular weight of 200 g/mol to 670 g/mol, preferably 225 g/mol to 600 g/mol, more preferably 250 g/mol to 550 g/mol, and most preferably 300 g/mol to 500 g/mol, and the interlayer compound is applied by using vacuum thermal evaporation.

According to an embodiment, the interlayer compound has a molecular weight of 200 g/mol to 670 g/mol, preferably 225 g/mol to 600 g/mol, more preferably 250 g/mol to 550 g/mol, and most preferably 300 g/mol to 500 g/mol, and the layer of the photoconversion units where the interlayer compound is contained in is applied by using vacuum thermal evaporation.

According to an embodiment, the interlayer compound is an electron extraction material.

According to an embodiment, the interlayer compound has $C_{2h}$-Symmetry.

According to an embodiment, in formula (I) $Ar^1$ and $Ar^2$ are selected the same.

According to an embodiment, A is be substituted with one or more substituents, wherein the one or substituents can be independently selected from a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,
wherein the one or more substituents on A are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN.

According to an embodiment, A is substituted with one or more substituents, wherein the one or substituents can be independently selected from a substituted or unsubstituted branched or unbranched $C_1$ to $C_4$ alkyl, a substituted or unsubstituted $C_6$ to $C_{12}$ aryl, a substituted or unsubstituted $C_5$ to $C_{12}$ heteroaryl, a substituted or unsubstituted $C_3$ to $C_{12}$ carbocyclyl, a substituted or unsubstituted $C_2$ to $C_{12}$ heterocyclyl,
wherein the one or more substituents on A are independently selected from D, branched or unbranched $C_1$ to $C_4$ alkyl, $C_6$ to $C_{12}$ aryl, $C_5$ to $C_{12}$ heteroaryl, $C_3$ to $C_{12}$ carbocyclyl, $C_2$ to $C_{12}$ heterocyclyl, halogen, F, nitro, or CN.

According to an embodiment, A is unsubstituted.

According to an embodiment, $Ar^1$ and/or $Ar^2$ are independently selected from formula (III)

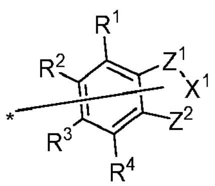

(III)

wherein the asterisk "*" denotes the binding position to L;
wherein L can be bound to A or one of $R^1$ to $R^4$;
wherein

$Z^1$ is selected from N, $NR^a$, C=O, C, $C(R^b)$,
$Z^2$ is selected from S, O, C=O, $C(R^c)_2$, NH, ND, $NR^a$,;
$X^1$ is selected from B, C, N, O;
$Z^2$ and $X^1$ or $Z^1$ and $X^1$ may form a six membered aromatic ring or six membered heteroaromatic ring;
$Z^1$ and $X^1$ or $Z^2$ and $X^1$ can form a double bond;
$R^a$ is selected from H, D, a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,
wherein the one or more substituents on $R^a$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^b$ is selected from a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,
wherein the one or more substituents on $R^b$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
each $R^c$ is independently selected from a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,
wherein the one or more substituents on $R^c$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^1$ to $R^4$ are independently selected from H, D, a substituted or unsubstituted branched or unbranched $C_1$ to $C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen, F, nitro, or CN,
wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN. with the proviso that when L is bound to one of $R^1$ to $R^4$, then said one of $R^1$ to $R^4$ to which L is bound to is a bond.

(IV) According to an embodiment, $Ar^1$ and/or $Ar^2$ are independently selected from formula

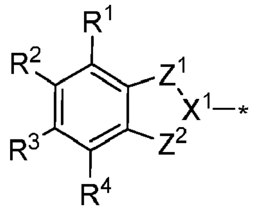

(IV)

wherein the asterisk "*" denotes the binding position to L;
wherein

$Z^1$ is selected from N, $NR^a$, C=O, C, $C(R^b)$,
$Z^2$ is selected from O, C=O, $C(R^c)_2$;
$X^1$ is selected from B, C, N, O;
$Z^2$ and $X^1$ or $Z^1$ and $X^1$ may form a six membered aromatic ring or six membered heteroaromatic ring;
$Z^1$ and $X^1$ or $Z^2$ and $X^1$ can form a double bond;
$R^a$ is selected from H, D, a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,
wherein the one or more substituents on $R^a$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^b$ is selected from a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,
wherein the one or more substituents on $R^b$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^c$ is selected from a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,
wherein the one or more substituents on $R^c$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^1$ to $R^4$ are independently selected from H, D, a substituted or unsubstituted branched or unbranched $C_1$ to $C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen, F, nitro, or CN,
wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN.

According to an embodiment, $Ar^1$ and/or $Ar^2$ are independently selected from formulae (V) or (VI):

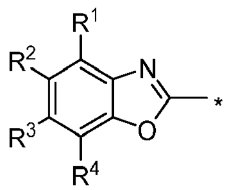

(V)

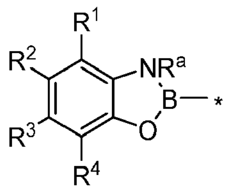

(VI)

Whereby $R^a$ is selected from H, D, a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,

wherein the one or more substituents on $R^a$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^1$ to $R^4$ are independently selected from H, D, a substituted or unsubstituted branched or unbranched $C_1$ to $C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen, F, nitro, or CN,

wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN.

According to an embodiment, the compound of formula (I) is a compound of formula (VII):

$Ar^1$-$Ar^2$ (VII)

i.e. L is a bond; and $Ar^1$ and $Ar^2$ are connected via a bond formed between $R^3$ of $Ar^1$ and $R^3$ of $Ar^2$.

According to an embodiment, $Ar^1$ and/or $Ar^2$ are independently selected from formulae (VIII) or (IX):

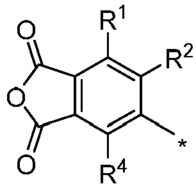 (VIII) 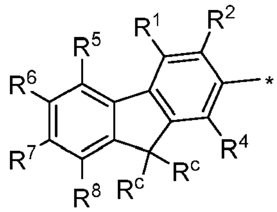 (IX)

Whereby

$R^1$, $R^2$ and $R^4$ are independently selected from H, D, a substituted or unsubstituted branched or unbranched $C_1$ to $C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen, F, nitro, or CN, wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN.
wherein $R^5$ to $R^8$ are independently selected from H, D, a substituted or unsubstituted branched or unbranched $C_1$ to $C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen, F, nitro, or CN,
wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN.

According to an embodiment, $Ar^1$ and $Ar^2$ are independently selected from formula (XI):

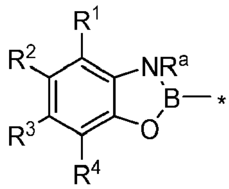 (XI),

wherein

$R^a$ is selected from H, D, a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,
wherein the one or more substituents on $R^a$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^1$ to $R^4$ are independently selected from H, D, a substituted or unsubstituted branched or unbranched $C_1$ to $C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen, F, nitro, or CN, wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN.

According to an embodiment, L is independently selected from a bond, a substituted or unsubstituted $C_6$ to $C_{15}$ aryl, a substituted or unsubstituted $C_2$ to $C_{12}$ heteroaryl,

According to an embodiment, L is selected from a substituted or unsubstituted $C_6$ to $C_{15}$ aryl, a substituted or

unsubstituted $C_5$ to $C_{12}$ heteroaryl,

According to an embodiment, L is represented by formula (X)

$$*-\left(L^1\right)_m-\left(L^2\right)_n-* \qquad \text{(X)}$$

wherein the asterisk "*" denotes the binding position to A;
wherein n is selected from 0 or 1;
wherein m is selected from 0 or 1;
$L^1$, and $L^2$ are independently selected from a substituted or unsubstituted $C_2$ to $C_5$ heteroarylene, a substituted or unsubstituted phenylene,
wherein the one or more substituents on $L^1$ or $L^2$ are independently selected from D, halogen, F, nitro, CN, a substituted or unsubstituted branched or unbranched $C_1$ to $C_{20}$ alkyl, a substituted or unsubstituted $C_6$ to $C_{12}$ aryl, a substituted or unsubstituted $C_3$ to $C_{12}$ heteroaryl, a substituted or unsubstituted $C_3$ to $C_{12}$ carbocyclyl, a substituted or unsubstituted $C_2$ to $C_{12}$ heterocyclyl,
wherein the one or more substituents of the one or more substituents on $L^1$ or $L^2$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;

According to an embodiment, the one or more substituents on L are independently selected from D, halogen, F, nitro, CN, a substituted or unsubstituted branched or unbranched $C_1$ to $C_4$, a substituted or unsubstituted $C_6$ to $C_{12}$ aryl, a substituted or unsubstituted $C_3$ to $C_{12}$ heteroaryl, a substituted or unsubstituted $C_3$ to $C_{12}$ carbocyclyl, a substituted or unsubstituted $C_2$ to $C_{12}$ heterocyclyl.

According to an embodiment, the one or more substituents on L are independently selected from D, halogen, F, nitro, CN, a substituted or unsubstituted branched or unbranched $C_1$ to $C_4$, a substituted or unsubstituted $C_6$ to $C_{10}$ aryl, a substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, the one or more substituents on L are independently selected from D, halogen, F, nitro, CN, a substituted or unsubstituted branched or unbranched $C_1$ to $C_3$, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, the one or more substituents on L are independently selected from D, halogen, F, nitro, CN, a substituted or unsubstituted unbranched $C_1$ to $C_2$, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, the one or more substituents on L are independently selected from D, halogen, F, CN, a substituted or unsubstituted $C_1$ to $C_2$.

According to an embodiment, the one or more substituents of the one or more substituents on L are independently selected from D, branched or unbranched $C_1$ to $C_4$ alkyl, $C_6$ to $C_{10}$ aryl, $C_5$ to $C_9$ heteroaryl, $C_3$ to $C_9$ carbocyclyl, $C_2$ to $C_9$ heterocyclyl, halogen, F, nitro, or CN.

According to an embodiment, the one or more substituents of the one or more substituents on L are independently selected from D, unbranched $C_1$ to $C_4$ alkyl, $C_6$ to $C_{10}$ aryl, $C_5$ to $C_9$ heteroaryl, $C_3$ to $C_9$ carbocyclyl, $C_2$ to $C_9$ heterocyclyl, halogen, F, nitro, or CN.

According to an embodiment, the one or more substituents of the one or more substituents on L are independently selected from D, $C_1$ alkyl, $C_6$ aryl, $C_5$, heteroaryl, halogen, F, nitro, or CN.

According to an embodiment, the one or more substituents of the one or more substituents on L are independently selected from D, halogen, F, nitro, CN.

According to an embodiment, the one or more substituents of the one or more substituents on L are independently selected from D, F.

According to an embodiment, the one or more substituents on L are independently selected from D, halogen, F, nitro, CN, unsubstituted branched or unbranched $C_1$ to $C_4$, unsubstituted $C_6$ to $C_{12}$ aryl, unsubstituted $C_3$ to $C_{12}$ heteroaryl, unsubstituted $C_3$ to $C_{12}$ carbocyclyl, unsubstituted $C_2$ to $C_{12}$ heterocyclyl.

According to an embodiment, the one or more substituents on L are independently selected from D, halogen, F, nitro, CN, unsubstituted branched or unbranched $C_1$ to $C_4$, unsubstituted $C_6$ to $C_{10}$ aryl, unsubstituted $C_3$ to $C_9$ heteroaryl, unsubstituted $C_3$ to $C_{10}$ carbocyclyl, unsubstituted $C_2$ to $C_9$ heterocyclyl.

According to an embodiment, the one or more substituents on L are independently selected from D, halogen, F, nitro, CN, unsubstituted branched or unbranched $C_1$ to $C_3$, unsubstituted $C_6$ aryl, unsubstituted $C_5$ to $C_9$ heteroaryl, unsubstituted $C_3$ to $C_{10}$ carbocyclyl, unsubstituted $C_2$ to $C_9$ heterocyclyl.

According to an embodiment, the one or more substituents on L are independently selected from D, halogen, F, nitro, CN, unsubstituted unbranched $C_1$ to $C_2$, unsubstituted $C_6$ aryl, unsubstituted $C_5$ to $C_9$ heteroaryl, unsubstituted $C_3$ to $C_{10}$ carbocyclyl, unsubstituted $C_2$ to $C_9$ heterocyclyl.

According to an embodiment, the one or more substituents on L are independently selected from D, halogen, F, CN, unsubstituted $C_1$ to $C_2$.

According to an embodiment, $L^1$ and $L^2$ in formula (X) are independently selected from substituted or unsusbstituted $C_3$ to $C_5$ heteroarylene, wherein the heteroarylene is a six-membered ring, substituted or unsusbstituted phenylene.

According to an embodiment, $L^1$ and $L^2$ in formula (X) are independently selected from a substituted or unsubstituted phenylene, a substituted or unsubstituted pyridylene, a substituted or unsubstituted triazinylene, a substituted or unsubstituted pyrazinylene,

According to an embodiment, $L^1$ and $L^2$ in formula (X) are independently selected from a substituted or unsubstituted phenylene, a substituted or unsubstituted pyridylene.

According to an embodiment, $L^1$ and $L^2$ in formula (X) are independently selected from a substituted or unsubstituted phenylene.

According to an embodiment, $L^1$ and $L^2$ in formula (X) are unsubstituted phenylene.

According to an embodiment, the one or more substituents on $L^1$ or $L^2$ in formula (X) are independently selected from D, halogen, F, nitro, CN, a substituted or unsubstituted branched or unbranched $C_1$ to $C_4$, a substituted or unsubstituted $C_6$ to $C_{12}$ aryl, a substituted or unsubstituted $C_3$ to $C_{12}$ heteroaryl, a substituted or unsubstituted $C_3$ to $C_{12}$ carbocyclyl, a substituted or unsubstituted $C_2$ to $C_{12}$ heterocyclyl.

According to an embodiment, the one or more substituents on $L^1$ or $L^2$ in formula (X) are independently selected from D, halogen, F, nitro, CN, a substituted or unsubstituted branched or unbranched $C_1$ to $C_4$, a substituted or unsubstituted $C_6$ to $C_{10}$ aryl, a substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, the one or more substituents on $L^1$ or $L^2$ in formula (X) are independently selected from D, halogen, F, nitro, CN, a substituted or unsubstituted branched or unbranched $C_1$ to $C_3$, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, the one or more substituents on $L^1$ or $L^2$ in formula (X) are independently selected from D, halogen, F, nitro, CN, a substituted or unsubstituted unbranched $C_1$ to $C_2$, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, the one or more substituents on $L^1$ or $L^2$ in formula (X) are independently selected from D, halogen, F, CN, a substituted or unsubstituted $C_1$ to $C_2$.

According to an embodiment, the one or more substituents of the one or more substituents on $L^1$ or $L^2$ in formula (X) are independently selected from D, branched or unbranched $C_1$ to $C_4$ alkyl, $C_6$ to $C_{10}$ aryl, $C_5$ to $C_9$ heteroaryl, $C_3$ to $C_9$ carbocyclyl, $C_2$ to $C_9$ heterocyclyl, halogen, F, nitro, or CN.

According to an embodiment, the one or more substituents of the one or more substituents on $L^1$ or $L^2$ in formula (X) are independently selected from D, unbranched $C_1$ to $C_4$ alkyl, $C_6$ to $C_{10}$ aryl, $C_5$ to $C_9$ heteroaryl, $C_3$ to $C_9$ carbocyclyl, $C_2$ to $C_9$ heterocyclyl, halogen, F, nitro, or CN.

According to an embodiment, the one or more substituents of the one or more substituents on $L^1$ or $L^2$ in formula (X) are independently selected from D, $C_1$ alkyl, $C_6$ aryl, $C_5$, heteroaryl, halogen, F, nitro, or CN.

According to an embodiment, the one or more substituents of the one or more substituents on $L^1$ or $L^2$ in formula (X) are independently selected from D, halogen, F, nitro, CN.

According to an embodiment, the one or more substituents of the one or more substituents on $L^1$ or $L^2$ in formula (IX) are independently selected from D, F.

According to an embodiment, the one or more substituents on $L^1$ or $L^2$ in formula (X) are independently selected from D, halogen, F, nitro, CN, unsubstituted branched or unbranched $C_1$ to $C_4$, unsubstituted $C_6$ to $C_{12}$ aryl, unsubstituted $C_3$ to $C_{12}$ heteroaryl, unsubstituted $C_3$ to $C_{12}$ carbocyclyl, unsubstituted $C_2$ to $C_{12}$ heterocyclyl.

According to an embodiment, the one or more substituents on $L^1$ or $L^2$ in formula (IX) are independently selected from D, halogen, F, nitro, CN, unsubstituted branched or unbranched $C_1$ to $C_4$, unsubstituted $C_6$ to $C_{10}$ aryl, unsubstituted $C_3$ to $C_9$ heteroaryl, unsubstituted $C_3$ to $C_{10}$ carbocyclyl, unsubstituted $C_2$ to $C_9$ heterocyclyl.

According to an embodiment, the one or more substituents on $L^1$ or $L^2$ in formula (IX) are independently selected from D, halogen, F, nitro, CN, unsubstituted branched or unbranched $C_1$ to $C_3$, unsubstituted $C_6$ aryl, unsubstituted $C_5$ to $C_9$ heteroaryl, unsubstituted $C_3$ to $C_{10}$ carbocyclyl, unsubstituted $C_2$ to $C_9$ heterocyclyl.

According to an embodiment, the one or more substituents on $L^1$ or $L^2$ in formula (IX) are independently selected from D, halogen, F, nitro, CN, unsubstituted unbranched $C_1$ to $C_2$, unsubstituted $C_6$ aryl, unsubstituted $C_5$ to $C_9$ heteroaryl, unsubstituted $C_3$ to $C_{10}$ carbocyclyl, unsubstituted $C_2$ to $C_9$ heterocyclyl.

According to an embodiment, the one or more substituents on $L^1$ or $L^2$ in formula (IX) are independently selected from D, halogen, F, CN, unsubstituted $C_1$ to $C_2$.

According to an embodiment, L is selected from E1 to E26:

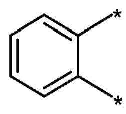 E1, 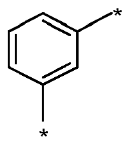 E2, 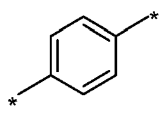 E3, 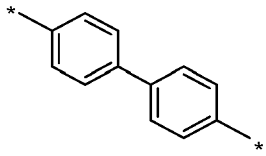 E4, 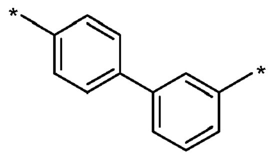

E5, 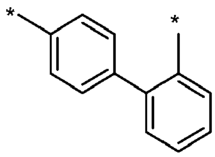 E6, 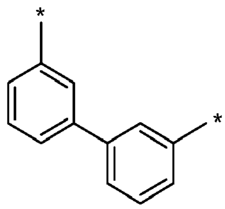 E7, 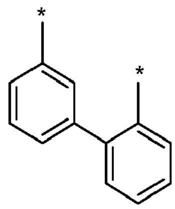 E8, 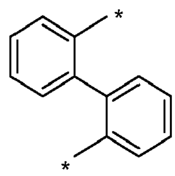 E9,…

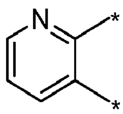 E10,… 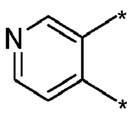 E11, 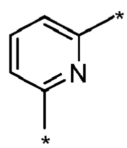 E12,… 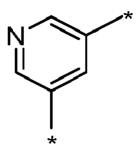 E13,… 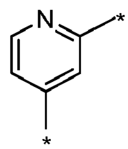 E14,

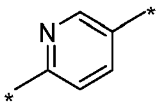 E15, 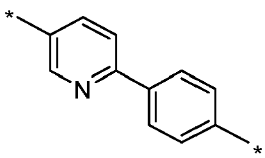 E16,… 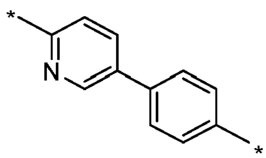 E17,…

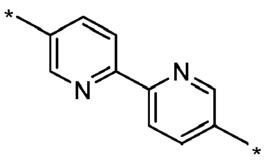 E18,… 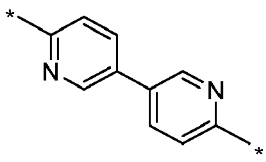 E19, 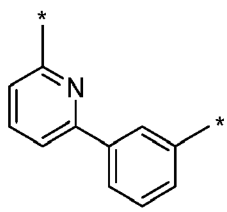 E20,…

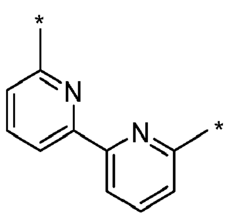 E21, 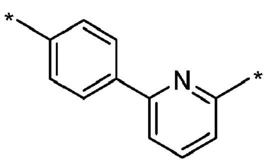 E22, 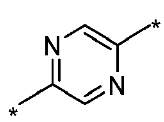 E23, 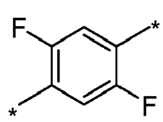 E24,

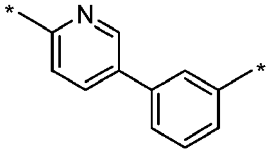 E25,… 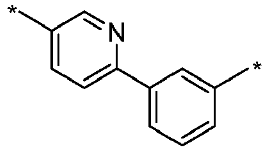 E26.

wherein the asterisk "*" denotes the binding position,
wherein E1 to E26 can be substituted with one or more substituent or unsubstituted;
wherein the one or more substituents are independently selected from D, halogen, F, nitro, CN, a substituted or unsubstituted branched or unbranched $C_1$ to $C_{20}$ alkyl, a substituted or unsubstituted $C_6$ to $C_{12}$ aryl, a substituted or unsubstituted $C_5$ to $C_{12}$ heteroaryl, a substituted or unsubstituted $C_3$ to $C_{12}$ carbocyclyl, a substituted or unsubstituted $C_2$ to $C_{12}$ heterocyclyl.

According to an embodiment, L is selected from E1 to E5, E7, E12 to E15, E24;

wherein E1 to E5, E7, E12 to E15, E24 can be substituted with one or more substituent or unsubstituted;
wherein the one or more substituents are independently selected from D, halogen, F, nitro, CN, a substituted or unsubstituted branched or unbranched $C_1$ to $C_{20}$ alkyl, a substituted or unsubstituted $C_6$ to $C_{12}$ aryl, a substituted or unsubstituted $C_5$ to $C_{12}$ heteroaryl, a substituted or unsubstituted $C_3$ to $C_{12}$ carbocyclyl, a substituted or unsubstituted $C_2$ to $C_{12}$ heterocyclyl.

According to an embodiment, L is selected from E2 to E4, E12, E24, wherein E2 to E4, E12, E24 can be substituted with one or more substituent or unsubstituted;
wherein the one or more substituents are independently selected from D, halogen, F, nitro, CN, a substituted or unsubstituted branched or unbranched $C_1$ to $C_{20}$ alkyl, a substituted or unsubstituted $C_6$ to $C_{12}$ aryl, a substituted or unsubstituted $C_5$ to $C_{12}$ heteroaryl, a substituted or unsubstituted $C_3$ to $C_{12}$ carbocyclyl, a substituted or unsubstituted $C_2$ to $C_{12}$ heterocyclyl.

According to an embodiment, L is selected from E1 to E26, wherein E1 to E26 can be substituted with one or more substituent or unsubstituted; wherein the one or more substituents are independently selected from D, halogen, F, nitro, CN, a substituted or unsubstituted branched or unbranched $C_1$ to $C_4$, a substituted or unsubstituted $C_6$ to $C_{12}$ aryl, a substituted or unsubstituted $C_3$ to $C_{12}$ heteroaryl, a substituted or unsubstituted $C_3$ to $C_{12}$ carbocyclyl, a substituted or unsubstituted $C_2$ to $C_{12}$ heterocyclyl.

According to an embodiment, L is selected from E1 to E5, E7, E12 to E15, E24;
wherein E1 to E5, E7, E12 to E15, E24 can be substituted with one or more substituent or unsubstituted; wherein the one or more substituents are independently selected from D, halogen, F, nitro, CN, a substituted or unsubstituted branched or unbranched $C_1$ to $C_4$, a substituted or unsubstituted $C_6$ to $C_{12}$ aryl, a substituted or unsubstituted $C_3$ to $C_{12}$ heteroaryl, a substituted or unsubstituted $C_3$ to $C_{12}$ carbocyclyl, a substituted or unsubstituted $C_2$ to $C_{12}$ heterocyclyl

.According to an embodiment, L is selected from E2 to E4, E12, E24, wherein E2 to E4, E12, E24 can be substituted with one or more substituent or unsubstituted; wherein the one or more substituents are independently selected from D, halogen, F, nitro, CN, a substituted or unsubstituted branched or unbranched $C_1$ to $C_4$, a substituted or unsubstituted $C_6$ to $C_{12}$ aryl, a substituted or unsubstituted $C_3$ to $C_{12}$ heteroaryl, a substituted or unsubstituted $C_3$ to $C_{12}$ carbocyclyl, a substituted or unsubstituted $C_2$ to $C_{12}$ heterocyclyl.

According to an embodiment, L is selected from E1 to E26, wherein E1 to E26 can be substituted with one or more substituent or unsubstituted;
wherein the one or more substituents are independently selected from D, halogen, F, nitro, CN, a substituted or unsubstituted branched or unbranched $C_1$ to $C_4$, a substituted or unsubstituted $C_6$ to $C_{10}$ aryl, a substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, L is selected from E1 to E5, E7, E12 to E15, E24;

wherein E1 to E5, E7, E12 to E15, E24 can be substituted with one or more substituent or unsubstituted;
wherein the one or more substituents are independently selected from D, halogen, F, nitro, CN, a substituted or unsubstituted branched or unbranched $C_1$ to $C_4$, a substituted or unsubstituted $C_6$ to $C_{10}$ aryl, a substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, L is selected from E2 to E4, E12, E24, wherein E2 to E4, E12, E24 can be substituted with one or more substituent or unsubstituted;
wherein the one or more substituents are independently selected from D, halogen, F, nitro, CN, a substituted or unsubstituted branched or unbranched $C_1$ to $C_4$, a substituted or unsubstituted $C_6$ to $C_{10}$ aryl, a substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, L is selected from E1 to E26, wherein E1 to E26 can be substituted with one or more substituent or unsubstituted;

wherein the one or more substituents are independently selected from D, halogen, F, nitro, CN, a substituted or unsubstituted branched or unbranched $C_1$ to $C_3$, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, L is selected from E1 to E5, E7, E12 to E15, E24;

wherein E1 to E5, E7, E12 to E15, E24 can be substituted with one or more substituent or unsubstituted;
wherein the one or more substituents are independently selected from D, halogen, F, nitro, CN, a substituted or unsubstituted branched or unbranched $C_1$ to $C_3$, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, L is selected from E2 to E4, E12, E24, wherein E2 to E4, E12, E24 can be substituted with one or more substituent or unsubstituted;
wherein the one or more substituents are independently selected from D, halogen, F, nitro, CN, a substituted or unsubstituted branched or unbranched $C_1$ to $C_3$, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, L is selected from E1 to E26, wherein E1 to E26 can be substituted with one or more substituent or unsubstituted;
wherein the one or more substituents are independently selected from D, halogen, F, nitro, CN, a substituted or unsubstituted unbranched $C_1$ to $C_2$, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, L is selected from E1 to E5, E7, E12 to E15, E24;

wherein E1 to E5, E7, E12 to E15, E24 can be substituted with one or more substituent or unsubstituted;
wherein the one or more substituents are independently selected from D, halogen, F, nitro, CN, a substituted or unsubstituted unbranched $C_1$ to $C_2$, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, L is selected from E2 to E4, E12, E24, wherein E2 to E4, E12, E24 can be substituted with one or more substituent or unsubstituted;
wherein the one or more substituents are independently selected from D, halogen, F, nitro, CN, a substituted or unsubstituted unbranched $C_1$ to $C_2$, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl.

According to an embodiment, L is selected from E1 to E26, wherein E1 to E26 can be substituted with one or more substituent or unsubstituted;
wherein the one or more substituents are independently selected from D, halogen, F, CN, a substituted or unsubstituted $C_1$ to $C_2$.

According to an embodiment, **L** is selected from E1 to E5, E7, E12 to E15, E24;

wherein E1 to E5, E7, E12 to E15, E24 can be substituted with one or more substituent or unsubstituted;
wherein the one or more substituents are independently selected from D, halogen, F, CN, a substituted or unsubstituted $C_1$ to $C_2$.

According to an embodiment, L is selected from E2 to E4, E12, E24, wherein E2 to E4, E12, E24 can be substituted with one or more substituent or unsubstituted;
wherein the one or more substituents are independently selected from D, halogen, F, CN, a substituted or unsubstituted $C_1$ to $C_2$.

According to an embodiment, L is selected from unsubstituted E1 to E26.

According to an embodiment, L is selected from unsubstuted E1 to E5, E7, E12 to E15, E24.

According to an embodiment, **L** is selected from unsubstituted E2 to E4, E12, E24,

According to an embodiment, $R^1$ to $R^4$ of formula (II) to formula (IX) - if present - are independently selected from H, D, a substituted or unsubstituted branched or unbranched $C_1$ to $C_4$ alkyl, a substituted or unsubstituted $C_6$ to $C_{10}$ aryl, a substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl, halogen, F, nitro, or CN.

According to an embodiment, $R^1$ to $R^4$ of formula (II) to formula (IX) - if present - are independently selected from H, D, a substituted or unsubstituted branched or unbranched $C_1$ to $C_3$ alkyl, a substituted or unsubstituted $C_6$ to $C_{10}$ aryl, a

substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl, halogen, F, nitro, or CN.

According to an embodiment, $R^1$ to $R^4$ of formula (II) to formula (IX) - if present - are independently selected from H, D, a substituted or unsubstituted $C_1$ to $C_2$ alkyl, a substituted or unsubstituted $C_6$ to $C_{10}$ aryl, a substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl, halogen, F, nitro, or CN.

According to an embodiment, $R^1$ to $R^4$ are independently selected from H, D, a substituted or unsubstituted $C_1$ to $C_2$ alkyl, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl, halogen, F, nitro, or CN.

According to an embodiment, $R^1$ to $R^4$ of formula (II) to formula (IX) - if present - are independently selected from H, D, a substituted or unsubstituted $C_1$ to $C_2$ alkyl, a substituted or unsubstituted $C_6$ aryl, a substituted or unsubstituted $C_5$ to $C_9$ heteroaryl, F, CN.

According to an embodiment, $R^1$ to $R^4$ of formula (II) to formula (IX) - if present - are independently selected from H, D, a substituted or unsubstituted $C_1$ alkyl, a substituted or unsubstituted $C_6$ aryl, a substituted or unsubstituted $C_5$ heteroaryl, F, CN.

According to an embodiment, the one or more substituents on $R^1$ to $R^4$ of formula (II) to formula (IX) - if present - are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN-

According to an embodiment, the one or more substituents on $R^1$ to $R^4$ of formula (II) to formula (IX) - if present - are independently selected from D, $C_1$ to $C_2$ alkyl, $C_6$ to $C_{10}$ aryl, $C_5$ to $C_9$ heteroaryl, $C_3$ to $C_{10}$ carbocyclyl, $C_2$ to $C_9$ heterocyclyl, halogen, F, nitro, or CN.-

According to an embodiment, the one or more substituents on $R^1$ to $R^4$ of formula (II) to formula (IX) - if present - are independently selected from D, $C_1$ alkyl, $C_6$ aryl, $C_5$ heteroaryl, F, or CN.

According to an embodiment, $R^5$ to $R^8$ of formula (IX) are independently selected from H, D, a substituted or unsubstituted branched or unbranched $C_1$ to $C_4$ alkyl, a substituted or unsubstituted $C_6$ to $C_{10}$ aryl, a substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl, halogen, F, nitro, or CN.

According to an embodiment, $R^5$ to $R^8$ of formula (IX) are independently selected from H, D, a substituted or unsubstituted branched or unbranched $C_1$ to $C_3$ alkyl, a substituted or unsubstituted $C_6$ to $C_{10}$ aryl, a substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl, halogen, F, nitro, or CN.

According to an embodiment, $R^5$ to $R^8$ of formula (IX) are independently selected from H, D, a substituted or unsubstituted $C_1$ to $C_2$ alkyl, a substituted or unsubstituted $C_6$ to $C_{10}$ aryl, a substituted or unsubstituted $C_3$ to $C_9$ heteroaryl, a substituted or unsubstituted $C_3$ to $C_{10}$ carbocyclyl, a substituted or unsubstituted $C_2$ to $C_9$ heterocyclyl, halogen, F, nitro, or CN.

According to an embodiment, $R^5$ to $R^8$ are independently selected from H, D, a substituted or unsubstituted $C_1$ to $C_2$ alkyl, a substituted or unsubstituted $C_6$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl, halogen, F, nitro, or CN.

According to an embodiment, $R^5$ to $R^8$ of formula (IX) are independently selected from H, D, a substituted or unsubstituted $C_1$ to $C_2$ alkyl, a substituted or unsubstituted $C_6$ aryl, a substituted or unsubstituted $C_5$ to $C_9$ heteroaryl, F, CN.

According to an embodiment, $R^5$ to $R^8$ of formula (IX) are independently selected from H, D, a substituted or unsubstituted $C_1$ alkyl, a substituted or unsubstituted $C_6$ aryl, a substituted or unsubstituted $C_5$ heteroaryl, F, CN.

According to an embodiment, the one or more substituents on $R^5$ to $R^8$ of formula (IX) are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN-

According to an embodiment, the one or more substituents on $R^5$ to $R^8$ of formula (IX) are independently selected from D, $C_1$ to $C_2$ alkyl, $C_6$ to $C_{10}$ aryl, $C_5$ to $C_9$ heteroaryl, $C_3$ to $C_{10}$ carbocyclyl, $C_2$ to $C_9$ heterocyclyl, halogen, F, nitro, or CN.-

According to an embodiment, the one or more substituents on $R^5$ to $R^8$ of formula (IX) are independently selected from D, $C_1$ alkyl, $C_6$ aryl, $C_5$ heteroaryl, F, or CN.

According to an embodiment, $R^a$ in formula (III) or (IV) is selected from a substituted or unsubstituted branched or unbranched $C_1$ to $C_4$ alkyl, a substituted or unsubstituted $C_6$ to $C_{12}$ aryl, a substituted or unsubstituted $C_5$ to $C_{12}$ heteroaryl, a substituted or unsubstituted $C_3$ to $C_{12}$ carbocyclyl, a substituted or unsubstituted $C_2$ to $C_{12}$ heterocyclyl,

wherein the one or more substituents on $R^a$ are independently selected from D, branched or unbranched $C_1$ to $C_2$ alkyl, $C_6$ to $C_{10}$ aryl, $C_5$ to $C_9$ heteroaryl, $C_3$ to $C_{10}$ carbocyclyl, $C_2$ to $C_9$ heterocyclyl, halogen, F, nitro, or CN.

According to an embodiment, $R^a$ in formula (III) or (IV) is selected from a substituted or unsubstituted $C_1$ to $C_2$ alkyl, a substituted or unsubstituted $C_6$ to $C_{10}$ aryl, a substituted or unsubstituted $C_5$ to $C_9$ heteroaryl, a substituted or

unsubstituted $C_3$ to $C_{10}$ carbocyclyl, a substituted or unsubstituted $C_2$ to $C_9$ heterocyclyl,
wherein the one or more substituents on $R^a$ are independently selected from D, $C_1$ alkyl, $C_6$ to $C_{10}$ aryl, $C_5$ to $C_9$ heteroaryl, $C_3$ to $C_{10}$ carbocyclyl, $C_2$ to $C_9$ heterocyclyl, halogen, F, nitro, or CN.

According to an embodiment, $R^b$ in formula (III) or (IV) is selected from a substituted or unsubstituted branched or unbranched $C_1$ to $C_4$ alkyl, a substituted or unsubstituted $C_6$ to $C_{12}$ aryl, a substituted or unsubstituted $C_5$ to $C_{12}$ heteroaryl, a substituted or unsubstituted $C_3$ to $C_{12}$ carbocyclyl, a substituted or unsubstituted $C_2$ to $C_{12}$ heterocyclyl,
wherein the one or more substituents on $R^b$ are independently selected from D, branched or unbranched $C_1$ to $C_2$ alkyl, $C_6$ to $C_{10}$ aryl, $C_5$ to $C_9$ heteroaryl, $C_3$ to $C_{10}$ carbocyclyl, $C_2$ to $C_9$ heterocyclyl, halogen, F, nitro, or CN.

According to an embodiment, $R^b$ in formula (III) or (IV) is selected from a substituted or unsubstituted $C_1$ to $C_2$ alkyl, a substituted or unsubstituted $C_6$ to $C_{10}$ aryl, a substituted or unsubstituted Cs to $C_9$ heteroaryl, a substituted or unsubstituted $C_3$ to $C_{10}$ carbocyclyl, a substituted or unsubstituted $C_2$ to $C_9$ heterocyclyl,
wherein the one or more substituents on $R^b$ are independently selected from D, $C_1$ alkyl, $C_6$ to $C_{10}$ aryl, $C_5$ to $C_9$ heteroaryl, $C_3$ to $C_{10}$ carbocyclyl, $C_2$ to $C_9$ heterocyclyl, halogen, F, nitro, or CN.

According to an embodiment, $R^c$ in formula (III), (IV) or (IX) is selected from a substituted or unsubstituted branched or unbranched $C_1$ to $C_4$ alkyl, a substituted or unsubstituted $C_6$ to $C_{12}$ aryl, a substituted or unsubstituted $C_5$ to $C_{12}$ heteroaryl, a substituted or unsubstituted $C_3$ to $C_{12}$ carbocyclyl, a substituted or unsubstituted $C_2$ to $C_{12}$ heterocyclyl,
wherein the one or more substituents on $R^b$ are independently selected from D, branched or unbranched $C_1$ to $C_2$ alkyl, $C_6$ to $C_{10}$ aryl, $C_5$ to $C_9$ heteroaryl, $C_3$ to $C_{10}$ carbocyclyl, $C_2$ to $C_9$ heterocyclyl, halogen, F, nitro, or CN.

According to an embodiment, $R^c$ in formula (III), (IV) or (IX) is selected from a substituted or unsubstituted $C_1$ to $C_2$ alkyl, a substituted or unsubstituted $C_6$ to $C_{10}$ aryl, a substituted or unsubstituted $C_5$ to $C_9$ heteroaryl, a substituted or unsubstituted $C_3$ to $C_{10}$ carbocyclyl, a substituted or unsubstituted $C_2$ to $C_9$ heterocyclyl,
wherein the one or more substituents on $R^c$ are independently selected from D, $C_1$ alkyl, $C_6$ to $C_{10}$ aryl, $C_5$ to $C_9$ heteroaryl, $C_3$ to $C_{10}$ carbocyclyl, $C_2$ to $C_9$ heterocyclyl, halogen, F, nitro, or CN;.

According to an embodiment the interlayer compound is not a compound selected from the following:

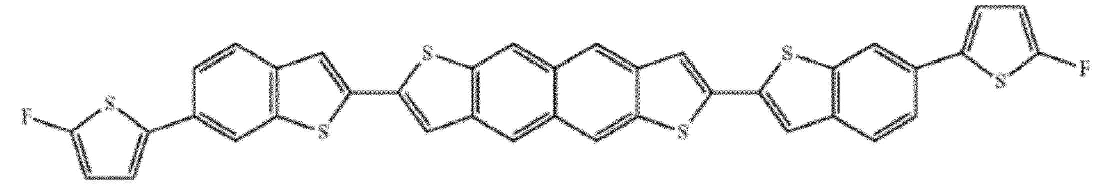

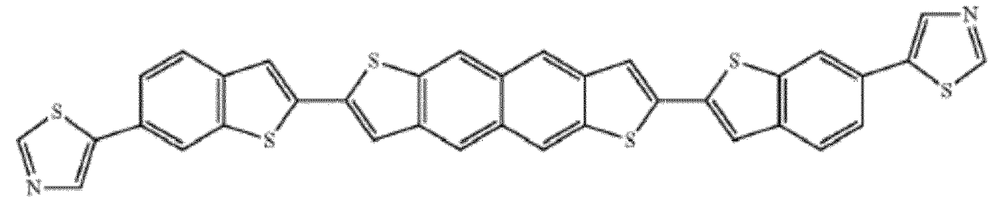

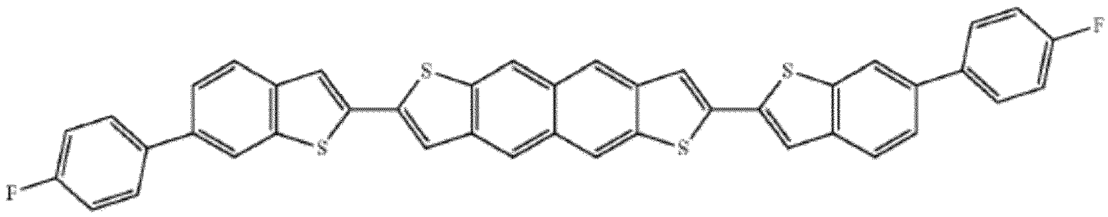

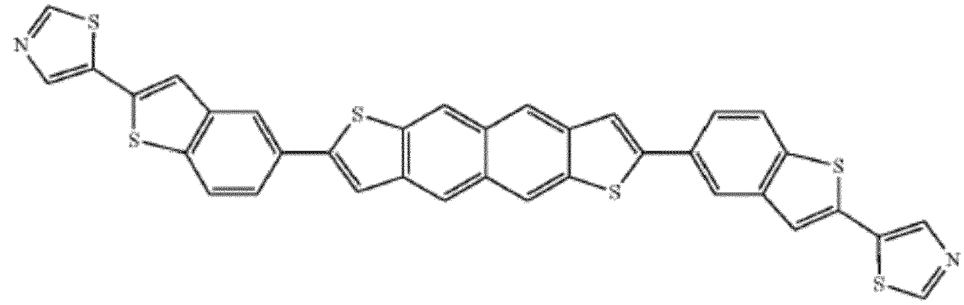

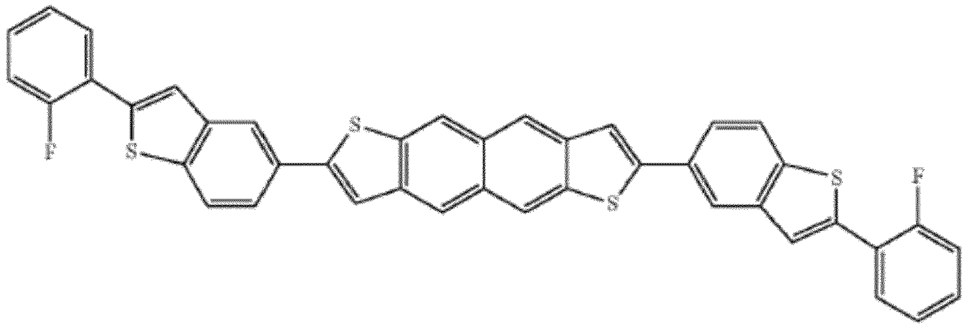

According to an embodiment, wherein the interlayer compound or the interlayer compound of formula (I) is selected from A1 to A73

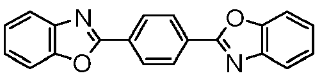 A1,

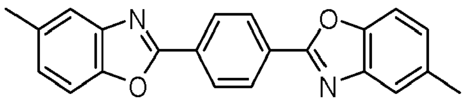 A2,

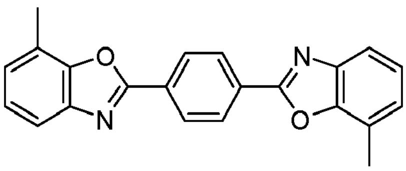 A3,

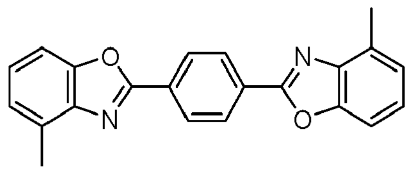 A4,

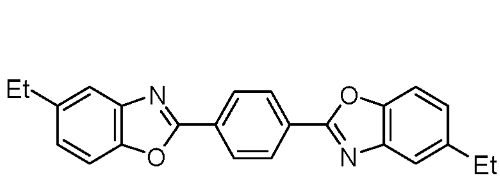 A5,

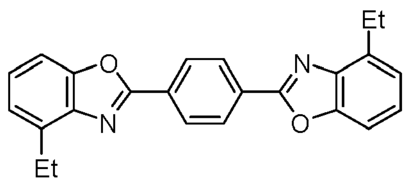 A6,

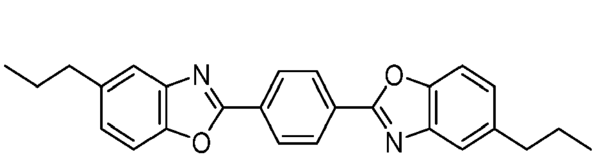 A7,

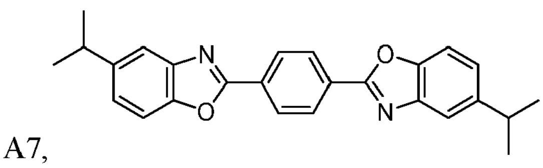 A8,

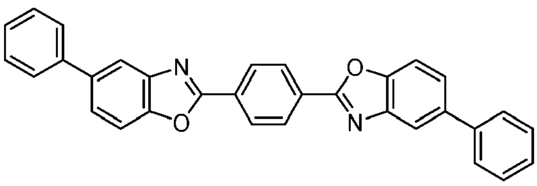 A9,

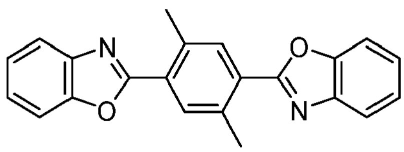 A10,

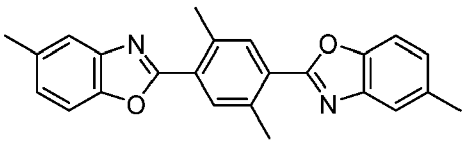
A11,
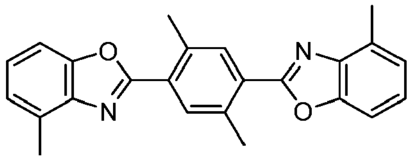
A12,

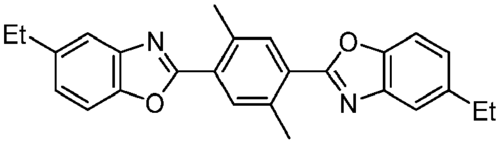
A13,
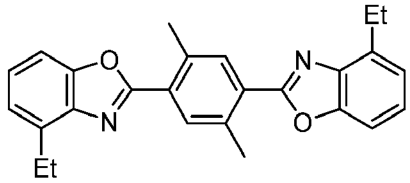
A14,

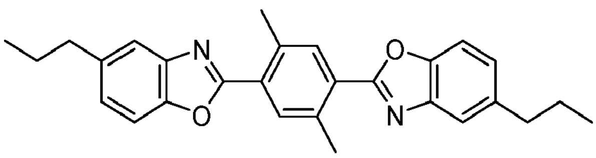
A15,
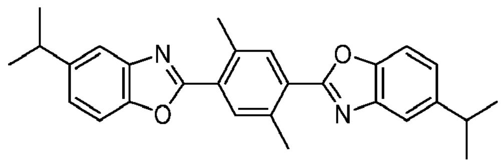

A16,
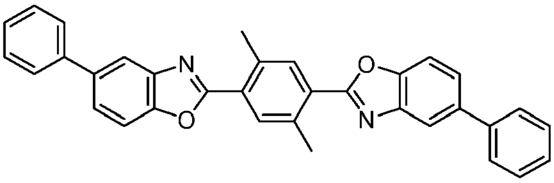
A17,
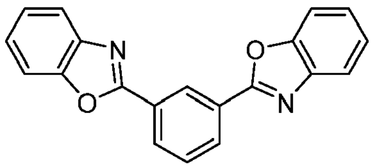
A18,

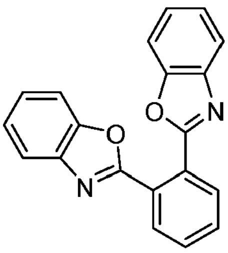
A19,
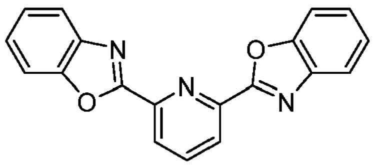
A20, ,
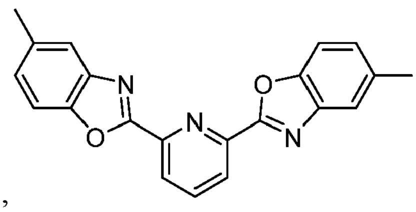

A21,
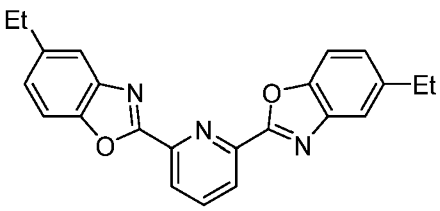
A22,
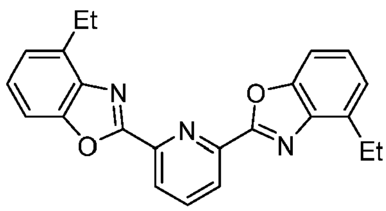
A23,

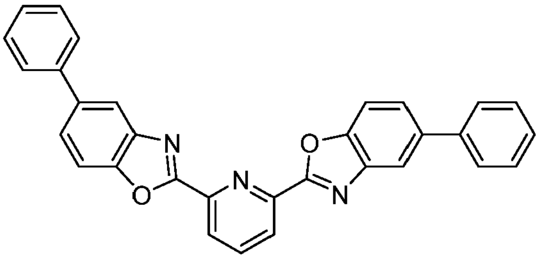
A24
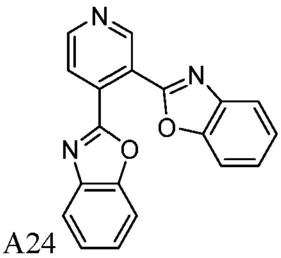
A25,

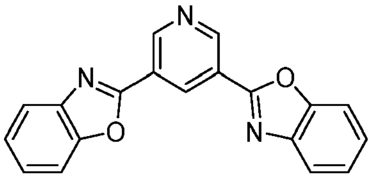 A26, 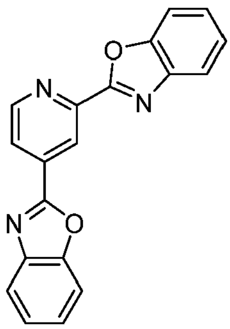 A27, 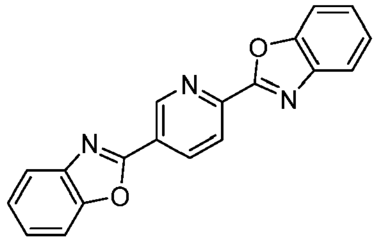 A28,

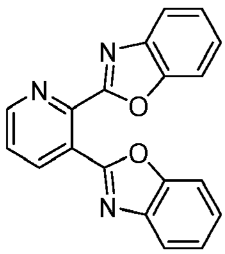 A29, 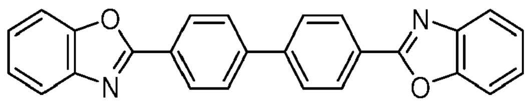 A30,

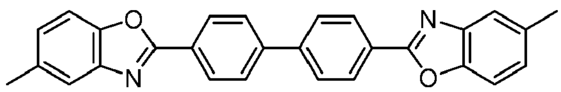 A31, 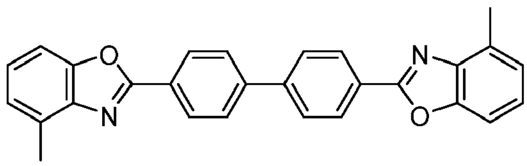 A32,

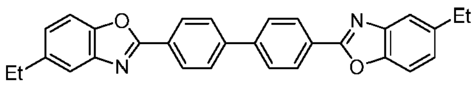 A33, 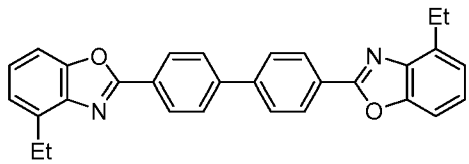 A34,

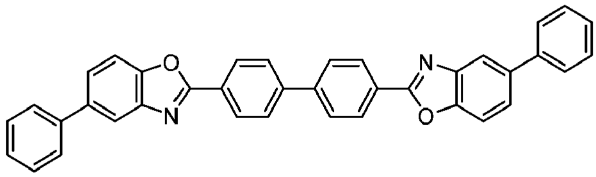 A35, 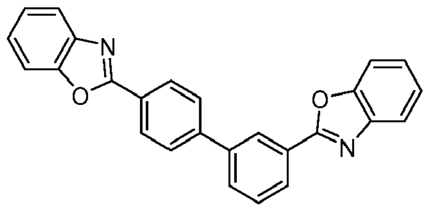 A36,

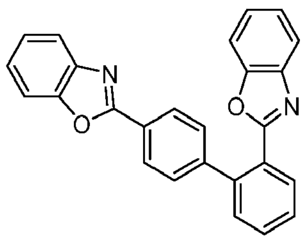 A37, 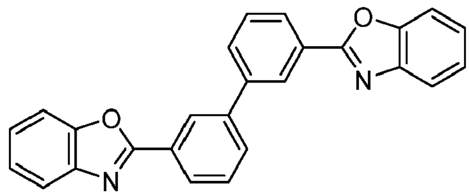 A38,

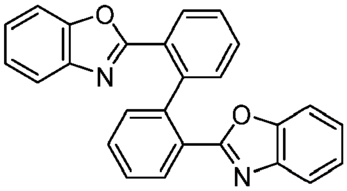 A39,

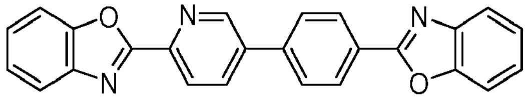 A40,

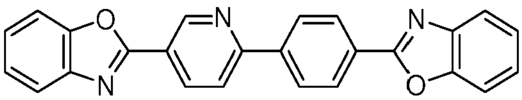 A41,

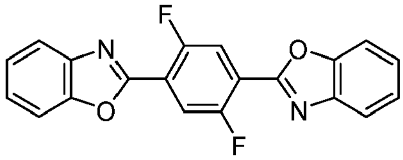 A42,

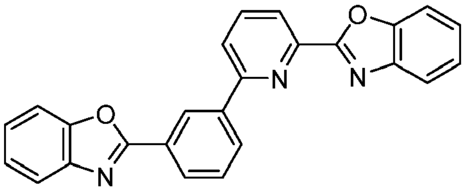 A43,

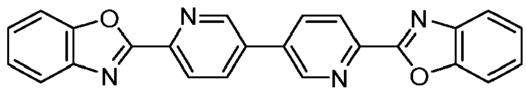 A44,

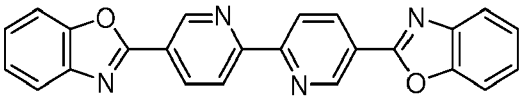 A45,

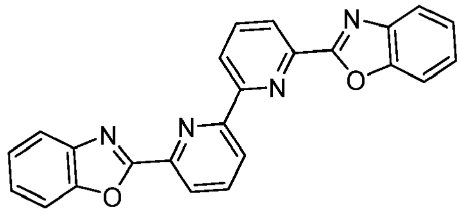 A46,

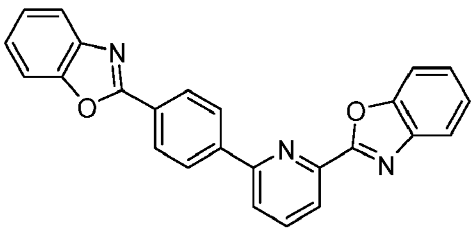 A47,

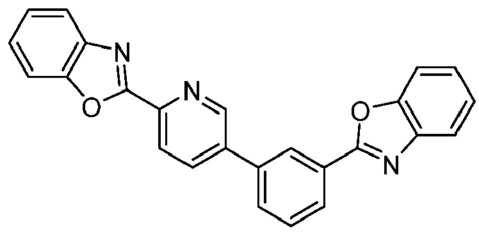 A48,

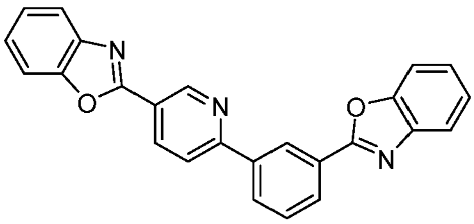 A49,

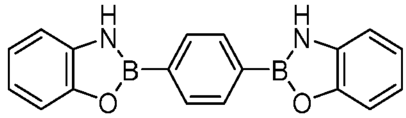 A50,

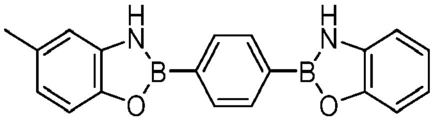 A51,

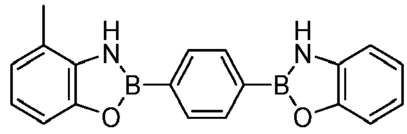 A52,

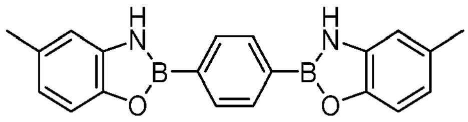 A53, 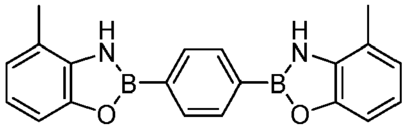 A54,

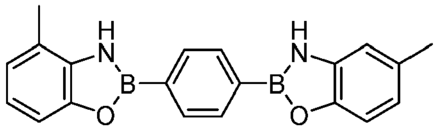 A55, 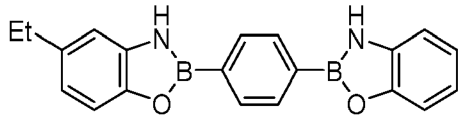 A56,

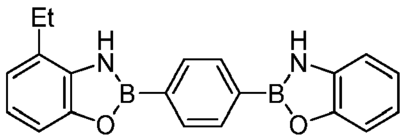 A57, 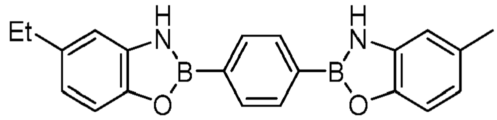 A58,

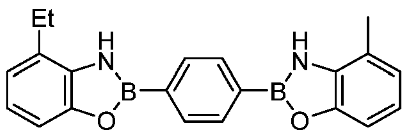 A59, 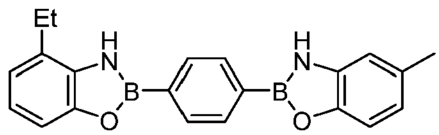 A60,

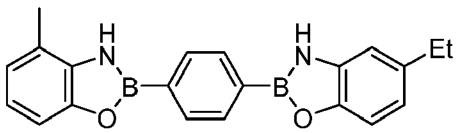 A61, 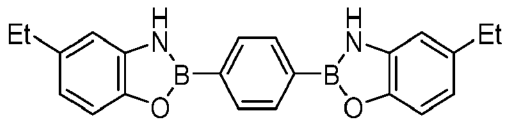 A62,

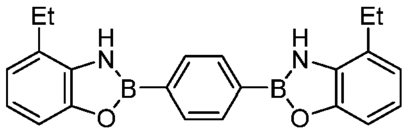 A63, 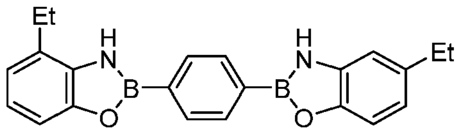 A64,

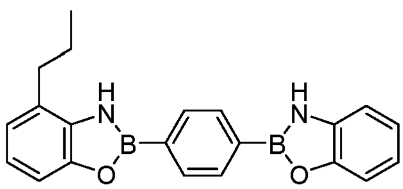 A65, 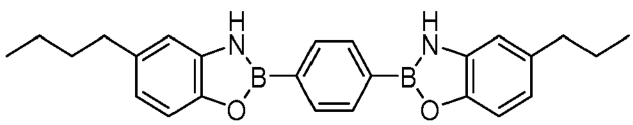 A66,

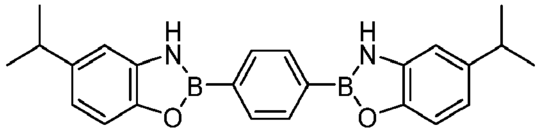 A67, 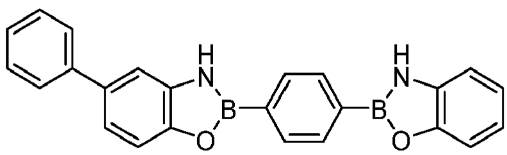 A68,

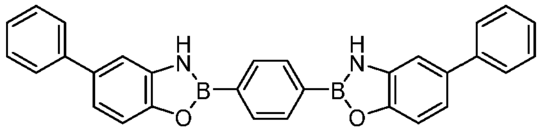 A69, 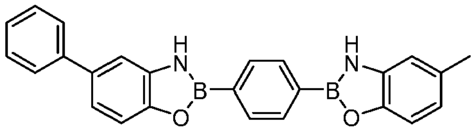 A70,

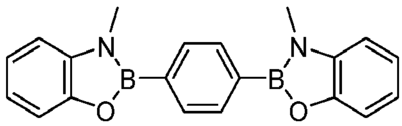 A71, 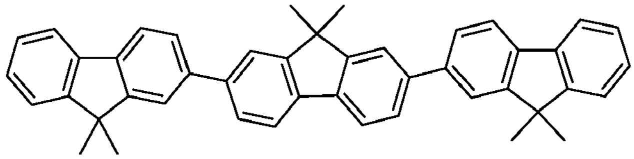 A72,

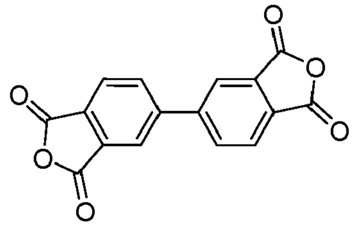 A73.

According to an embodiment, the interlayer compound or the interlayer compound of formula (I) is selected from:

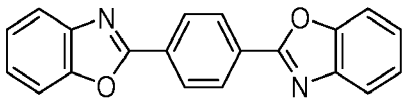 A1, 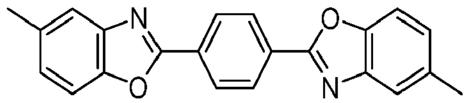 A2,

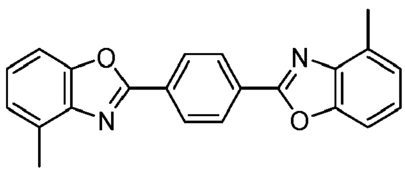 A4, 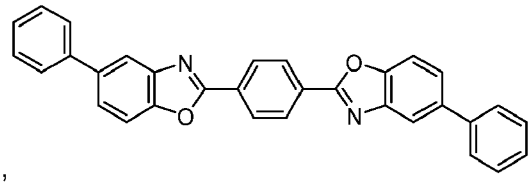 A9,

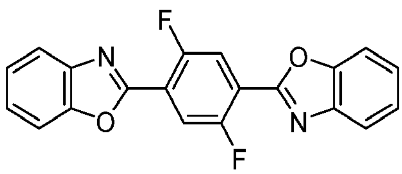 A42, 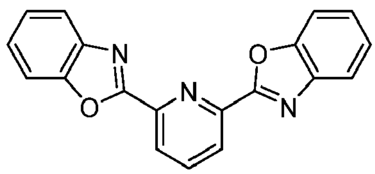 A20,

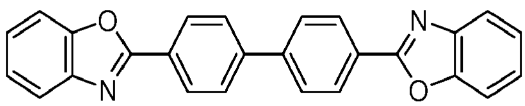 A30, 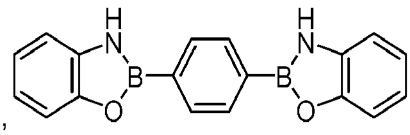 A50,

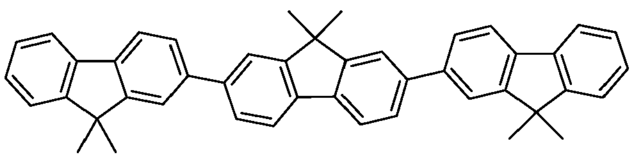 A72, 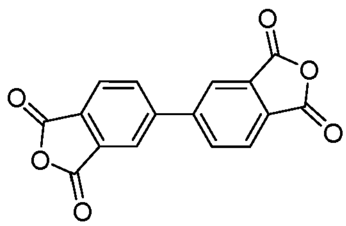 A73.

Interlayer

According to an embodiment, the interlayer essentially consists of the interlayer compound. The term "essentially" especially means ≥97 vol%, more preferred ≥98 vol% and most preferred ≥99 vol%.

According to an embodiment, the interlayer is a **non-flat layer,** a closed layer, a **non-closed** layer, a **non-flat closed** layer, or **a non-flat non-closed** layer.

The term "non-flat" especially means /and or includes that the corresponding layer does not have a uniform

thickness throughout the device.

The term "non-closed" especially means and or includes that there can be areas where the corresponding layer is interrupted.

Correspondingly, the term "non-flat non closed" especially means and/or includes that the corresponding layer does not have a uniform thickness throughout the device and includes areas where the corresponding layer is interrupted.

According to an embodiment, wherein the interlayer has a thickness from 1 nm to 200 nm preferably 1 nm to 100 nm.

Organic semiconductor layer

According to the invention, the organic photodetector comprises an organic semiconductor layer.

According to an embodiment, wherein the organic semiconductor layer is in direct contact to the photoconversion unit.

According to an embodiment, the organic semiconductor layer is in direct contact to the photoconversion unit, wherein the organic semiconductor layer comprises a compound having a LUMO energy level,

and wherein an electron acceptor compound in direct contact to the organic semiconductor layer has a LUMO energy level,
wherein a difference of the LUMO energy level of the compound and the electron acceptor compound is in the range of ≥0. 1 eV to ≤2.5 eV, preferably ≥0.5 eV to ≤2.5 eV, more preferably ≥0.75 eV to ≤2.5 eV, and most preferably ≥1.0 eV to ≤2.5 eV;
wherein the LUMO energy level is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer comprises a compound having a LUMO energy level of ≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ -1.5 eV; wherein the LUMO energy level is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer comprises a compound having a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV; wherein the HOMO energy level is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer comprises a compound having a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV; wherein the triplet state energy is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer comprises a compound having a LUMO energy level of ≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV, and a **HOMO** energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV; wherein the LUMO energy level, and the HOMO energy level are calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer comprises a compound, wherein the compound has a LUMO energy level of ≥ -2.7 eV to ≤ - 1.2 eV; preferably ≥ -2.5 eV to ≤ - 1.3 eV; more preferably ≥ -2.4 eV to ≤ -1.4 eV;

and most preferably ≥ -2.3 eV to ≤ - 1.5 eV; and a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV; wherein the LUMO energy level, and the triplet state energy are calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer comprises a compound, wherein the compound has a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV; and a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV; wherein the HOMO energy level, and the triplet state energy are calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer comprises a compound, wherein the compound has a LUMO energy level of ≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV; and a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV;
a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV; and a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV; wherein the LUMO energy level, the HOMO energy level, and the triplet state energy are calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer comprises a compound having a LUMO energy level, and wherein the electron acceptor has a LUMO energy level, wherein a difference of the LUMO energy level of the compound and the electron acceptor compound is in the range of ≥0.1 eV to ≤2.5 eV, preferably ≥0.5 eV to ≤2.5 eV, more preferably ≥0.75 eV to ≤2.5 eV, and most preferably ≥1.0 eV to ≤2.5 eV wherein the LUMO energy level is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer comprises a compound; wherein the compound is a hole blocking compound and/or an electron transport compound; preferably a hole blocking layer.

According to an embodiment, the organic semiconductor layer comprises a compound, wherein the compound is a hole blocking compound.

According to an embodiment, the organic semiconductor layer is selected from a hole blocking layer, or an electron transport layer; wherein the hole blocking layer, if present, comprises a hole blocking compound, and the electron transport layer, if present, comprises an electron transport compound; preferably the organic semiconductor layer is selected from a hole blocking layer, wherein the hole blocking layer comprises a hole blocking compound.

According to an embodiment, the organic semiconductor layer comprises a hole blocking compound and/or an electron transport compound, wherein the hole blocking compound, if present, has a LUMO energy level of ≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ -1.5 eV, and a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV;
wherein the electron transport compound, if present, has a LUMO energy level of≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV; wherein the LUMO energy level, and HOMO energy level is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer comprises a hole blocking compound and/or an electron transport compound, wherein the hole blocking compound has a LUMO energy level of≥ -2.7 eV to ≤ - 1.2 eV;

preferably ≥ -2.5 eV to ≤ - 1.3 eV; more preferably ≥ -2.4 eV to ≤ -1.4 eV; and most preferably ≥ -2.3 eV to ≤ -1.5 eV; and a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV;
wherein the electron transport compound, if present, has a LUMO energy level of≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV; wherein the LUMO energy level, and triplet state energy is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer comprises a hole blocking compound and/or an electron transport compound, wherein the hole blocking compound has a LUMO energy level of≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV; a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV;

and a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV;
wherein the electron transport compound, if present, has a LUMO energy level of≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV; wherein the LUMO energy level, HOMO energy level, and triplet state energy are calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer comprises a hole blocking compound; wherein the hole blocking compound has a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV; wherein the HOMO energy level is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer comprises a hole blocking compound; wherein the hole blocking compound has a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV; wherein the triplet state energy is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer comprises an electron transport compound having a LUMO energy level and/or a hole blocking compound having a LUMO energy level, and wherein the electron acceptor compound has a LUMO energy level, wherein a difference of the LUMO energy level of the hole blocking compound, if present, and the electron acceptor compound is in the range of ≥0. 1 eV to ≤2.5 eV, preferably ≥0.5 eV to ≤2.5 eV, more preferably ≥0.75 eV to ≤2.5 eV, and most preferably ≥1.0 eV to ≤2.5 eV;

wherein a difference of the LUMO energy level of the electron transport compound, if present, and the electron acceptor compound is in the range of ≥0.1 eV to ≤2.5 eV, preferably >0.5 eV to ≤2.5 eV, more preferably ≥0.75 eV to ≤2.5 eV, and most preferably ≥1.0 eV to ≤2.5 eV;
wherein the LUMO energy level is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer is in direct contact to the photoconversion unit, wherein the organic semiconductor layer comprises an electron transport compound and/or hole blocking compound having a LUMO energy level, and wherein an electron acceptor compound in direct contact to the organic semiconductor

layer has a LUMO energy level, wherein a difference of the LUMO energy level of the electron transport compound, if present, and the electron acceptor compound is in the range of ≥0.1 eV to ≤2.5 eV, preferably ≥0.5 eV to ≤2.5 eV, more preferably ≥0.75 eV to ≤2.5 eV, and most preferably ≥1.0 eV to ≤2.5 eV;

wherein a difference of the LUMO energy level of the hole blocking compound, if present, and the electron acceptor compound is in the range of ≥0.1 eV to ≤2.5 eV, preferably ≥0.5 eV to ≤2.5 eV, more preferably ≥0.75 eV to ≤2.5 eV, and most preferably ≥1.0 eV to ≤2.5 eV;

wherein the LUMO energy level is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer is selected from a hole blocking layer, or an electron transport layer, wherein the hole blocking layer, if present, comprises a hole blocking compound, and the electron transport layer, if present, comprises an electron transport compound.

According to an embodiment, the organic semiconductor layer is selected from a hole blocking layer, or an electron transport layer, wherein the hole blocking layer, if present, comprises a hole blocking compound, and the electron transport layer, if present, comprises an electron transport compound; wherein the hole blocking compound, if present, have a LUMO energy level of ≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV; and wherein the hole blocking compound has a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV; and

wherein the electron transport compound, if present, have a LUMO energy level of ≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV; wherein the LUMO energy level, and HOMO energy level are calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer is selected from a hole blocking layer, or an electron transport layer, wherein the hole blocking layer, if present, comprises a hole blocking compound, and the electron transport layer, if present, comprises an electron transport compound; wherein the hole blocking compound, if present, has a LUMO energy level of ≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV; and a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV; and

wherein the electron transport compound, if present, has a LUMO energy level of≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV; wherein the LUMO energy level, and triplet state energy are calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer is selected from a hole blocking layer, or an electron transport layer, wherein the hole blocking layer, if present, comprises a hole blocking compound, and the electron transport layer, if present, comprises an electron transport compound; wherein the hole blocking compound, if present, has a LUMO energy level of ≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV;

a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV;

and a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV; and

wherein the electron transport compound, if present, has a LUMO energy level of≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV; wherein the LUMO energy level, HOMO energy level, and triplet state energy is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and

the HOMO and LUMO energy levels of the molecular structures are determined by applying the hybrid functional B3LYP with a 6-31 G* basis set in the gas phase.

According to an embodiment, the organic semiconductor layer is selected from a hole blocking layer, wherein the hole blocking layer comprises a hole blocking compound; wherein the hole blocking compound has a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV; wherein the HOMO energy level is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer is selected from a hole blocking layer, wherein the hole blocking layer comprises a hole blocking compound; wherein the hole blocking compound has a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV; wherein the triplet state energy is calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the organic semiconductor layer is selected from a hole blocking layer; wherein the hole blocking layer comprises a hole blocking compound, and wherein the hole blocking compound has a LUMO energy level of ≥ -2.7 eV to ≤ - 1.2 eV; preferably ≥ - 2.5 eV to ≤ - 1.3 eV; more preferably ≥ -2.4 eV to ≤ -1.4 eV; and most preferably ≥ -2.3 eV to ≤ - 1.5 eV; and a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV; wherein the LUMO energy level, and HOMO energy level are calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer is selected from a hole blocking layer, wherein the hole blocking layer comprises a hole blocking compound; wherein the hole blocking compound has a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV; and a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV; wherein the HOMO energy level, and triplet state energy are calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the organic semiconductor layer is selected from a hole blocking layer, wherein the hole blocking layer comprises a hole blocking compound; wherein the hole blocking compound has a LUMO energy level of ≥ -2.7 eV to ≤ - 1.2 eV; preferably ≥ -2.5 eV to ≤ - 1.3 eV; more preferably ≥ -2.4 eV to ≤ -1.4 eV; and most preferably ≥ -2.3 eV to ≤ - 1.5 eV;

a HOMO energy level in the range of ≥ -7.5 eV to ≤ - 4.9 eV; preferably ≥ -7.0 eV to ≤ - 5.0 eV; more preferably ≥ -6.5 eV to ≤ -5.1 eV; and most preferably ≥ -6.0 eV to ≤ -5.2 eV;

and a triplet state energy in the range of ≥ 2.3 eV to ≤ 4.5 eV; preferably ≥ 2.4 eV to ≤ 4.25 eV; more preferably ≥ 2.5 eV to ≤ 4.0 eV; and most preferably ≥ 2.6 eV to ≤ 3.5 eV; wherein the LUMO energy level, the HOMO energy level, and the triplet state energy are calculated by method with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

The organic semiconductor layer may be formed on the anode layer or cathode layer by vacuum deposition, spin coating, printing, casting, slot-die coating, Langmuir-Blodgett (LB) deposition, or the like. When the organic semiconductor layer is formed using vacuum deposition, the deposition conditions may vary according to the compound(s) that are used to form the layer, and the desired structure and thermal properties of the layer. In general, however, conditions for vacuum deposition may include a deposition temperature of 100° C to 350° C, a pressure of $10^{-8}$ to $10^{-3}$ Torr (1 Torr equals 133.322

Pa), and a deposition rate of 0.1 to 10 nm/sec.

When the organic semiconductor layer is formed using spin coating or printing, coating conditions may vary according to the compound(s) that are used to form the layer, and the desired structure and thermal properties of the organic semiconductor layer. For example, the coating conditions may include a coating speed of about 2000 rpm to about 5000 rpm, and a thermal treatment temperature of about 80° C to about 200° C. Thermal treatment removes a solvent after the coating is performed.

The thickness of the organic semiconductor layer may be in the range from about 1 nm to about 200 nm, and for example, from about 2 nm to about 150 nm, from about 2 nm to about 100 nm, from about 2 nm to about 50 nm, from about 2 nm to about 15 nm, alternatively about 2 nm to about 12 nm.

According to one embodiment of the present invention the organic semiconductor layer is non-emissive.

In the context of the present specification the term "essentially non-emissive" or "non-emissive" means that the contribution of the compound or layer to the visible emission spectrum from the device is less than 10%, preferably less than 5 % relative to the visible emission spectrum. The visible emission spectrum is an emission spectrum with a wavelength of about ≥ 380 nm to about ≤ 780 nm.

Photoconversion unit

In the following the further components and/or setup of the photoconversion unit will be described in more detail whereby all features can be combined *ad libitum*:
According to an embodiment, the layer(s) of the photoconversion unit are selected from a **non-flat layer,** a closed layer, a **non-closed** layer, a **non-flat closed** layer, or a **non-flat non-closed** layer.

It should be noted that in case the photoconversion unit comprises one or more layers which comprise more than one compound it can be that in said one or more layers - for each layer independently if there are more than one - said compounds are homogeneously distributed amongst the layer or that one or more compounds show topical unequal distribution. According to one embodiment of the present invention said compound(s) may be described as forming itself a non-closed, non-flat and/or non-flat-none closed- subsection within said layer.

According to an embodiment, the photoconversion unit is selected from photoconversion units (i) to (viii)

(i) the photoconversion unit comprises a first layer, wherein the first layer of the photoconversion unit comprises **the** electron donor compound and **the** electron acceptor compound;

(ii) the photoconversion unit comprises a first layer, and a second layer; wherein the first layer of the photoconversion unit comprises **the** electron donor compound and a **further** electron acceptor compound; and wherein the second layer of the photoconversion unit comprises **the** electron acceptor compound;

(iii) the photoconversion unit comprises a first layer, and a second layer; wherein the first layer of the photoconversion unit comprises **the** electron donor compound; and wherein the second layer of the photoconversion unit comprises **the** electron acceptor compound;

(iv) the photoconversion unit comprises a first layer, wherein the first layer of the photoconversion unit comprises **the** electron donor compound and **the** electron acceptor compound; wherein the first layer of the photoconversion layer is in direct contact to the organic semiconductor layer;

(v) the photoconversion unit comprises a first layer, and a second layer; wherein the first layer of the photoconversion unit comprises **the** electron donor compound and a **further** electron acceptor compound; and wherein the second layer of the photoconversion unit comprises **the** electron acceptor compound; wherein the second layer of the photoconversion unit is in direct contact to the organic semiconductor layer; or

(vi) the photoconversion unit comprises a first layer, and a second layer; wherein the first layer of the photoconversion unit comprises **the** electron donor compound; and wherein the second layer of the photoconversion unit comprises **the** electron acceptor compound wherein the second layer of the photoconversion unit is in direct contact to the organic semiconductor layer;

(vii) the photoconversion unit comprises a first layer, and a second layer; wherein the first layer of the photoconversion unit comprises **the** electron donor compound and a **further** electron acceptor compound; and wherein the second layer of the photoconversion unit comprises **the** electron acceptor compound; wherein the second layer of the photoconversion unit is in direct contact to the organic semiconductor layer; wherein the first layer of the photoconversion unit is in direct contact to the second layer of the photoconversion unit; or

(viii) the photoconversion unit comprises a first layer, and a second layer; wherein the first layer of the photoconversion unit comprises **the** electron donor compound; and wherein the second layer of the photoconversion unit comprises **the** electron acceptor compound wherein the second layer of the photoconversion unit is in direct contact to the organic semiconductor layer; wherein the first layer of the photoconversion unit is in direct contact to the second layer of the photoconversion unit.

According to an embodiment, wherein the photoconversion unit is selected from photoconversion units (i), (ii), (iv), (v), (vi), (vii), and (viii).
According to embodiment, wherein the photoconversion unit is selected from photoconversion units (i), (ii), (iv), (v), and (vii).
According to embodiment, wherein the photoconversion unit is selected from photoconversion units (i), and (v).
According to an embodiment, wherein the photoconversion unit, or the photonversion unit (i) to (viii) has a thickness from 1 nm to 300 nm, preferably from 2 nm to 300 nm, more preferably from 5 nm to 300 nm.

Electron donor compound

According to an embodiment, the electron donor compound absorbs light in the range of ≥ 380 nm to ≤ 2.5 μm, preferably ≥ 490 to ≤ 2.5 μm.
According to an embodiment, the electron donor compound has an energy gap Egap between its HOMO energy level and its LUMO energy level of ≥ 0.4 eV to ≤ 3.3 eV preferably ≥ 0.4 eV to ≤2.8 eV, wherein the energy gap, the HOMO energy level, and the LUMO energy level calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.
According to an embodiment, the electron donor compound has an energy gap $E_{gap}$ between its LUMO energy level and its HOMO energy level ≥ 0.4 eV to ≤ 3.3 eV preferably ≥ 0.4 eV to ≤2.8 eV; wherein the energy gap, the HOMO energy level, and the LUMO energy level are calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.
According to an embodiment, the electron donor compound has a LUMO energy level in the range of ≥ -4.0 eV to ≤ -1.0 eV, preferably ≥ -4.0 eV to ≤ -2.0 eV, more preferably ≥ -4.0 eV to ≤-2.5 eV, wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.
According to an embodiment, the electron donor compound comprises a phthalocyanine compound, a perylene-based compound, a squaraine dye compound, subphthalocyanine (SubPc), zinc phthalocyanine (ZnPc), ditolyaminothienyl-benzothiadiazole-dicyanovinylene (DTDCTB), lead phthalocyanine (PbPc), 5,10,15,20-Tetraphenyl bisbenz[5,6] indeno[1,2,3-cd: 1',2',3'-lm]perylene (DBP), copper phthalocyanine (CuPc), tin phthalocyanine (SnPc), quinacridone, quinacridone-derivatives

**Electron acceptor compound**

According to an embodiment, the electron acceptor compound absorbs light in the wave length range of ≥ 380 nm to ≤ 2.5 μm, preferably ≥ 490 to ≤ 2.5 μm.
According to an embodiment, the electron acceptor compound has a LUMO energy level in the range of ≥ -4.5 eV to ≤ -2.5 eV, preferably ≥ -4.5 eV to ≤ -3.0 eV, wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.
According to an embodiment, the electron acceptor compound has a LUMO energy level in the range of ≥ -4.5 eV to ≤ -2.5 eV, preferably ≥ -4.5 eV to ≤ -3.0 eV, wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the

HOMO and LUMO energy levels of the molecular structures are determined by applying the hybrid functional B3LYP with a 6-31G* basis set in the gas phase.

According to an embodiment, the electron acceptor compound has an energy gap Egap between its LUMO energy level and its HOMO energy level in the range of ≥0.01 eV to ≤5.0 eV; preferably ≥0.4 eV to ≤3.3 eV, and more preferably ≥0.4 eV to ≤2.8 eV, wherein the energy gap, the HOMO energy level, and the LUMO energy level are calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the electron acceptor compound comprises Fullerene-$C_{70}$ [115383-22-7], Fullerence-$C_{60}$ [99685-96-8], [6,6]-phenyl-$C_{71}$-butyric acid methyl ester (abbreviation: $PC_{71}BM$), [6,6]-phenyl-$C_{61}$-butyric acid methyl ester (abbreviation: $PC_{61}BM$), and 1',1",4',4"-tetrahydro-di[1,4]methanonaphthaleno[1,2:2',3',56,60:2",3"][5,6]fullerene-$C_{60}$ (abbreviation: ICBA), a fullerene derivative, a perylene tetracarboxylic diimide (PTCDI) derivative, a perylene tetracarboxylic dianhydride (PTCDA) derivative, or the like

According to an embodiment, the electron donor compound has a LUMO energy level and wherein the electron acceptor compound has a LUMO energy level, wherein the LUMO energy level of the electron donor compound is equal or larger than the LUMO energy level of the electron acceptor compound, wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the electron donor compound has a LUMO energy level and a HOMO energy level, and wherein the electron acceptor compound has a LUMO energy level and a HOMO energy level, wherein the LUMO energy level of the electron donor compound is equal or larger than the LUMO energy level of the electron acceptor compound, and wherein the HOMO energy level of the electron donor compound is equal or larger than the HOMO energy level of the electron acceptor compound;

wherein the HOMO energy level and the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the electron donor compound has a LUMO energy level and a HOMO energy level, and wherein the electron acceptor compound has a LUMO energy level and a HOMO energy level, wherein the LUMO energy level of the electron donor compound is larger than the LUMO energy level of the electron acceptor compound, and wherein the HOMO energy level of the electron donor compound is equal or larger than the HOMO energy level of the electron acceptor compound;

wherein the HOMO energy level and the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31 G* basis set in the gas phase.

According to an embodiment, the electron donor compound has a LUMO energy level and a HOMO energy level, and wherein the electron acceptor compound has a LUMO energy level and a HOMO energy level, wherein the LUMO energy level of the electron donor compound larger than the LUMO energy level of the electron acceptor compound, and wherein the HOMO energy level of the electron donor compound is larger than the HOMO energy level of the electron acceptor compound;

wherein the HOMO energy level and the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the electron donor compound has a LUMO energy level and wherein the electron acceptor compound has a LUMO energy level, wherein the LUMO energy level of the electron acceptor compound is equal or further away from vacuum level than the LUMO energy level of the electron donor compound, wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the LUMO energy levels of the molecular structures are determined by applying the hybrid functional B3LYP with a 6-31G* basis set in the gas phase.

According to an embodiment, the electron donor compound has a LUMO energy level and and a HOMO energy level, wherein the electron acceptor compound has a LUMO energy level and a HOMO energy level, wherein the LUMO energy level of the electron acceptor compound is equal or further away from vacuum level than the LUMO energy level of the electron donor compound, wherein the HOMO energy level of the electron acceptor compound is equal or further away from vacuum level than the HOMO energy level of the electron donor compound, wherein the HOMO energy level and wherein the HOMO energy level and the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the electron donor compound has a LUMO energy level and a HOMO energy level, and wherein the electron acceptor compound has a LUMO energy level and HOMO energy level, wherein the LUMO energy level of the electron acceptor compound is further away from vacuum level than the LUMO energy level of the electron donor compound, wherein the HOMO energy level of the electron acceptor compound is equal or further away from vacuum level than the HOMO energy level of the electron donor compound, wherein the HOMO energy level and the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, the electron donor compound has a LUMO energy level and a HOMO energy level, and wherein the electron acceptor compound has a LUMO energy level and HOMO energy level, wherein the LUMO energy level of the electron acceptor compound is further away from vacuum level than the LUMO energy level of the electron donor compound, wherein the HOMO energy level of the electron acceptor compound is further away from vacuum level than the HOMO energy level of the electron donor compound, wherein the HOMO energy level and the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, wherein the electron **donor** compound has a LUMO energy level, the electron **acceptor** compound has a LUMO energy level, and the additional compound has a LUMO energy level, wherein the **LUMO** energy level of the **the additional compound** is **larger than** the LUMO energy level of the electron **donor** compound,

wherein the **LUMO** energy level of the electron **donor** compound is equal or **larger than** the LUMO energy level of the electron **acceptor** compound; wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase.

According to an embodiment, wherein the electron **donor** compound has a LUMO energy level, the electron **acceptor** compound has a LUMO energy level, and the interlayer compound has a LUMO energy level, wherein the **LUMO** energy level of the **interlayer compound** is **larger than** the LUMO energy level of the electron **donor** compound,

wherein the **LUMO** energy level of the electron **donor** compound is equal or **larger than** the LUMO energy level of the electron **acceptor** compound; wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the LUMO energy levels of the molecular structures are determined by applying the hybrid functional B3LYP with a 6-31G* basis set in the gas phase.

According to an embodiment, wherein the electron **donor** compound has a LUMO energy level, the electron **acceptor** compound has a LUMO energy level, and the interlayer compound has a LUMO energy level, wherein the **LUMO** energy level of the **interlayer compound** is **larger than** the LUMO energy level of the electron **donor** compound,

wherein the **LUMO** energy level of the electron **donor** compound is **larger than** the LUMO energy level of the electron **acceptor** compound; wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the LUMO energy levels of the molecular structures are determined by applying the hybrid functional B3LYP with a 6-31G* basis set in the gas phase.

According to an embodiment, wherein the electron donor compound has a LUMO energy level, the electron acceptor compound has a LUMO energy level, and the interlayer compound has a LUMO energy level,

wherein the LUMO energy level of the electron acceptor compound is equal or further away from the vacuum level than the LUMO energy level of the electron donor compound,

wherein the LUMO energy level of the electron donor compound is further away from the vacuum level than the LUMO energy level of the interlayer compound;

wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the LUMO energy levels of the molecular structures are determined by applying the hybrid functional B3LYP with a 6-31 G* basis set in the gas phase.

According to an embodiment, wherein the electron donor compound has a LUMO energy level, the electron acceptor compound has a LUMO energy level, and the interlayer compound has a LUMO energy level,

wherein the LUMO energy level of the electron acceptor compound is further away from the vacuum level than the LUMO energy level of the electron donor compound,

wherein the LUMO energy level of the electron donor compound is further away from the vacuum level than the LUMO energy level of the interlayer compound;

wherein the LUMO energy level is calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the LUMO energy levels of the molecular structures are determined by applying the hybrid functional B3LYP with a 6-31G* basis set in the gas phase.

Organic photodetector

According to an embodiment, the organic photodetector has a dark current density of $-1\times10^{-4}$ mA/cm or less when a reverse Bias of -3V$\pm$0.05 is applied.

The dark current density of an organic photodetector may be measured in dark conditions by applying a voltage at -3V$\pm$0.05.

The dark current density of an organic photodetector may be measured in dark conditions by applying a voltage at -3V$\pm$0.05, wherein the positive pol of the current-voltage measurement device is connected to the anode layer of the organic photodetector, and wherein the negative pol of the current-voltage measurement device is connected to the cathode layer of the organic photodetector.

The voltage may be applied for a period of at least one second before the current is measured.

The minimum measurement time of the current is selected so that the effects of current fluctuations in the external grid on the measured value disappear.

The "dark current density" is the current density which is determined when the organic photodetector is not exposed to light.

The organic photodetector messured may have an area size from 0.01 $mm^2$ - 30 $mm^2$, preferably 2.0 $mm^2$ to 10.0 $mm^2$, more preferably 4.0 to 7.0 $mm^2$, and most preferably 6.0 $mm^2$ to 7.0 $mm^2$.

The area size of the organic photodetector is determined by the area wherein the anode layer, cathode layer, and the layers between the anode layer and the cathode layer overlaps.

In the overlap of the area anode layer, cathode layer, and the layer between the anode layer and cathode layer are stacked on top of each other. The anode layer area may be defined by a pixel definition layer aperture like shown in the figures

For the measurement of the dark current density, the organic photodetector may be encapsulated. The encapsulation of the organic photodetector may be a thin film encapsulation or an encapsulation lid, wherein the encapsulation lid provides a cavity, which includes a getter material. In particular, the encapsulation lid is a glass lid.

The applying of the voltage and the measurement of the current may be conducted by means of a Keithley SM2635B.

When using a Keithley SM2635B, the voltage may be applied for a period of at least one second before the current is measured with a minimum measurement time of the current, wherein the minimum measurement time of the current is selected so that the effects of the current fluctuations in the external grid on the measured value disappear.

When using a Keithley SM2635B, the minimum measurement time of the current is at least 5 NPLC (Number of Power Line-Cycles).

According to an embodiment, the organic photodetector further comprises an electron transport layer, an electron injection layer; a hole injection layer, hole transport layer, an electron blocking layer, an electron transport layer, and/or an electron injection layer.

According to an embodiment, the organic photodetector further comprises an electron transport layer and/or an electron injection layer; preferably an electron transport layer and an electron injection layer; more preferably an electron

transport layer and an electron injection layer, wherein the organic semiconductor layer is a hole blocking layer.

According to an embodiment, the organic photodetector further comprises a hole injection layer, hole transport layer and/or an electron blocking layer, preferably a hole injection layer and a hole transport layer, more preferably a hole injection layer, hole transport layer and an electron blocking layer.

According to an embodiment, the organic photodetector further comprises a hole injection layer, hole transport layer, an electron transport layer, and an electron injection layer

According to an embodiment, the organic photodetector further comprises a hole injection layer, hole transport layer, an electron blocking layer, an electron transport layer, and an electron injection layer.

According to an embodiment, the organic photodetector further comprises a hole injection layer, hole transport layer, an electron transport layer, and an electron injection layer, wherein the organic semiconductor layer is a hole blocking layer.

According to an embodiment, the organic photodetector further comprises a hole injection layer, hole transport layer, an electron blocking layer, an electron transport layer, and an electron injection layer, wherein the organic semiconductor layer is a hole blocking layer.

## Organic electronic device

According to another aspect of the present invention, an organic electronic device is provided, comprising a substrate, an organic photodetector, an organic light-emitting device;

wherein the organic photodetector and the organic light-emitting device is disposed on the substrate;
wherein the organic photodetector is an organic photodetector as described in this invention,
wherein the organic light-emitting device comprises

an anode layer, a cathode layer, an organic semiconductor layer, a light-emitting layer a cathode layer;
wherein the organic semiconductor layer and the light-emitting layer are arranged between the anode layer and the cathode layer;
wherein the organic semiconductor layer is arranged between the cathode layer and the organic light-emitting layer;

According to one embodiment of the present invention, the organic light-emitting device is an electroluminescent device, an organic light emitting diode (OLED), or a light emitting device.

According to one embodiment, the cathode layer of the organic light-emitting device and the cathode layer of the organic photodetector is a common cathode layer shared by at least one of the organic light-emitting device and at least one of the organic photodetector.

According to one embodiment, the organic electronic device is a display device.

According to an embodiment, in the organic electronic device the organic semiconductor layer of the organic light-emitting device and the organic semiconductor layer of the organic photodetector is a common organic semiconductor layer shared by at least one of the organic light-emitting device and at least one of the organic photodetector.

According to an embodiment, in the organic electronic device the organic semiconductor layer of the organic light-emitting device and the organic semiconductor layer of the organic photodetector is a common organic semiconductor layer shared by the organic light-emitting device and the organic photodetector.

According to an embodiment, in the organic electronic device the organic light-emitting device further comprises a hole transport region and the organic photodetector comprises a hole transport region.

According to an embodiment, in the organic electronic device the hole transport region of the organic light-emitting device and the hole transport region of the organic photodetector is a common hole transport region shared by at least one of the organic light-emitting device and at least one of the organic photodetector.

According to an embodiment, in the organic electronic device the hole transport region of the organic light-emitting device and the hole transport region of the organic photodetector is a common hole transport region shared by the organic light-emitting device and the organic photodetector.

According to an embodiment, in the organic electronic device the common hole transport region is selected from a common hole injection layer, a common hole transport layer.

According to an embodiment, the organic electronic device further comprises a common electron transport region, wherein the common electron transport region is shared by at least one of the organic light-emitting device and at least one of the organic photodetector.

According to an embodiment, the organic electronic device further comprises a common electron transport region, wherein the common electron transport region is shared by the organic light-emitting device and the organic photodetector.

According to an embodiment, in the organic electronic device the hole transport region of the organic light-emitting device and the hole transport region of the organic photodetector is a common hole transport region shared by at least one organic light-emitting device and at least one organic photodetector; and wherein the organic electronic device further comprises a common electron transport region, wherein the common electron transport is shared by at least one organic light-emitting device and at least one organic photodetector.

According to an embodiment, in the organic electronic device the hole transport region of the organic light-emitting device and the hole transport region of the organic photodetector is a common hole transport region shared by the organic light-emitting device and the organic photodetector; wherein the organic electronic device further comprises a common electron transport region, wherein the common electron transport is shared by the organic light-emitting device and the organic photodetector.

According to an embodiment, the common electron transport region comprises a common hole blocking layer, a common electron transport layer, and/or a common electron injection layer.

According to an embodiment, the organic photodetector of organic electronic device further comprises an electron blocking layer, wherein the electron blocking layer of the organic photodetector is arranged between semiconductor layer and the organic semiconductor layer; and wherein the organic light-emitting device comprises an electron blocking layer, wherein the electron blocking layer is arranged between the organic semiconductor layer and the light-emitting layer, wherein the electron blocking layer of the organic photodetector and the electron blocking layer of the organic light-emitting device is a common electron blocking layer shared by at least one of the organic photodetectors and at least one of the organic light-emitting devices.

According to an embodiment, the organic light-emitting device of the organic electronic device further comprises a hole injection layer, hole transport layer, an electron blocking layer, an electron transport layer, and/or an electron injection layer; wherein, if present, the electron blocking layer is in direct contact to the light-emitting layer; and
wherein the organic photodetector of the the organic light-emitting device of the organic electronic device further comprises a hole injection layer, hole transport layer, an electron transport layer, and/or an electron injection layer, wherein, if present, the hole transport layer is in direct contact to the photoconversion unit.

According to an embodiment, the organic light-emitting device of the organic electronic device further comprises a hole injection layer, hole transport layer, an electron blocking layer, an electron transport layer, and/or an electron injection layer; and
wherein the organic photodetector of the the organic light-emitting device of the organic electronic device further comprises a hole injection layer, hole transport layer, an electron transport layer, and/or an electron injection layer.

According to an embodiment, the organic light-emitting device of the organic electronic device further comprises an electron transport layer and/or an electron injection layer; preferably an electron transport layer and an electron injection layer; more preferably an electron transport layer and an electron injection layer, wherein the organic semiconductor layer is a hole blocking layer; and
wherein the organic photodetector of the organic electronic device further comprises an electron transport layer and/or an electron injection layer; preferably an electron transport layer and an electron injection layer; more preferably an electron transport layer and an electron injection layer, wherein the organic semiconductor layer is a hole blocking layer.

According to an embodiment, the organic light-emitting device of the organic electronic device further comprises a hole injection layer, hole transport layer and an electron blocking layer; wherein the electron blocking layer is in direct contact to the light-emitting layer; and
wherein the organic photodetector of the organic electronic device further comprises a hole injection layer, and a hole transport layer, and wherein the hole transport layer is in direct contact to the photoconversion unit.

According to an embodiment, the organic light-emitting device of the organic electronic device further comprises a hole injection layer, hole transport layer and/or an electron blocking layer, preferably a hole injection layer, hole transport layer and an electron blocking layer; and
wherein the organic photodetector of the organic electronic device further comprises a hole injection layer, and/or a hole transport layer, preferably a hole injection layer, and a hole transport layer.

According to an embodiment, the organic light-emitting device of the organic electronic device further comprises a hole injection layer, hole transport layer and/or an electron blocking layer, preferably a hole injection layer, hole transport layer and an electron blocking layer; and
wherein the organic photodetector of the organic electronic device further comprises a hole injection layer, hole transport layer and/or an electron blocking layer, preferably a hole injection layer, hole transport layer and an electron blocking layer.

According to an embodiment, the organic light-emitting device of the organic electronic device further comprises a hole injection layer, hole transport layer, an electron blocking layer, an electron transport layer, and an electron injection layer; wherein the electron blocking layer is in direct contact to the light-emitting layer; and
wherein the organic photodetector of the organic electronic device further comprises a hole injection layer, hole transport layer, an electron transport layer, and an electron injection layer, wherein the hole transport layer is in direct contact to the photoconversion unit.

According to an embodiment, the organic light-emitting device of the organic electronic device further comprises a hole injection layer, hole transport layer, an electron blocking layer, an electron transport layer, and an electron injection layer; and

wherein the organic photodetector of the organic electronic device further comprises a hole injection layer, hole transport layer, an electron transport layer, and an electron injection layer.

According to an embodiment, the organic light-emitting device of the organic electronic device further comprises a hole injection layer, hole transport layer, an electron blocking layer, an electron transport layer, and an electron injection layer; and

wherein the organic photodetector of the organic electronic device further comprises a hole injection layer, hole transport layer, an electron blocking layer, an electron transport layer, and an electron injection layer.

According to an embodiment, the organic light-emitting device of the organic electronic device further comprises a hole injection layer, hole transport layer, an electron blocking layer, an electron transport layer, and an electron injection layer, wherein the organic semiconductor layer is a hole blocking layer; and wherein the electron blocking layer is in direct contact to the light-emitting layer; and

wherein the organic photodetector of the organic electronic device further comprises a hole injection layer, hole transport layer, an electron transport layer, and an electron injection layer, wherein the organic semiconductor layer is a hole blocking layer, and wherein the hole transport layer is in direct contact to the photoconversion unit.

According to an embodiment, the organic light-emitting device of the organic electronic device further comprises a hole injection layer, hole transport layer, an electron blocking layer, an electron transport layer, and an electron injection layer, wherein the organic semiconductor layer is a hole blocking layer; and

wherein the organic photodetector of the organic electronic device further comprises a hole injection layer, hole transport layer, an electron transport layer, and an electron injection layer, wherein the organic semiconductor layer is a hole blocking layer.

According to an embodiment, the organic light-emitting device of the organic electronic device further comprises a hole injection layer, hole transport layer, an electron blocking layer, an electron transport layer, and an electron injection layer, wherein the organic semiconductor layer is a hole blocking layer; and

wherein the organic photodetector of the organic electronic device further comprises a hole injection layer, hole transport layer, an electron blocking layer, an electron transport layer, and an electron injection layer, wherein the organic semiconductor layer is a hole blocking layer.

According to an embodiment, the organic light-emitting device of the organic electronic device further comprises, an electron transport layer and/or an electron injection layer; preferably an electron transport layer and an electron injection layer; more preferably an electron transport layer and an electron injection layer, wherein the organic semiconductor layer is a hole blocking layer; and

wherein the organic photodetector of the organic electronic device further comprises an electron transport layer and/or an electron injection layer; preferably an electron transport layer and an electron injection layer; more preferably an electron transport layer and an electron injection layer, wherein the organic semiconductor layer is a hole blocking layer; and

wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;

wherein in the organic electronic device the electron transport layer of the organic light-emitting device, if present, and the electron transport layer of the organic photodetector, if present, is a **common electron transport layer** shared by at least one of the organic light-emitting device and at least one of the organic photodetector;

wherein in the organic electronic device the electron injection layer of the organic light-emitting device, if present, and the electron injection layer of the organic photodetector, if present, is a **common electron injection layer** shared by at least one of the organic light-emitting device and at least one of the organic photodetector; ; preferably the common organic semiconductor layer, the common electron transport layer, the common electron injection laye , if present, is shared by the organic light-emitting device and the organic photodetector.

According to an embodiment, the organic light-emitting device of the organic electronic device further comprises a hole injection layer, hole transport layer and/or an electron blocking layer, preferably a hole injection layer, hole transport layer and an electron blocking layer; wherein, if present, the electron blocking layer is in direct contact to the light-emitting layer; and

wherein the organic photodetector of the organic electronic device further comprises a hole injection layer, and/or hole transport layer, preferably a hole injection layer, and a hole transport layer, and wherein, if present, the hole transport layer is in direct contact to the photoconversion unit; and

wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;
wherein in the organic electronic device the hole injection layer of the organic light-emitting device, if present, and the hole injection of the organic photodetector, if present, is a **common hole injection layer** shared by at least one of the organic light-emitting device and at least one of the organic photodetector;
wherein in the organic electronic device the hole transport layer of the organic light-emitting device, if present, and the hole transport layer of the organic photodetector, if present, is a **common hole transport layer** shared by at least one of the organic light-emitting device and at least one of the organic photodetector; preferably the common organic semiconductor layer, the common hole injection layer, and the common hole transport layer, if present, is shared by the organic light-emitting device and the organic photodetector.

According to an embodiment, the organic light-emitting device of the organic electronic device further comprises a hole injection layer, hole transport layer and/or an electron blocking layer, preferably a hole injection layer, hole transport layer and an electron blocking layer; and

wherein the organic photodetector of the organic electronic device further comprises a hole injection layer, and/or hole transport layer, preferably a hole injection layer, and a hole transport layer; and
wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;
wherein in the organic electronic device the hole injection layer of the organic light-emitting device, if present, and the hole injection of the organic photodetector, if present, is a **common hole injection layer** shared by at least one of the organic light-emitting device and at least one of the organic photodetector;
wherein in the organic electronic device the hole transport layer of the organic light-emitting device, if present, and the hole transport layer of the organic photodetector, if present, is a **common hole transport layer** shared by at least one of the organic light-emitting device and at least one of the organic photodetector; preferably the common organic semiconductor layer, the common hole injection layer, and the common hole transport layer, if present, is shared by the organic light-emitting device and the organic photodetector.

According to an embodiment, the organic light-emitting device of the organic electronic device further comprises a hole injection layer, hole transport layer and/or an electron blocking layer, preferably a hole injection layer, hole transport layer and an electron blocking layer; and

wherein the organic photodetector of the organic electronic device further comprises a hole injection layer, hole transport layer and/or an electron blocking layer, preferably a hole injection layer, hole transport layer and an electron blocking layer; and
wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;
wherein in the organic electronic device the hole injection layer of the organic light-emitting device, if present, and the hole injection of the organic photodetector, if present, is a **common hole injection layer** shared by at least one of the organic light-emitting device and at least one of the organic photodetector;
wherein in the organic electronic device the hole transport layer of the organic light-emitting device, if present, and the hole transport layer of the organic photodetector, if present, is a **common hole transport layer** shared by at least one of the organic light-emitting device and at least one of the organic photodetector; preferably the common organic semiconductor layer, the common hole injection layer, and the common hole transport layer, if present, is shared by the organic light-emitting device and the organic photodetector.

According to an embodiment, the organic light-emitting device of the organic electronic device further comprises a hole injection layer, hole transport layer, an electron blocking layer, an electron transport layer, and/or an electron injection layer; and wherein, if present, the electron blocking layer is in direct contact to the light-emitting layer; and

wherein the organic photodetector of the organic electronic device further comprises a hole injection layer, hole transport layer, an electron transport layer, and/or an electron injection layer, and wherein, if present, the hole transport layer is in direct contact to the photoconversion unit; and
wherein in the organic electronic device the organic semiconductor layer of the organic light-emitting device, and the organic semiconductor layer of the organic photodetector is a **common organic semiconductor layer** shared by at

least one of the organic light-emitting device and at least one of the organic photodetector;

wherein in the organic electronic device the electron transport layer of the organic light-emitting device and the electron transport layer of the organic photodetector is a **common electron transport layer** shared by at least one of the organic light-emitting device and at least one of the organic photodetector;

wherein in the organic electronic device the electron injection layer of the organic light-emitting device and the electron injection layer of the organic photodetector is a **common electron injection layer** shared by at least one of the organic light-emitting device and at least one of the organic photodetector;

wherein in the organic electronic device the hole injection layer of the organic light-emitting device and the hole injection of the organic photodetector is a **common hole injection layer** shared by at least one of the organic light-emitting device and at least one of the organic photodetector;

wherein in the organic electronic device the hole transport layer of the organic light-emitting device and the hole transport layer of the organic photodetector is a **common hole transport layer** shared by at least one of the organic light-emitting device and at least one of the organic photodetector; preferably the common organic semiconductor layer, the common electron transport layer, the common electron injection layer, the common hole injection layer, and the common hole transport layer, if present, is shared by the organic light-emitting device and the organic photodetector.

According to an embodiment, the organic light-emitting device of the organic electronic device further comprises a hole injection layer, hole transport layer, an electron blocking layer, an electron transport layer, and/or an electron injection layer; and

wherein the organic photodetector of the organic electronic device further comprises a hole injection layer, hole transport layer, an electron transport layer, and/or an electron injection layer; and

wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;

wherein in the organic electronic device the electron transport layer of the organic light-emitting device and the electron transport layer of the organic photodetector is a **common electron transport layer** shared by at least one of the organic light-emitting device and at least one of the organic photodetector;

wherein in the organic electronic device the electron injection layer of the organic light-emitting device and the electron injection layer of the organic photodetector is a **common electron injection layer** shared by at least one of the organic light-emitting device and at least one of the organic photodetector;

wherein in the organic electronic device the hole injection layer of the organic light-emitting device and the hole injection of the organic photodetector is a **common hole injection layer** shared by at least one of the organic light-emitting device and at least one of the organic photodetector;

wherein in the organic electronic device the hole transport layer of the organic light-emitting device and the hole transport layer of the organic photodetector is a **common hole transport layer** shared by at least one of the organic light-emitting device and at least one of the organic photodetector; preferably the common organic semiconductor layer, the common electron transport layer, the common electron injection layer, the common hole injection layer, and the common hole transport layer, if present, is shared by the organic light-emitting device and the organic photodetector.

According to an embodiment, the organic light-emitting device of the organic electronic device further comprises a hole injection layer, hole transport layer, an electron blocking layer, an electron transport layer, and/or an electron injection layer; and

wherein the organic photodetector of the organic electronic device further comprises a hole injection layer, hole transport layer, an electron blocking layer, an electron transport layer, and/or an electron injection layer; and

wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;

wherein in the organic electronic device the electron transport layer of the organic light-emitting device and the electron transport layer of the organic photodetector is a **common electron transport layer** shared by at least one of the organic light-emitting device and at least one of the organic photodetector;

wherein in the organic electronic device the electron injection layer of the organic light-emitting device and the electron injection layer of the organic photodetector is a **common electron injection layer** shared by at least one of the organic light-emitting device and at least one of the organic photodetector;

wherein in the organic electronic device the hole injection layer of the organic light-emitting device and the hole

injection of the organic photodetector is a **common hole injection layer** shared by at least one of the organic light-emitting device and at least one of the organic photodetector;

wherein in the organic electronic device the hole transport layer of the organic light-emitting device and the hole transport layer of the organic photodetector is a **common hole transport layer** shared by at least one of the organic light-emitting device and at least one of the organic photodetector; preferably the common organic semiconductor layer, the common electron transport layer, the common electron injection layer, the common hole injection layer, and the common hole transport layer, if present, is shared by the organic light-emitting device and the organic photodetector.

According to an embodiment, the organic light-emitting device of the organic electronic device further comprises a hole injection layer, hole transport layer, an electron blocking layer, an electron transport layer, and an electron injection layer; and wherein the electron blocking layer is in direct contact to the light-emitting layer;
and

wherein the organic photodetector of the organic electronic device further comprises a hole injection layer, hole transport layer, an electron transport layer, and an electron injection layer, and wherein the hole transport layer is in direct contact to the photoconversion unit; and

wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;

wherein in the organic electronic device the electron transport layer of the organic light-emitting device and the electron transport layer of the organic photodetector is a **common electron transport layer** shared by at least one of the organic light-emitting device and at least one of the organic photodetector;

wherein in the organic electronic device the electron injection layer of the organic light-emitting device and the electron injection layer of the organic photodetector is a **common electron injection layer** shared by at least one of the organic light-emitting device and at least one of the organic photodetector;

wherein in the organic electronic device the hole injection layer of the organic light-emitting device and the hole injection of the organic photodetector is a **common hole injection layer** shared by at least one of the organic light-emitting device and at least one of the organic photodetector;

wherein in the organic electronic device the hole transport layer of the organic light-emitting device and the hole transport layer of the organic photodetector is a common **hole transport layer** shared by at least one of the organic light-emitting device and at least one of the organic photodetector; preferably the common organic semiconductor layer, the common electron transport layer, the common electron injection layer, the common hole injection layer, and the common hole transport layer is shared by the organic light-emitting device and the organic photodetector.

According to an embodiment, the organic light-emitting device of the organic electronic device further comprises a hole injection layer, hole transport layer, an electron blocking layer, an electron transport layer, and an electron injection layer; and

wherein the organic photodetector of the organic electronic device further comprises a hole injection layer, hole transport layer, an electron transport layer, and an electron injection layer; and

wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;

wherein in the organic electronic device the electron transport layer of the organic light-emitting device and the electron transport layer of the organic photodetector is a **common electron transport layer** shared by at least one of the organic light-emitting device and at least one of the organic photodetector;

wherein in the organic electronic device the electron injection layer of the organic light-emitting device and the electron injection layer of the organic photodetector is a **common electron injection layer** shared by at least one of the organic light-emitting device and at least one of the organic photodetector;

wherein in the organic electronic device the hole injection layer of the organic light-emitting device and the hole injection of the organic photodetector is a **common hole injection layer** shared by at least one of the organic light-emitting device and at least one of the organic photodetector;

wherein in the organic electronic device the hole transport layer of the organic light-emitting device and the hole transport layer of the organic photodetector is a common **hole transport layer** shared by at least one of the organic light-emitting device and at least one of the organic photodetector; preferably the common organic semiconductor layer, the common electron transport layer, the common electron injection layer, the common hole injection layer, and the common hole transport layer is shared by the organic light-emitting device and the organic photodetector.

According to an embodiment, the organic light-emitting device of the organic electronic device further comprises a hole injection layer, hole transport layer, an electron blocking layer, an electron transport layer, and an electron injection layer; and

wherein the organic photodetector of the organic electronic device further comprises a hole injection layer, hole transport layer, an electron blocking layer, an electron transport layer, and an electron injection layer; and
wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;
wherein in the organic electronic device the electron transport layer of the organic light-emitting device and the electron transport layer of the organic photodetector is a **common electron transport layer** shared by at least one of the organic light-emitting device and at least one of the organic photodetector;
wherein in the organic electronic device the electron injection layer of the organic light-emitting device and the electron injection layer of the organic photodetector is a **common electron injection layer** shared by at least one of the organic light-emitting device and at least one of the organic photodetector;
wherein in the organic electronic device the hole injection layer of the organic light-emitting device and the hole injection of the organic photodetector is a **common hole injection layer** shared by at least one of the organic light-emitting device and at least one of the organic photodetector;
wherein in the organic electronic device the hole transport layer of the organic light-emitting device and the hole transport layer of the organic photodetector is a common **hole transport layer** shared by at least one of the organic light-emitting device and at least one of the organic photodetector; preferably the common organic semiconductor layer, the common electron transport layer, the common electron injection layer, the common hole injection layer, and the common hole transport layer is shared by the organic light-emitting device and the organic photodetector.

According to an embodiment, the organic light-emitting device of the organic electronic device further comprises a hole injection layer, hole transport layer, an electron blocking layer, an electron transport layer, and an electron injection layer, wherein the organic semiconductor layer is a hole blocking layer; and wherein the electron blocking layer is in direct contact to the light-emitting layer; and

wherein the organic photodetector of the organic electronic device further comprises a hole injection layer, hole transport layer, an electron transport layer, and an electron injection layer, wherein the organic semiconductor layer is a hole blocking layer, and wherein the hole transport layer is in direct contact to the photoconversion unit; and
wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;
wherein in the organic electronic device the electron transport layer of the organic light-emitting device and the electron transport layer of the organic photodetector is a **common electron transport layer** shared by at least one of the organic light-emitting device and at least one of the organic photodetector;
wherein in the organic electronic device the electron injection layer of the organic light-emitting device and the electron injection layer of the organic photodetector is a **common electron injection layer** shared by at least one of the organic light-emitting device and at least one of the organic photodetector;
wherein in the organic electronic device the hole injection layer of the organic light-emitting device and the hole injection of the organic photodetector is a **common hole injection layer** shared by at least one of the organic light-emitting device and at least one of the organic photodetector; and
wherein in the organic electronic device the hole transport layer of the organic light-emitting device and the hole transport layer of the organic photodetector is a **common hole transport layer** shared by at least one of the organic light-emitting device and at least one of the organic photodetector; preferably the common organic semiconductor layer, the common electron transport layer, the common electron injection layer, the common hole injection layer, and the common hole transport layer is shared by the organic light-emitting device and the organic photodetector.

According to an embodiment, the organic light-emitting device of the organic electronic device further comprises a hole injection layer, hole transport layer, an electron blocking layer, an electron transport layer, and an electron injection layer, wherein the organic semiconductor layer is a hole blocking layer; and

wherein the organic photodetector of the organic electronic device further comprises a hole injection layer, hole transport layer, an electron transport layer, and an electron injection layer, wherein the organic semiconductor layer is a hole blocking layer; and
wherein in the organic electronic device the organic semiconductor layer of the organic light-emitting device, and the

organic semiconductor layer of the organic photodetector is a **common organic semiconductor layer** shared by at least one of the organic light-emitting device and at least one of the organic photodetector;
wherein in the organic electronic device the electron transport layer of the organic light-emitting device and the electron transport layer of the organic photodetector is a **common electron transport layer** shared by at least one of the organic light-emitting device and at least one of the organic photodetector;
wherein in the organic electronic device the electron injection layer of the organic light-emitting device and the electron injection layer of the organic photodetector is a **common electron injection layer** shared by at least one of the organic light-emitting device and at least one of the organic photodetector;
wherein in the organic electronic device the hole injection layer of the organic light-emitting device and the hole injection of the organic photodetector is a **common hole injection layer** shared by at least one of the organic light-emitting device and at least one of the organic photodetector; and
wherein in the organic electronic device the hole transport layer of the organic light-emitting device and the hole transport layer of the organic photodetector is a **common hole transport layer** shared by at least one of the organic light-emitting device and at least one of the organic photodetector; preferably the common organic semiconductor layer, the common electron transport layer, the common electron injection layer, the common hole injection layer, and the common hole transport layer is shared by the organic light-emitting device and the organic photodetector.

According to an embodiment, the organic light-emitting device of the organic electronic device further comprises a hole injection layer, hole transport layer, an electron blocking layer, an electron transport layer, and an electron injection layer, wherein the organic semiconductor layer is a hole blocking layer; and

wherein the organic photodetector of the organic electronic device further comprises a hole injection layer, hole transport layer, an electron blocking layer, an electron transport layer, and an electron injection layer, wherein the organic semiconductor layer is a hole blocking layer; and
wherein in the organic electronic device the organic semiconductor layer of the organic light-emitting device, and the organic semiconductor layer of the organic photodetector is a **common organic semiconductor layer** shared by at least one of the organic light-emitting device and at least one of the organic photodetector;
wherein in the organic electronic device the electron transport layer of the organic light-emitting device and the electron transport layer of the organic photodetector is a **common electron transport layer** shared by at least one of the organic light-emitting device and at least one of the organic photodetector;
wherein in the organic electronic device the electron injection layer of the organic light-emitting device and the electron injection layer of the organic photodetector is a **common electron injection layer** shared by at least one of the organic light-emitting device and at least one of the organic photodetector;
wherein in the organic electronic device the hole injection layer of the organic light-emitting device and the hole injection of the organic photodetector is a **common hole injection layer** shared by at least one of the organic light-emitting device and at least one of the organic photodetector; and
wherein in the organic electronic device the hole transport layer of the organic light-emitting device and the hole transport layer of the organic photodetector is a **common hole transport layer** shared by at least one of the organic light-emitting device and at least one of the organic photodetector; preferably the common organic semiconductor layer, the common electron transport layer, the common electron injection layer, the common hole injection layer, and the common hole transport layer is shared by the organic light-emitting device and the organic photodetector.

According to an embodiment, the organic photodetector of organic electronic device further comprises an electron blocking layer, wherein the electron blocking layer of the organic photodetector is arranged between semiconductor layer and the organic semiconductor layer; and wherein the organic light-emitting device comprises an electron blocking layer, wherein the electron blocking layer is arranged between the organic semiconductor layer and the light-emitting layer, wherein the electron blocking layer of the organic photodetector and the electron blocking layer of the organic light-emitting device is a common electron blocking layer shared by at least one of the organic photodetectors and at least one of the organic light-emitting devices.

According to an embodiment, the organic photodetector of organic electronic device further comprises an electron blocking layer, wherein the electron blocking layer of the organic photodetector is arranged between semiconductor layer and the organic semiconductor layer; and wherein the organic light-emitting device comprises an electron blocking layer, wherein the electron blocking layer is arranged between the organic semiconductor layer and the light-emitting layer, wherein the electron blocking layer of the organic photodetector and the electron blocking layer of the organic light-emitting device is a common electron blocking layer shared by at least one of the organic photodetectors and at least one of the organic light-emitting devices;
wherein in the organic electronic device the organic semiconductor layer of the organic light-emitting device, and the organic semiconductor layer of the organic photodetector is a **common organic semiconductor layer** shared by at least

one of the organic light-emitting device and at least one of the organic photodetector.

According to an embodiment, the organic photodetector of organic electronic device further comprises an electron blocking layer, wherein the electron blocking layer of the organic photodetector is arranged between semiconductor layer and the organic semiconductor layer; and wherein the organic light-emitting device comprises an electron blocking layer, wherein the electron blocking layer is arranged between the organic semiconductor layer and the light-emitting layer, wherein the electron blocking layer of the organic photodetector and the electron blocking layer of the organic light-emitting device is a common electron blocking layer shared by at least one of the organic photodetectors and at least one of the organic light-emitting devices;

wherein in the organic electronic device the organic semiconductor layer of the organic light-emitting device, and the organic semiconductor layer of the organic photodetector is a **common organic semiconductor layer** shared by the organic light-emitting device and the organic photodetector.

According to an aspect of the present invention, an organic electronic device is provided, comprising a compound of formula (I) whereby $Ar^1$ and $Ar^2$ are independently selected from formula (XI) described above.

According to an embodiment, wherein the organic electronic device is an electroluminescent device, an organic electroluminescent device, an organic light emitting diode (OLED), a light emitting device, a thin film transistor, a battery, a display device, an organic photovoltaic cell (OPV), organic solar cell (OSC), or an organic photodetector (OPD).

Use of the interlayer material and further uses

The present invention furthermore relates to the use of a compound having a root mean square roughness measured by atomic force microscopy of ≥7 nm and an enthalpy of fusion $\Delta H_{fus}$ measured by differential scanning calorimetry of ≥ 60 J/g for photo detection and/or in a photo detector, especially an organic photodetector.

The present invention furthermore relates to the use of a compound of formula (I) for photo detection and/or in a photo detector, especially an organic photodetector.

All specification and embodiments shown for the additional material and/or the compound of formula (I) and its individual moieties apply *mutatis mutandis.*

Another aspect of the present invention is directed to the use of a compound of of formula (XI) whereby $Ar^1$ and $Ar^2$ are independently selected from formula (X) in an organic electronic device.

According to an embodiment, wherein the organic electronic device is an electroluminescent device, an organic electroluminescent device, an organic light emitting diode (OLED), a light emitting device, a thin film transistor, a battery, a display device, an organic photovoltaic cell (OPV), organic solar cell (OSC), or an organic photodetector (OPD).

Another aspect of the present invention is directed to the use of a compound of formula (I) whereby $Ar^1$ and $Ar^2$ are independently selected from formula (XI) for light-emission.

Further layers

In accordance with the invention, the organic photodetector, the organic electronic device, the organic light-emitting device of the organic electronic device, or the organic photodetector of the organic electronic device may comprise, besides the layers already mentioned above, further layers. It is noted that layers may be, depending on the actual embodiment, present in more than one or even all sub-devices of the organic electronic device, especially both in the organic photodetector and the organic light-emitting device. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

*Anode layer*

The anode layer, also named anode electrode, may be formed by depositing or sputtering a material that is used to form the anode layer. The material used to form the anode layer may be a high work-function material, so as to facilitate hole injection. The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode layer. The anode layer may also be formed using metals, typically silver (Ag), gold (Au), or metal

alloys.

The anode layer may comprise two or more anode sub-layers.

According to one embodiment, the anode layer comprises a first anode sub-layer and a second anode sub-layer, wherein the first anode sub-layer is arranged closer to the substrate and the second anode sub-layer is arranged closer to the cathode layer.

According to one embodiment, the anode layer may comprise a first anode sub-layer comprising or consisting of Ag or Au and a second anode-sub-layer comprising or consisting of transparent conductive oxide.

According to one embodiment, the anode layer comprises a first anode sub-layer, a second anode sub-layer and a third anode sub-layer, wherein the first anode sub-layer is arranged closer to the substrate and the second anode sub-layer is arranged closer to the cathode layer, and the third anode sub-layer is arranged between the substrate and the first anode sub-layer.

According to one embodiment, the anode layer may comprise a first anode sub-layer comprising or consisting of Ag or Au, a second anode-sub-layer comprising or consisting of transparent conductive oxide and optionally a third anode sub-layer comprising or consisting of transparent conductive oxide. Preferably the first anode sub-layer may comprise or consists of Ag, the second anode-sublayer may comprise or consists of ITO or IZO and the third anode sub-layer may comprises or consists of ITO or IZO.

Preferably the first anode sub-layer may comprise or consists of Ag, the second anode-sublayer may comprise or consists of ITO and the third anode sub-layer may comprise or consist of ITO.

Preferably, the transparent conductive oxide in the second and third anode sub-layer may be selected the same.

According to one embodiment, the anode layer may comprise a first anode sub-layer comprising Ag or Au having a thickness of 100 to 150 nm, a second anode sub-layer comprising or consisting of a transparent conductive oxide having a thickness of 3 to 20 nm and a third anode sub-layer comprising or consisting of a transparent conductive oxide having a thickness of 3 to 20 nm.

It is to be understood that the third anode layer is not part of the substrate.

*Hole injection layer*

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; $\alpha$-NPD (N,N'-Bis(naphthalen-1-yl)-N,N'-bis(phenyl)-benzidine) doped with F4TCNQ. $\alpha$-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

According to one embodiment of the present invention, the organic electronic device may further comprise a hole transport layer, wherein the hole transport layer is arranged between the anode layer and the cathode layer.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to a preferred embodiment of the present invention, the hole transport layer may comprise a substantially covalent matrix compound.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

Substantially covalent matrix compound/ covalent matrix compound

According to one embodiment of the present invention, at least one of the layers of the organic electronic device may comprise a substantially covelant matrix compound or a covalent matrix compound.

The substantially covalent matrix compound, also named matrix compound, may be an organic aromatic matrix compounds, which comprises organic aromatic covalent bonded carbon atoms. The substantially covalent matrix compound may be an organic compound, consisting substantially from covalently bound C, H, O, N, S, which may optionally comprise also covalently bound B, P or Si. The substantially covalent matrix compound may be an organic aromatic covalent bonded compound, which is free of metal atoms, and the majority of its skeletal atoms may be selected from C, O, S, N and preferably from C, O and N, wherein the majority of atoms are C-atoms. Alternatively, the covalent matrix compound is free of metal atoms and majority of its skeletal atoms may be selected from C and N, preferably the covalent matrix compound is free of metal atoms and majority of its skeletal atoms may be selected from C and the minority of its skeletal atoms may be N.

According to one embodiment, the substantially covalent matrix compound may have a molecular weight Mw of $\geq$ 400 and $\leq$ 2000 g/mol, preferably a molecular weight Mw of $\geq$ 450 and $\leq$ 1500 g/mol, further preferred a molecular weight Mw of $\geq$ 500 and $\leq$ 1000 g/mol, in addition preferred a molecular weight Mw of $\geq$ 550 and $\leq$ 900 g/mol, also preferred a molecular weight Mw of $\geq$ 600 and $\leq$ 800 g/mol.

In one embodiment, the HOMO level of the substantially covalent matrix compound may be more negative than the HOMO level of N2,N2,N2',N2',N7,N7,N7',N7'-octakis(4-methoxyphenyl)-9,9'-spirobi[fluorene]-2,2',7,7'-tetraamine (CAS 207739-72-8) when determined under the same conditions.

In one embodiment of the present invention, the substantially covalent matrix compound may be free of alkoxy groups.

Preferably, the substantially covalent matrix compound comprises at least one arylamine moiety, alternatively a diarylamine moiety, alternatively a triarylamine moiety.

Preferably, the substantially covalent matrix compound is free of TPD or NPB.

Compound of formula (IIIa) or a compound of formula (IIIb)

According to another aspect of the present invention, the substantially covalent matrix compound or covalent matrix compound, also referred to as matrix compound herein, may comprises at least one arylamine compound, diarylamine compound, triarylamine compound, a compound of formula (IIIa) or a compound of formula (IIIb):

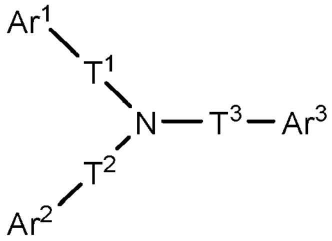

(IIIa),

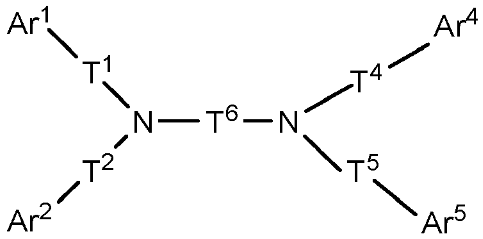

(IIIb),

wherein:

$T^1$, $T^2$, $T^3$, $T^4$ and $T^5$ are independently selected from a single bond, phenylene, biphenylene, terphenylene or naphthenylene, preferably a single bond or phenylene;

$T^6$ is phenylene, biphenylene, terphenylene or naphthenylene;

$Ar^1$, $Ar^2$, $Ar^3$, $Ar^4$ and $Ar^5$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of $Ar^1$, $Ar^2$, $Ar^3$, $Ar^4$ and $Ar^5$ are selected the same or different from the group comprising H, D, F, C(-O)$R^2$, CN, $Si(R^2)_3$, $P(-O)(R^2)_2$, $OR^2$, $S(-O)R^2$, $S(-O)_2R^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic Atoms, and substituted or unsubstituted heteroaromatic ring systems having 5 to 40 aromatic Atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,

wherein $R^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

Preferably, the substituents of $Ar^1$, $Ar^2$, $Ar^3$, $Ar^4$ and $Ar^5$ are selected the same or different from the group comprising H, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl, $C_3$ to $C_{18}$ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl.

Thereby, the compound of formula (IIIa) or (IIIb) may have a rate onset temperature suitable for mass production.

According to an embodiment the substantially covalent matrix compound comprises a compound of formula (IIIa) or formula (IIIb):

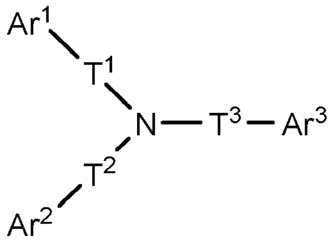
(IIIa),
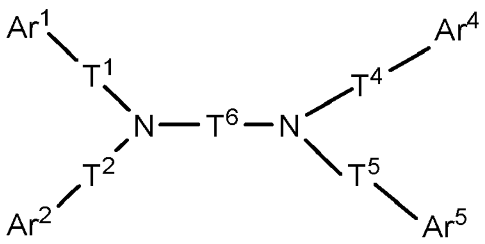
(IIIb),

wherein

$T^1$, $T^2$, $T^3$, $T^4$ and $T^5$ may be independently selected from a single bond, phenylene, biphenylene, terphenylene or naphthenylene, preferably a single bond or phenylene;

$T^6$ is phenylene, biphenylene, terphenylene or naphthenylene;

$Ar^1$, $Ar^2$, $Ar^3$, $Ar^4$ and $Ar^5$ may be independently selected from unsubstituted $C_6$ to $C_{20}$ aryl, or unsubstituted $C_3$ to $C_{20}$ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene], or a unsubstituted aromatic fused ring system comprising at least three unsubstituted aromatic rings selected from the group comprising unsubstituted non-hetero, unsubstituted hetero 5-member rings, unsubstituted 6-member rings and/or unsubstituted 7-member rings, unsubstituted fluorene, or a fused ring system comprising 2 to 6 unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle.

According to an embodiment, the substantially covalent matrix compound comprises a compound of formula (IIIa) or formula (IIIb):

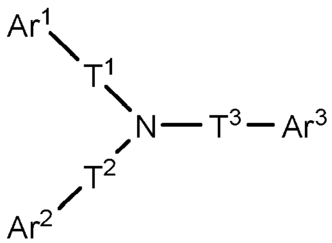
(IIIa),
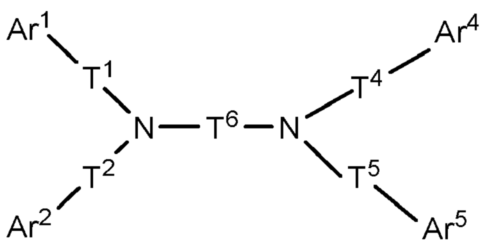
(IIIb),

wherein

$T^1$, $T^2$, $T^3$, $T^4$ and $T^5$ may be independently selected from a single bond, phenylene, biphenylene, terphenylene or naphthenylene, preferably a single bond or phenylene;

$T^6$ is phenylene, biphenylene, terphenylene or naphthenylene;

$Ar^1$, $Ar^2$, $Ar^3$, $Ar^4$ and $Ar^5$ may be independently selected from unsubstituted $C_6$ to $C_{20}$ aryl, or unsubstituted $C_3$ to $C_{20}$ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene].

Thereby, the compound of formula (IIIa) or (IIIb) may have a rate onset temperature suitable for mass production.

According to an embodiment wherein $T^1$, $T^2$, $T^3$, $T^4$ and $T^5$ may be independently selected from a single bond,

phenylene, biphenylene or terphenylene.

According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond.

According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond.

According to an embodiment wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond.

According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene.

According to an embodiment wherein $T^6$ may be biphenylene. According to an embodiment wherein $T^6$ may be terphenylene.

According to an embodiment wherein $Ar^1$, $Ar^2$, $Ar^3$, $Ar^4$ and $Ar^5$ may be independently selected from formulae (G1) to (G16):

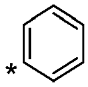 (G1), 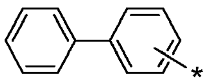 (G2), 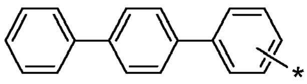 (G3), 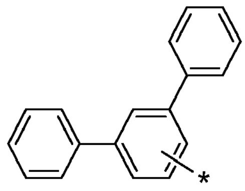 (G4),

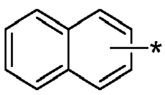 (G5), 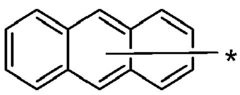 (G6), 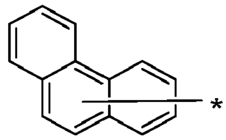 (G7), 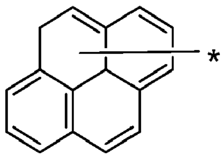 (G8),

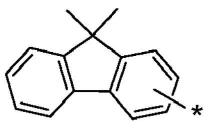 (G9), 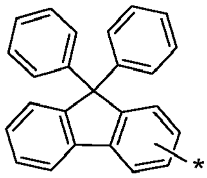 (G10), 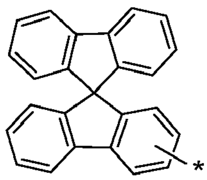 (G11),

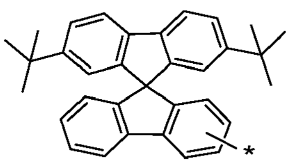 (G12), 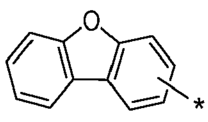 (G13), 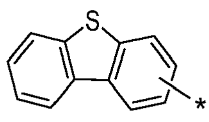 (G14),

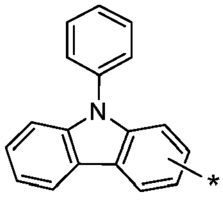 (G15), 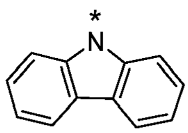 (G16),

wherein the asterix "*" denotes the binding position.

According to an embodiment, $Ar^1$, $Ar^2$, $Ar^3$, $Ar^4$ and $Ar^5$ may be independently selected from (G1) to (G15); alternatively selected from (G1) to (G10) and (G13) to (G15).

According to an embodiment, $Ar^1$, $Ar^2$, $Ar^3$, $Ar^4$ and $Ar^5$ may be independently selected from the group consisting of (G1), (G2), (G5), (G7), (G9), (G10), (G13) to (G16).

The rate onset temperature may be in a range particularly suited to mass production, when $Ar^1$, $Ar^2$, $Ar^3$, $Ar^4$ and $Ar^5$ are selected in this range.

The "matrix compound of formula (IIIa) or formula (IIIb) " may be also referred to as "hole transport compound".

According to one embodiment the compound of formula (IIIa) or formula (IIIb) may comprises at least ≥ 1 to ≤ 6 substituted or unsubstituted aromatic fused ring systems comprising heteroaromatic rings.

According to one embodiment the compound of formula (IIIa) or formula (IIIb) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings.

According to one embodiment the compound of formula (IIIa) or formula (IIIb) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred 3 or 4 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the compound of formula (IIIa) or formula (IIIb) may comprise:

- a substituted or unsubstituted aromatic fused ring systems with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5-to 7- member ring of a heterocycle; or
- an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic and at least one substituted or unsubstituted unsaturated 5- to 7- member ring. It should be noted here that the substituted or unsubstituted unsaturated 5- to 7- member ring may not be an aromatic ring.

According to one embodiment, the substantially covalent matrix compound comprises at least one naphthyl group, carbazole group, dibenzofurane group, dibenzothiophene group and/or substituted fluorenyl group, wherein the substituents are independently selected from methyl, phenyl or fluorenyl.

According to an embodiment of the present invention, the compound of formula (IIIa) or formula (IIIb) are selected from formulae (F1) to (F23):

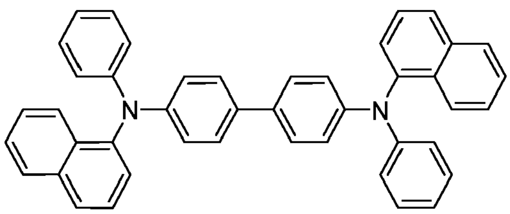
(F1),
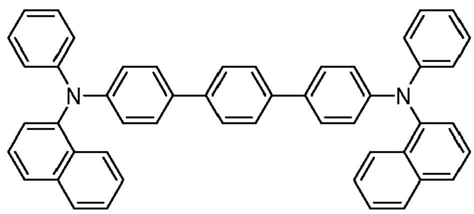
(F2),

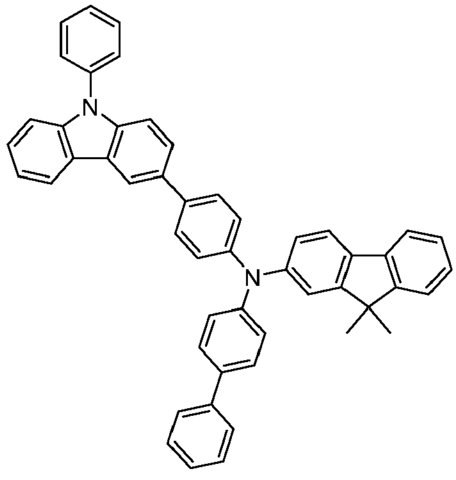 (F3), 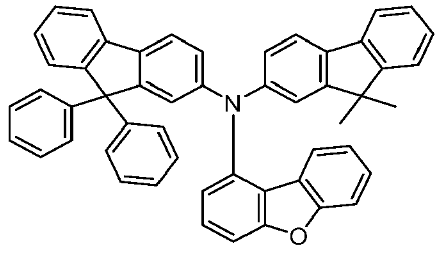 (F4),

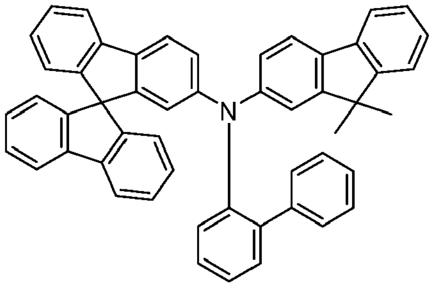 (F5), 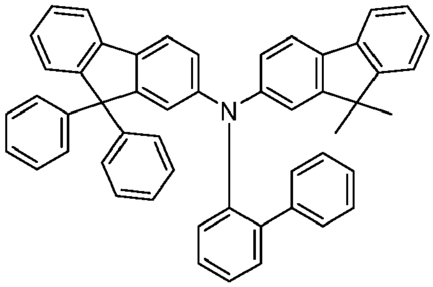 (F6),

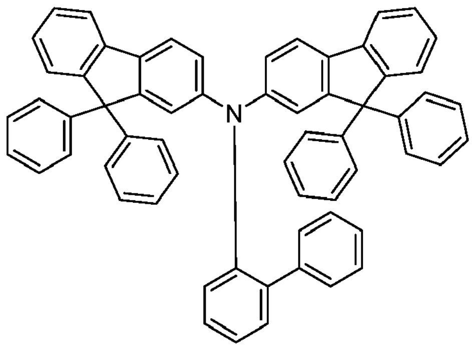 (F7), 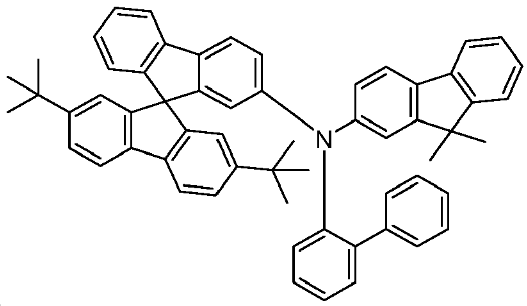 (F8),

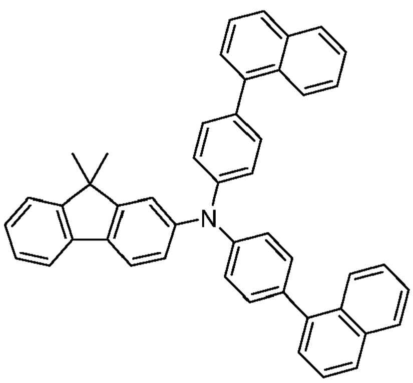 (F9), 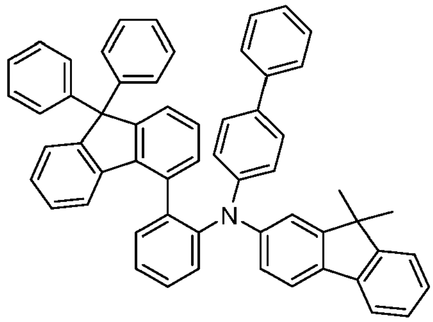 (F10),

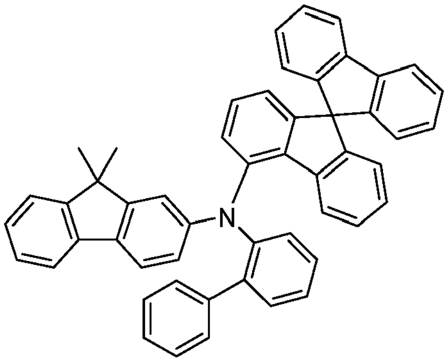

(F11),

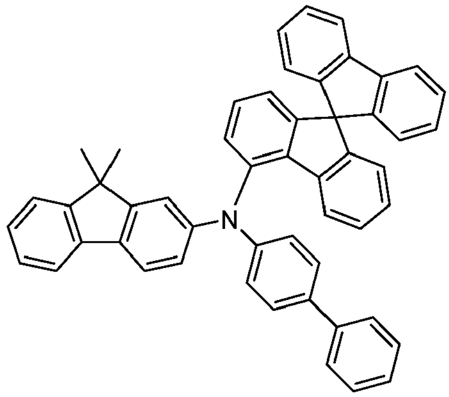

(F12),

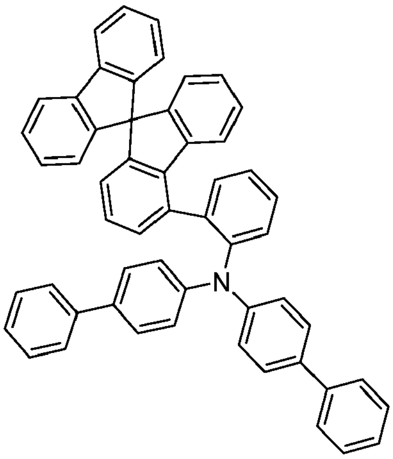

(F13),

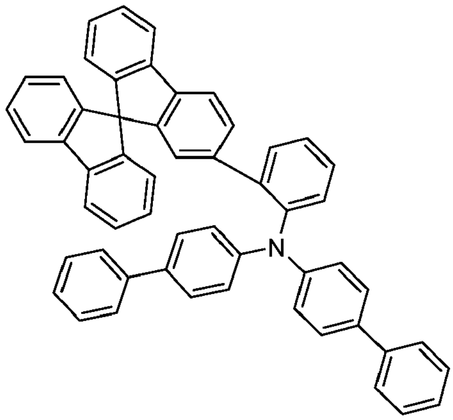

(F14),

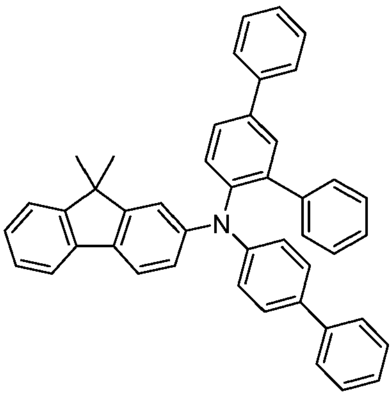

(F15),

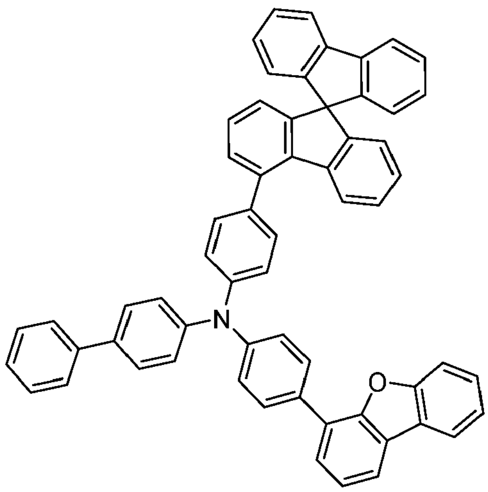

(F16),

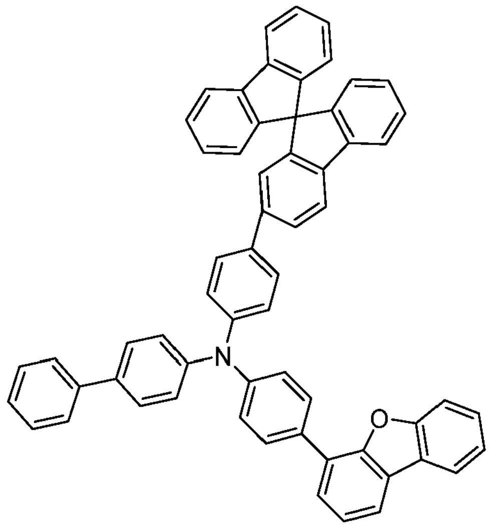
(F17)

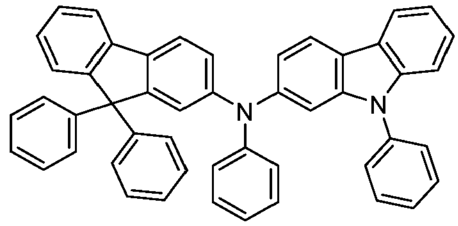
(F18)

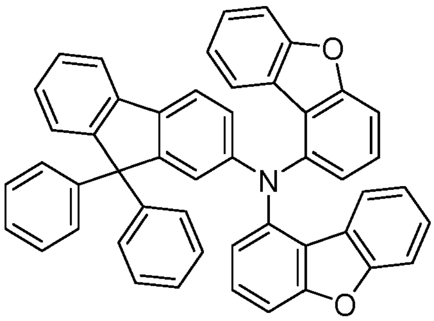
(F19),

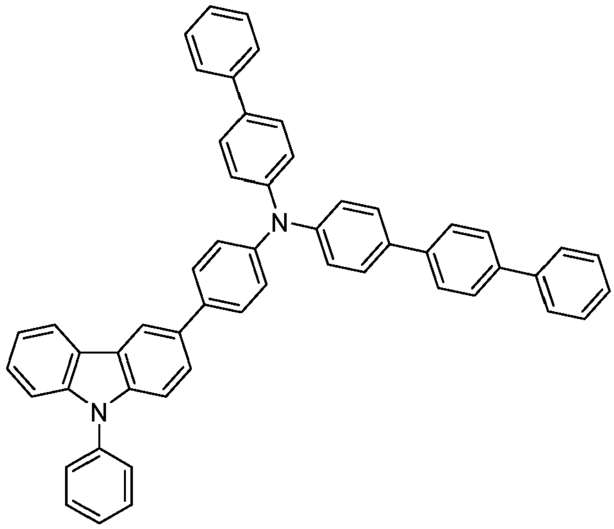
(F20),

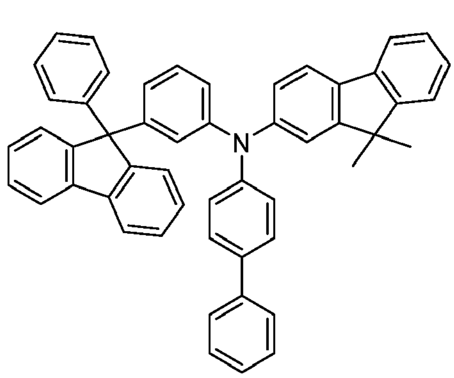
(F21),

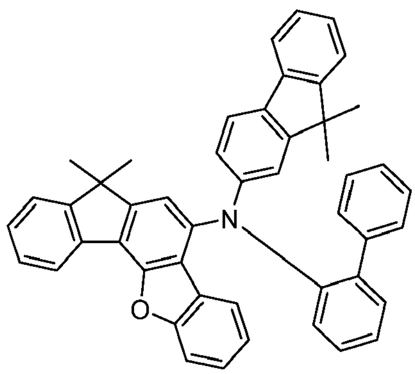
(F22),

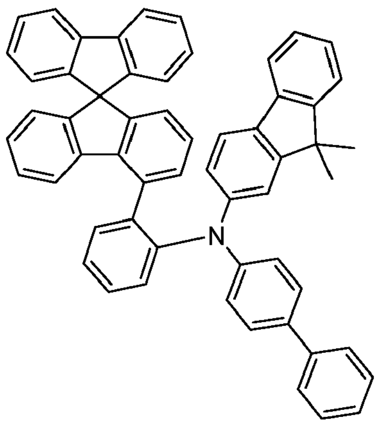

(F23);

preferably the compound of formula (IIIa) or formula (IIIb) is selected from formulae (F3) to (F23), more preferred from (F4) to (F23), most preferred from (F18).

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime may be improved.

The electron blocking layer comprises an electron blocking compound.

Typically, the electron blocking layer comprises a triarylamine compound such as N,N-di([1,1'-biphenyl]-4-yl)-7,7-dimethyl-7H-fluoreno[4,3-b]benzofuran-10-amine ([1616706-52-5]), ]), N,N-di([1,1'-biphenyl]-4-yl)-4'-(9H-carbazol-9-yl)-[1,1'-biphenyl]-4-amine ([1069137-74-1]), N,N-di([1,1'-biphenyl]-4-yl)-9-phenyl-9H-carbazol-2-amine ([1259388-72-1]), $N^1$-([1,1'-biphenyl]-4-yl)-$N^3$-(dibenzo[b,d]thiophen-2-yl)-$N^1$,$N^3$-diphenyl-5-(9-phenyl-9H-carbazol-2-yl)benzene-1,3-diamine ([1869085-48-2]), $N^1$-([1,1'-biphenyl]-4-yl)-$N^3$,$N^3$-diphenyl-$N^1$-(8-(9-phenyl-9H-carbazol-2-yl)dibenzo[b,d]thiophen-2-yl)benzene-1,3-diamine ([2055861-88-4]), $N^7$-(dibenzo[b,d]thiophen-3-yl)-$N^2$,$N^2$,$N^7$-triphenyldibenzo[b,d]thiophene-2,7-diamine ([2033134-06-2]), 7-(4-(dibenzo[b,d]thiophen-3-yl(phenyl)amino)phenyl)-N,N-diphenyldibenzo[b,d]thiophen-2-amine ([2641671-54-5]), N-([1,1'-biphenyl]-4-yl)-9,9-dimethyl-N-(3-(9-phenyl-9H-fluoren-9-yl)phenyl)-9H-fluoren-2-amine (2226747-62-0), N-([1,1'-biphenyl]-2-yl)-N-(9,9-dimethyl-9H-fluoren-2-yl)-9,9'-spirobi[fluoren]-4-amine ([1450933-44-4]), N-([1,1'-biphenyl]-4-yl)-N-(2-(9,9-diphenyl-9H-fluoren-4-yl)phenyl)-9,9-dimethyl-9H-fluoren-2-amine ([1792219-00-1]), 2',7'-di-tert-butyl-N,N-bis(9,9-dimethyl-9H-fluoren-2-yl)-9,9'-spirobi[fluoren]-4-amine ([2379778-94-4]),

N,N-di([1,1'-biphenyl]-4-yl)-3'-(9H-carbazol-9-yl)-[1,1'-biphenyl]-4-amine ([1464822-27-2]),
N,N-bis(4-(dibenzo[b,d]furan-4-yl)phenyl)-[1,1':4',1"-terphenyl]-4-amine ([N,N-bis(4-(dibenzo[b,d]furan-4-yl)phenyl)-[1,1':4',1"-terphenyl]-4-amine]) ([1198399-61-9]),
N-(4-(naphthalen-1-yl)phenyl)-N-(3-(6-phenyldibenzo[b,d]furan-4-yl)phenyl)naphthalen-1-amine ([1868149-26-1]),
N,9,9-triphenyl-N-(4'-(triphenylsilyl)-[1,1'-biphenyl]-4-yl)-9H-fluoren-2-amine ([2209040-18-4]),
N-([1,1'-biphenyl]-4-yl)-N-(4-(phenanthren-9-yl)phenyl)-[1,1':4',1"-terphenyl]-4-amine ([2233544-05-1]),
N-([1,1'-biphenyl]-4-yl)-9,9-diphenyl-N-(4-(triphenylsilyl)phenyl)-9H-fluoren-2-amine ([1613079-70-1]),
N-([1,1'-biphenyl]-4-yl)-3'-(9H-carbazol-9-yl)-N-(4-(dibenzo[b,d]furan-4-yl)phenyl)-[1,1'-biphenyl]-4-amine ([2245098-00-2]),
N,N-di([1,1'-biphenyl]-4-yl)-9,9'-spirobi[fluoren]-2-amine ([1364602-86-7]), N,N-di([1,1'-biphenyl]-4-yl)-3'-(dibenzo[b,d]furan-4-yl)-[1,1'-biphenyl]-4-amine ([N,N-di([1,1'-biphenyl]-4-yl)-3'-(dibenzo[b,d]furan-4-yl)-[1,1'-biphenyl]-4-amine]),
N-([1,1'-biphenyl]-4-yl)-N-(4-(9-phenyl-9H-carbazol-3-yl)phenyl)-[1,1':4',1"-terphenyl]-4-amine ([1569603-30-0]),
N-(3'-(9H-carbazol-9-yl)-[1,1'-biphenyl]-4-yl)-N-([1,1'-biphenyl]-4-yl)-[1,1':4',1"-terphenyl]-4-amine ([1887177-93-6]),
N3,N3'-di([1,1'-biphenyl]-4-yl)-N3,N3'-dimesityl-[1,1'-biphenyl]-3,3'-diamine ([1887177-93-6]).

The electron blocking compound in particular a triarylamine compound may have a LUMO level closer to vacuum level than the LUMO level of the hole transport layer. The electron blocking compound may have a HOMO level that is further away from vacuum level compared to the HOMO level of the hole transport layer.

The electron blocking compound in particular a triarylamine compound may have a LUMO level closer to vacuum

level than the LUMO level of the electron donor compound in the emission layer.

The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

In case the organic electronic device comprises at least one organic photodetector and at least one organic light-emittting device, it is one embodiment of the present invention that at least one electron blocking layer is shared by at least one organic photodetector and by at least one organic light-emitting diode

*Photoconversion unit*

The photoconversion unit converts photons into an electrical current.

The photoconversion unit may be formed by vacuum deposition, spin coating, slot-die coat-ing, printing, casting, LB deposition, or the like. When the photoconversion unit is formed using vacuum deposition or spin coating, the conditions for deposition and coating may be similar to those for the formation of the HIL. However, the conditions for deposition and coating may vary, according to the compound that is used to form the PAL.

*Emission layer (EML)*

The emission layer (EML) converts an electrical current into photons.

According to an embodiment, the emission layer is arranged between the anode layer and the cathode layer, preferably the emission layer is arranged between the organic semiconductor layer and the cathode layer.

The EML may be formed by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The emission layer (EML) may comprise an organic emitter host and a light-emitting compound dopant. Examples of the organic emitter host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

According to a preferred embodiment of the present invention, the emission layer comprises a light-emitting compound of formula (IV):

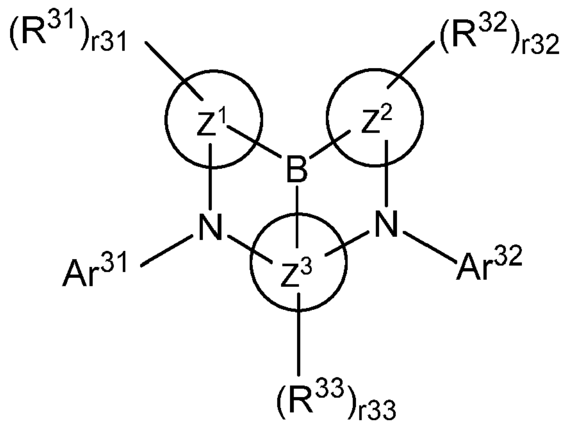

(IV),

wherein

$Z^1$, $Z^2$ and $Z^3$ are the same as or different from each other, and are each independently selected from the group comprising a monocyclic to polycyclic aromatic hydrocarbon ring or monocyclic to polycyclic aromatic hetero ring;
$Ar^{31}$ and $Ar^{32}$ are the same as or selected different from each other, and are each independently a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;
$R^{31}$, $R^{32}$ and $R^{33}$ are the same as or different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,
wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;
$r^{31}$, $r^{32}$ and $r^{33}$ are each an integer from 0, 1, 2, 3 or 4, and when $r^{31}$ to $r^{33}$ are 2 or higher, substituents in the parenthesis are the same as or different from each other.

According to one embodiment, for formula (III):

| | |
|---|---|
| $Z^1$, $Z^2$ and $Z^3$ | are the same as or selected different from each other, and are each independently selected from the group comprising a monocyclic to bicyclic aromatic hydrocarbon ring, or a monocyclic to bicyclic aromatic hetero ring containing O, N or S; |
| $Ar^{31}$ and $Ar^{32}$ | are the same as or selected different from, and are each independently selected from the group comprising an alkyl group having 1 to 10 carbon atoms, which is unsubstituted or substituted with an aryl group, an aryl group having 6 to 30 carbon atoms, which is unsubstituted or substituted with an aryl group, or a heteroaryl group having 2 to 30 carbon atoms; |
| $R^{31}$, $R^{32}$ and $R^{33}$ | are the same as or selected different from each other, and are each independently selected from the group comprising hydrogen, deuterium, a substituted or unsubstituted alkyl group, a substituted or unsubstituted cycloalkyl group, a substituted or unsubstituted silyl group, a substituted or unsubstituted aryl group, |

or a substituted or unsubstituted heteroaryl group.
According to one embodiment, wherein for formula (III):

| | |
|---|---|
| $Z^1$, $Z^2$ and $Z^3$ | are the same as or selected different from each other, and are each independently selected from the group comprising a benzene ring or a thiophene ring; |
| $Ar^{31}$ and $Ar^{32}$ | are the same as or selected different from each other, and are each independently selected from |

the group comprising phenyl group, a biphenyl group, a naphthyl group, a dimethyl fluorenyl group, a diphenyl fluorenyl group, a dibenzofuran group, or a dibenzothiophene group;

$R^{31}$, $R^{32}$ and $R^{33}$ are the same as or selected different from each other, and are each independently selected from the group comprising hydrogen, deuterium, a substituted or unsubstituted alkyl group having 1 to 10 carbon atoms, a substituted or unsubstituted cycloalkyl group having 5 to 30 carbon atoms, a substituted or unsubstituted silyl group having 1 to 10 carbon atoms, a substituted or unsubstituted aryl group having 6 to 30 carbon atoms, or a substituted or unsubstituted heteroaryl group having 2 to 30 carbon atoms.

According to a preferred embodiment of the present invention, the emission layer comprises a light-emitting compound of formula (IV) is selected from formulae (BD1) to (BD9):

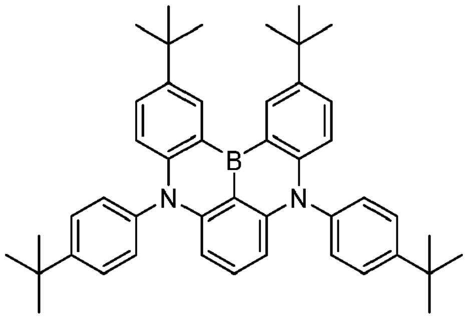
(BD1),

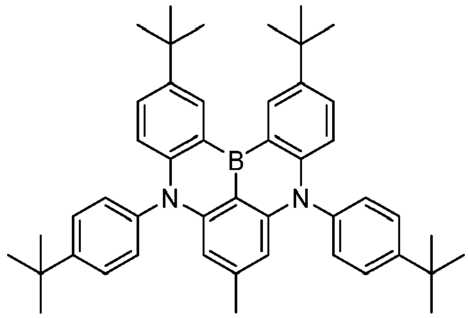
(BD2),

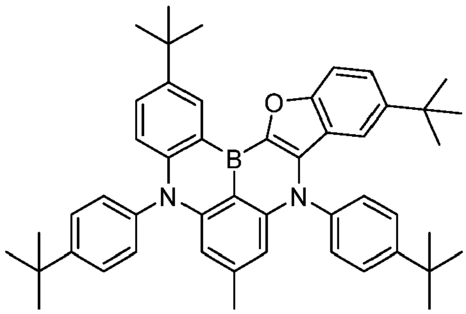
(BD3),

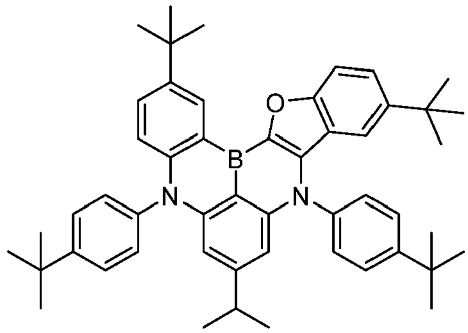
(BD4),

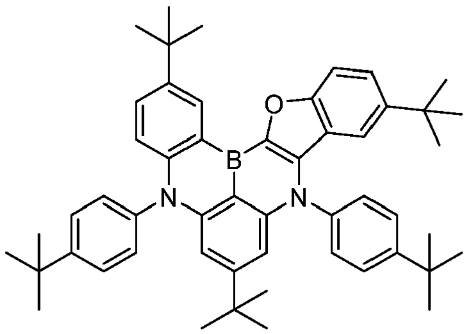
(BD5),

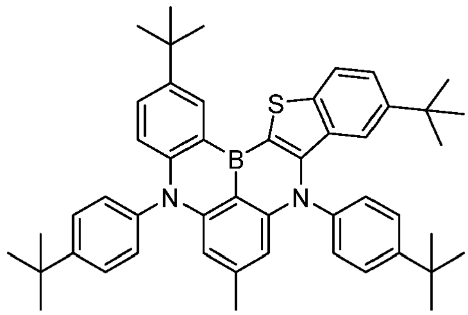
(BD6),

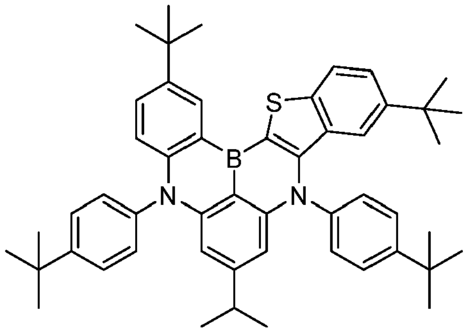 (BD7), 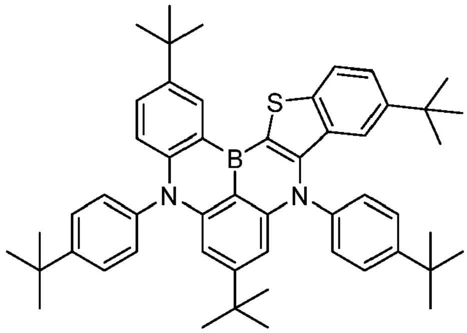 (BD8),

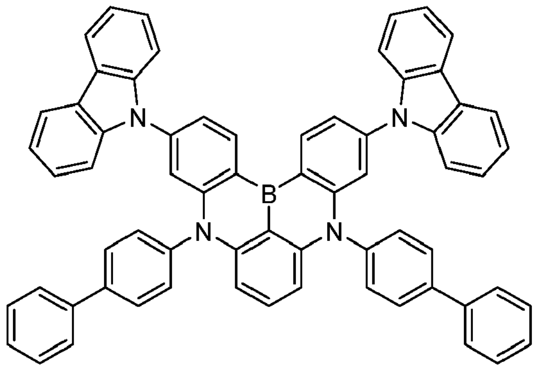 (BD9).

According to a preferred embodiment of the present invention, the emission layer comprises an organic emitter host compound, wherein the organic emitter host compound comprises

- at least one condensed aromatic ring system consisting of 3 to 5 rings, and
- 3 to 7 aromatic or heteroaromatic rings, wherein one or more sub-groups of the aromatic and/or heteroaromatic rings may be condensed to form fused aromatic or heteroaromatic ring systems;

wherein the molecular weight Mw of the organic emitter host compound is in the range of $\geq 400$ and $\leq 2000$ g/mol.

According to a preferred embodiment of the present invention, the organic emitter host compound has the formula (V)

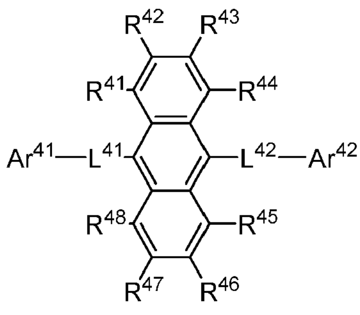 (V), wherein

$Ar^{41}$ and $Ar^{42}$ are independently selected from substituted or unsubstituted $C_6$ to $C_{24}$ aryl, substituted or unsubstituted $C_3$ to $C_{24}$ heteroaryl;

$L^{41}$ and $L^{42}$ are independently selected from a direct bond or substituted or unsubstituted $C_6$ to $C_{24}$ arylene, substituted or unsubstituted $C_3$ to $C_{24}$ heteroarylene;

$R^{41}$ to $R^{48}$ are independently selected from H, D, substituted or unsubstituted $C_1$ to $C_{12}$ alkyl, substituted or unsubstituted $C_6$ to $C_{19}$ aryl, substituted or unsubstituted $C_3$ to $C_{12}$ heteroaryl;

wherein

the substituents on $Ar^{41}$, $Ar^{42}$, $L^{41}$, $L^{42}$, $R^{41}$ to $R^{48}$ are independently selected from D, $C_6$ to $C_{10}$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or

perdeuterated $C_1$ to $C_6$ alkyl, partially or perdeuterated $C_1$ to $C_6$ alkoxy, halogen, F or CN.

According to a preferred embodiment of the present invention, the organic emitter host and/or compound of formula (V) is selected from formulae (BH1) to (BH13):

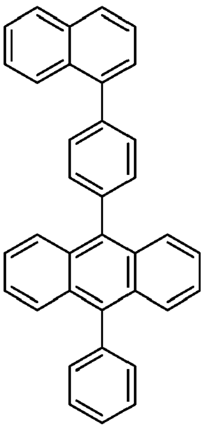
(BH1),
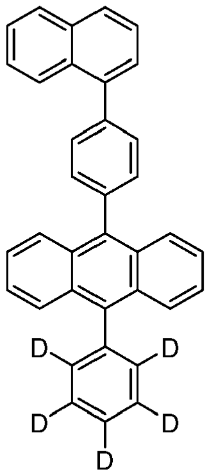
(BH2),
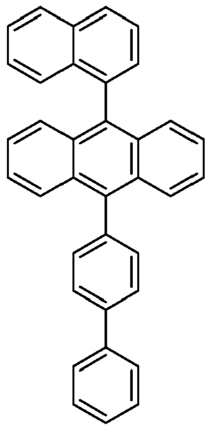
(BH3),
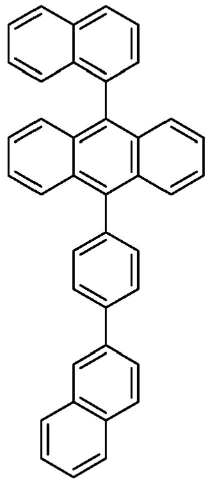
(BH4),

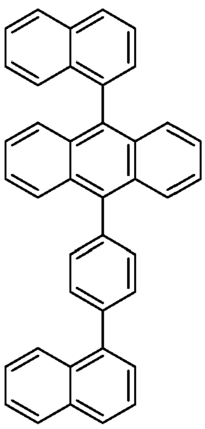
(BH5),
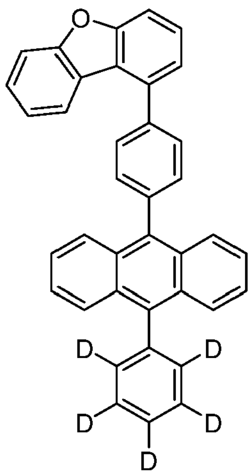
(BH6),
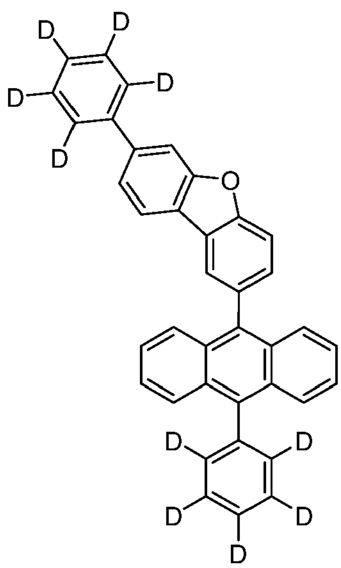
(BH7),

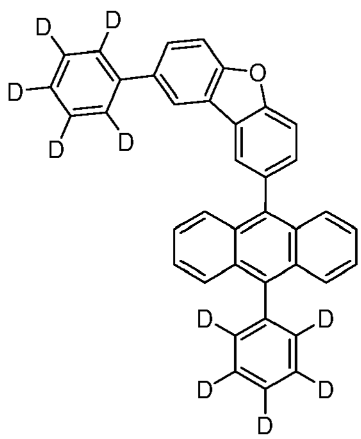
(BH8),
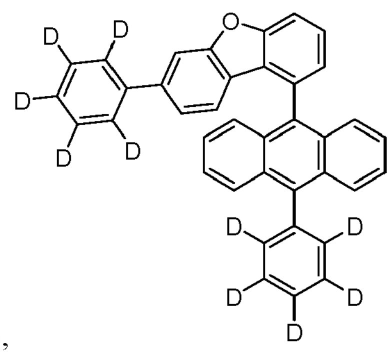
(BH9),

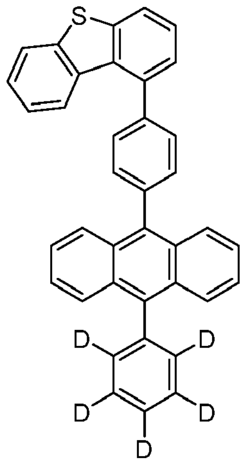
(BH10),

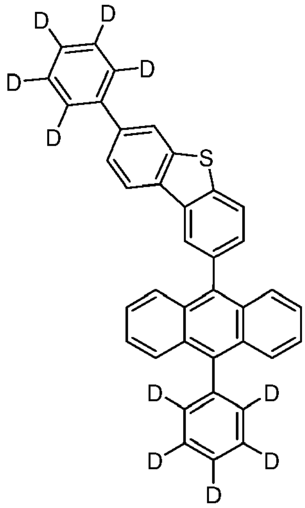
(BH11),

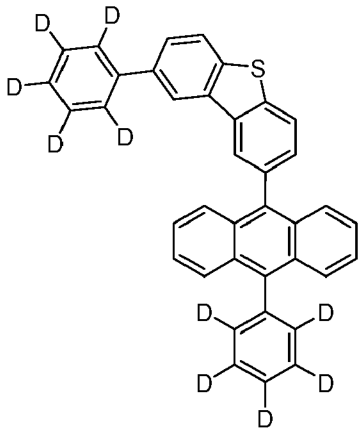
(BH12),

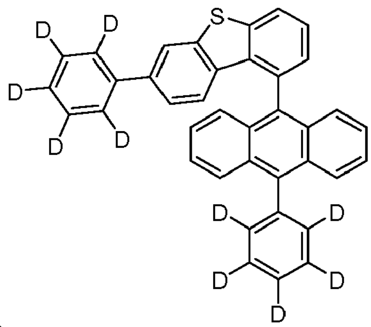
(BH13).

According to a preferred embodiment of the present invention, the light-emitting layer comprises a light-emitting dopant of formula (IV) and an organic emitter host of formula (V).

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and triazine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The organic electronic device according to the present invention may further comprise an electron transport layer (ETL), wherein the electron transport layer is arranged between the anode layer and the cathode layer, preferably between the organic semiconductor layer and the cathode layer.

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

*Electron injection layer (EIL)*

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

*Cathode layer*

The cathode layer is formed on the ETL or optional EIL. The cathode layer may be formed of a metal, an alloy, an electrically conductive compound, or a mixture thereof. The cathode layer may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode layer may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

It is to be understood that the cathode layer is not part of an electron injection layer or the electron transport layer.

Pixel definition layer

According to an embodiment of the invention, the organic electronic device may comprise a pixel definition layer by which the organic photodetector and/or the organic-light emitting device are separated from each other.

The pixel definition layer preferably is in direct contact with the substrate.

According to one embodiment, the pixel definition layer is not positive charged and/or is not an anode or comprises an anode material, preferably the pixel definition layer comprises Si based compound, SiN, a non-positive charged oligomer and/or polymer material. Preferred oligomer material include a polyacrylate-based resin or a polyimide-based resin. Also the pixel definition layer may futher include an inorganic matteri in addition to the polymer material as well as a light absorbing material, such a black pigment and/or a black dye, such as carbon black.

Use of the organic photodetector

Another aspect of the present invention is directed to the use of an organic photodetector, wherein the organic photodetector comprises an anode layer, a cathode layer, photoconversion unit comprising one or more layer, an interlayer, and an organic semiconductor layer;

wherein the photoconversion unit comprises a donor compound, and an acceptor compound,
wherein the photoconversion unit is arranged between the anode layer and the organic semiconductor layer,
wherein the organic semiconductor layer is arranged between the photoconversion unit and the cathode layer,
wherein the interlayeris arranged between the anode layer and the photoconversion unit;
wherein the interlayer is in direct contact to the photoconversion unit
wherein the interlayer comprises an interlayer compound that either

- has a root mean square roughness measured by atomic force microscopy of $\geq$7 nm and an enthalpy of fusion $\Delta H_{fus}$ measured by differential scanning calorimetry; of $\geq$ 60 J/g or

- is a compound of formula (I):

$$Ar^1\text{-}L\text{-}Ar^2 \qquad (I)$$

wherein $Ar^1$, and $Ar^2$ are independently selected from formula (II)

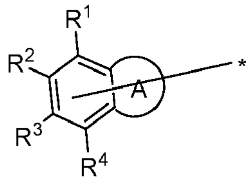

(II),

wherein the asterisk "*" denotes the binding position to L;
wherein L can be bound to A or one of $R^1$ to $R^4$;
wherein

A is a substituted or unsubstituted 5-membered carbocycle or a substituted or unsubstituted 5-membered heterocycle; wherein optionally one or more additional rings can be fused to A to form a ring system;
L is independently selected from a bond, a substituted or unsubstituted $C_6$ to $C_{30}$ aryl, a substituted or unsubstituted $C_2$ to $C_{24}$ heteroaryl,
wherein one or more substituents on L are independently selected from D, halogen, F, nitro, CN, a substituted or unsubstituted branched or unbranched $C_1$ to $C_{20}$ alkyl, a substituted or unsubstituted $C_6$ to $C_{12}$ aryl, a substituted or unsubstituted $C_3$ to $C_{12}$ heteroaryl, a substituted or unsubstituted $C_3$ to $C_{12}$ carbocyclyl, a substituted or unsubstituted $C_2$ to $C_{12}$ heterocyclyl,
wherein the one or more substituents of the one or more substituents on $L^1$ or $L^2$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^1$ to $R^4$ are independently selected from H, D, a substituted or unsubstituted branched or unbranched $C_1$ to $C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen, F, nitro, or CN,
wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN; with the proviso that when L is bound to one of $R^1$ to $R^4$, then said one of $R^1$ to $R^4$ to which L is bound to is a bond.

All specification and embodiments shown for the organic photodetector apply *mutatis mutandis.*
Hereinafter, the embodiments are illustrated in more detail with reference to examples. However, the present disclosure is not limited to the following examples. Reference will now be made in detail to the exemplary aspects.

**Description of the Drawings**

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.
Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

<u>Figures 1 to 24</u>

Fig. 1 is schematic view of an organic photodetector according an exemplary embodiment of the present invention.
Fig. 2 is schematic view of an organic photodetector according an exemplary embodiment of the present invention.
Fig. 3 is schematic view of an organic photodetector according an exemplary embodiment of the present invention.
Fig. 4 is schematic view of an organic photodetector according an exemplary embodiment of the present invention.
Fig. 5 is schematic view of an organic photodetector according an exemplary embodiment of the present invention.
Fig. 6 is schematic view of an organic photodetector according an exemplary embodiment of the present invention.
Fig. 7 a schematic (cross section) representation of a layer structure
Fig. 8 a schematic (cross section) representation of a layer structure
Fig. 9 is schematic view of an organic electronic device in particular a display device according to an exemplary embodiment of the present invention.
Fig. 10 is schematic view of an organic electronic device in particular a display device according to an exemplary embodiment of the present invention.
Fig. 11 is schematic view of an organic electronic device in particular a display device according to an exemplary embodiment of the present invention.
Fig. 12 is schematic view of an organic electronic device in particular a display device according to an exemplary embodiment of the present invention.
Fig. 13 is schematic view of an organic electronic device in particular a display device according to an exemplary embodiment of the present invention.
Fig. 14 is schematic view of an organic electronic device in particular a display device according to an exemplary embodiment of the present invention.
Fig. 15 is schematic view of an organic electronic device in particular a display device according to an exemplary embodiment of the present invention.
Fig. 16 is schematic view of an organic electronic device in particular a display device according to an exemplary embodiment of the present invention.
Fig. 17 is schematic view of an organic electronic device in particular a display device according to an exemplary embodiment of the present invention.
Fig. 18 is schematic view of an organic electronic device in particular a display device according to an exemplary embodiment of the present invention.
Fig. 19 is schematic view of an organic electronic device in particular a display device according to an exemplary embodiment of the present invention.
Fig. 20 is schematic view of an organic electronic device in particular a display device according to an exemplary embodiment of the present invention.
Fig. 21 is schematic view of an organic electronic device in particular a display device according to an exemplary embodiment of the present invention.
Fig. 22 is schematic view of an organic electronic device in particular a display device according to an exemplary embodiment of the present invention.
FIG. 23 is a schematic view of an organic photodetector device according to an exemplary embodiment of the present invention.
FIG. 24 is a schematic top view of an organic photodetector device according to an exemplary embodiment of the present invention.

Hereinafter, the figures 1 to 24 are illustrated in more detail with reference to examples.
However, the present disclosure is not limited to the following figures, which are of exemplary nature only.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

Hereinafter, one or more exemplary embodiments of the present invention will be described in detail with, reference to the following examples. However, these examples are not intended to limit the purpose and scope of the one or more exemplary embodiments of the present invention.

Referring to Fig. 1 the organic photodetector 100 includes a substrate 110, an anode layer 120, a interlayer 145, a photoconversion unit 150, an organic semiconductor layer 160 which can be an electron transport layer and/or hole blocking layer, and a cathode 190; wherein the photoconversion unit 150 may comprise one or more layer, wherein the photoconversion unit comprises an electron donor compound and an electron acceptor compound. The photoconversion unit 150 may comprise a layer 151, wherein the layer 151 comprises the electron donor compound and the electron acceptor compound. The interlayer 145 comprises an interlayer compound.

Referring to Fig. 2 the organic photodetector 100 includes a substrate 110, an anode layer 120, a interlayer 145, a first layer 152 of a photoconversion unit 150, a second layer 153 of a photoconversion unit 150, an organic semiconductor

layer 160 which can be an electron transport layer and/or hole blocking layer, and a cathode 190.

The first layer 152 of the photoconversion unit 150 may comprise the electron donor compound, the second layer 153 of the photoconversion unit 150 may comprise the electron acceptor compound.

The first layer 152 of the photoconversion unit 150 may comprise the electron donor compound and an electron acceptor compound, the second layer 153 of the photoconversion unit 150 may comprise the electron acceptor compound. The interlayer 145 comprises an interlayer compound.

Referring to Fig. 3 the organic photodetector 100 includes a substrate 110, an anode layer 120, a hole transport layer 132, a interlayer 145, a photoconversion unit 150, an organic semiconductor layer 160 which is an electron transport layer and/or hole blocking layer, and a cathode 190;

wherein the photoconversion unit 150 may comprise one or more layer, wherein the photoconversion unit comprises an electron donor compound and an electron acceptor compound. The photoconversion unit 150 may comprise a layer 151, wherein the layer 151 comprises the electron donor compound and the electron acceptor compound. The interlayer 145 comprises an interlayer compound.

Referring to Fig. 4 the organic photodetector 100 includes a substrate 110, an anode layer 120, a hole transport layer 132 a interlayer 145, a first layer 152 of a photoconversion unit 150, a second layer 153 of a photoconversion unit 150, an organic semiconductor layer 160 which can be an electron transport layer and/or hole blocking layer, and a cathode 190. The first layer 152 of the photoconversion unit 150 may comprise the electron donor compound, the second layer 153 of the photoconversion unit 150 may comprise the electron acceptor compound.

The first layer 152 of the photoconversion unit 150 may comprise the electron donor compound and an electron acceptor compound, the second layer 153 of the photoconversion unit 150 may comprise the electron acceptor compound.

The interlayer 145 comprises an interlayer compound.

Referring to Fig. 5 the organic photodetector 100 includes a substrate 110, an anode layer 120, a hole injection layer 131, a hole transport layer 132, an electron blocking layer 133, a interlayer 145, a photoconversion unit 150, an organic semiconductor layer 160 which can be a hole blocking layer, an electron transport layer 170, an electron injection layer 180, and a cathode 190;

wherein the photoconversion unit 150 may comprise one or more layers, wherein the photoconversion unit comprises an electron donor compound and an electron acceptor compound. The photoconversion unit 150 may comprise a layer 151, wherein the layer 151 comprises the electron donor compound and the electron acceptor compound. The interlayer 145 comprises an interlayer compound.

Referring to Fig. 6 the organic photodetector 100 includes a substrate 110, an anode layer 120, a hole injection layer 131, a hole transport layer 132, an electron blocking layer 133, a interlayer 145, a first layer 152 of a photoconversion unit 150, a second layer 153 of a photoconversion unit 150, an organic semiconductor layer 160 which is a hole blocking layer, an electron transport layer 170, an electron injection layer 180, and a cathode 190.

The first layer 151 of the photoconversion unit 150 may comprise the electron donor compound, the second layer 152 of the photoconversion unit 150 may comprise the electron acceptor compound.

The first layer 152 of the photoconversion unit 150 may comprise the electron donor compound and an electron acceptor compound, the second layer 153 of the photoconversion unit 150 may comprise the electron acceptor compound.

The interlayer 145 comprises an interlayer compound.

Fig. 7 shows a schematic (cross-section) representative view of a possible layer structure of an interlayer employed in the devices of the present invention. The interlayer has a non-flat-non-closed setup 22, i.e. there are particles 23 of the interlayer compound that are separated from each other providing an island or particle structure. The particles 23 have a height 24. The interlayer is provided on an underlying layer 21, which, depending on the actual embodiment can e.g. be the anode, an electron blocking layer. The open spaces between the particles 25 is filled with the material of the "next" layer (in the order or manufacture of the device), in most embodiments material of the photoconversion unit. However, usually the space between the particles will not or essentially not contain any material from the underlying layer 21.

Fig. 8 shows a schematic (cross-section) representative view of a possible layer structure of an interlayer employed in the devices of the present invention. Here the interlayer is formed as a non-flat layer 32, i.e. there is a first part which is formed on the underlying layer 31, which depending on the actual embodiment can e.g. be the anode, an electron blocking layer, which has essentially a classical flat shape and a second part, which is more particle-like. The open spaces between said particles are filled with the material of the "next" layer (in the order or manufacture of the device), in most embodiments the material of the photoconversion unit.

Referring to Fig. 9 the organic electronic device in particular a light-receiving and light-emitting device or a display device especially a display device includes a substrate 210, an organic photodetector 300 and an organic light-emitting device 400, which are separated by a pixel definition layer 700.

The organic photodetector includes 300 includes an anode layer 320, a interlayer 345, a photoconversion unit 350, an organic semiconductor layer 260 which is in particular an electron transport layer or hole blocking layer, and a

cathode layer 290; wherein the photoconversion unit 350 may comprise one or more layer, wherein the photoconversion unit comprises an electron donor compound and an electron acceptor compound. The photoconversion unit 350 may comprise a layer 351, wherein the layer 351 comprises the electron donor compound and the electron acceptor compound. The interlayer 345 comprises the interlayer compound.

The organic light-emitting device 400 includes an anode layer 420, a light-emitting layer 440, an organic semiconductor layer 260 which is in particular an electron transport layer or hole blocking layer, and a cathode layer 290.

The organic electronic device 200 have a common organic semiconductor layer 260 which is in particular a common electron transport layer or a common hole blocking layer, wherein the common organic semiconductor layer 260 is shared by the organic photodetector 300 and the organic light-emitting device 400.

Further, the organic electronic device 200 have a common have a common cathode layer 290, wherein the common cathode layer 290 is shared by the organic photodetector 300 and the organic light-emitting device 400.

Referring to Fig. 10 the organic electronic device in particular a light-receiving and light-emitting device or a display device especially a display device includes a substrate 210, an organic photodetector 300 and an organic light-emitting device 400, which are separated by a pixel definition layer 700.

The organic photodetector includes 300 includes an anode layer 320, a hole transport layer 232, a interlayer 345, and a photoconversion unit 350, an organic semiconductor layer 260 which is in particular an electron transport layer or hole blocking layer, and a cathode layer 290; wherein the photoconversion unit 350 may comprise one or more layer, wherein the photoconversion unit comprises an electron donor compound and an electron acceptor compound. The photoconversion unit 350 may comprise a layer 351, wherein the layer 351 comprises the electron donor compound and the electron acceptor compound. The interlayer 345 comprises the interlayer compound.

The organic light-emitting device 400 includes an anode layer 420, a hole transport layer 232, a light-emitting layer 440, an organic semiconductor layer 260 which is in particular an electron transport layer or hole blocking layer, and a cathode layer 290.

The organic electronic device 200 have a common hole transport layer 232, wherein the common hole transport layer 232 is shared by the organic photodetector 300 and the organic light-emitting device 400.

The organic electronic device 200 have a common organic semiconductor layer 260 which is in particular a common electron transport layer or a common hole blocking layer, wherein the common organic semiconductor layer 260 is shared by the organic photodetector 300 and the organic light-emitting device 400.

Further, the organic electronic device 200 have a common have a common cathode layer 290, wherein the common cathode layer 290 is shared by the organic photodetector 300 and the organic light-emitting device 400.

Referring to Fig. 11 the organic electronic device in particular a light-receiving and light-emitting device or a display device especially a display device includes a substrate 210, an organic photodetector 300 and an organic light-emitting device 400, which are separated by a pixel definition layer 700.

The organic photodetector includes 300 includes an anode layer 320, a hole injection layer 231, a hole transport layer 232, an electron blocking layer 233, a interlayer 345, and a photoconversion unit 350, an organic semiconductor layer 260 which is in particular an electron transport layer or hole blocking layer, and a cathode layer 290; wherein the photoconversion unit 350 may comprise one or more layer, wherein the photoconversion unit comprises an electron donor compound and an electron acceptor compound. The photoconversion unit 350 may comprise a layer 351, wherein the layer 351 comprises the electron donor compound and the electron acceptor compound. The interlayer 345 comprises the interlayer compound.

The organic light-emitting device 400 includes an anode layer 420, a hole injection layer 231, a hole transport layer 232,electron blocking layer 233, and a light-emitting layer 440, an organic semiconductor layer 260 which is in particular an electron transport layer or hole blocking layer, and a cathode layer 290.

The organic electronic device 200 have a common hole injection layer 231, wherein the common hole injection layer 231 is shared by the organic photodetector 300 and the organic light-emitting device 400.

The organic electronic device 200 have a common hole transport layer 232, wherein the common hole transport layer 232 is shared by the organic photodetector 300 and the organic light-emitting device 400.

The organic electronic device 200 have a common electron blocking layer 233, wherein the common electron blocking layer 233 is shared by at least one organic photodetector 300 and at least one organic light-emitting device 400.

The organic electronic device 200 have a common organic semiconductor layer 260 which is in particular a common electron transport layer or a common hole blocking layer, wherein the common organic semiconductor layer 260 is shared by the organic photodetector 300 and the organic light-emitting device 400.

Further, the organic electronic device 200 have a common have a common cathode layer 290, wherein the common cathode layer 290 is shared by the organic photodetector 300 and the organic light-emitting device 400.

Fig. 12 is schematic view of an organic electronic device in particular a light-receiving and light-emitting device or a display device especially a display device according to an exemplary embodiment of the present invention.

Referring to Fig. 12 the organic electronic device in particular a light-receiving and light-emitting device or a display device especially a display device includes a substrate 210, an organic photodetector 300 and an organic light-emitting device 400, which are separated by a pixel definition layer 700.

The organic photodetector includes 300 includes an anode layer 320, a interlayer 345, a first layer 351 of a photoconversion unit 350, and a second photoconversion layer 352 of the photoconversion unit 350, an organic semiconductor layer 260 which is in particular an electron transport layer or hole blocking layer, and a cathode layer 290.

The first layer 352 of the photoconversion unit 350 may comprise the electron donor compound, the second layer 353 of the photoconversion unit 350 may comprise the electron acceptor compound.

The first layer 352 of the photoconversion unit 350 may comprise the electron donor compound and an electron acceptor compound, the second layer 353 of the photoconversion unit 350 may comprise the electron acceptor compound.

The interlayer 345 comprises an interlayer compound.

The organic light-emitting device 400 includes an anode layer 420, a light-emitting layer 440, an organic semiconductor layer 260 which is in particular an electron transport layer or hole blocking layer, and a cathode layer 290.

The organic electronic device 200 have a common organic semiconductor layer 260 which is in particular a common electron transport layer or a common hole blocking layer, wherein the common organic semiconductor layer 260 is shared by the organic photodetector 300 and the organic light-emitting device 400.

Further, the organic electronic device 200 have a common have a common cathode layer 290, wherein the common cathode layer 290 is shared by the organic photodetector 300 and the organic light-emitting device 400.

Referring to Fig. 13 the organic electronic device in particular a light-receiving and light-emitting device or a display device especially a display device includes a substrate 210, an organic photodetector 300 and an organic light-emitting device 400, which are separated by a pixel definition layer 700.

The organic photodetector includes 300 includes an anode layer 320, a hole transport layer 232,a interlayer 345, a first layer 352 of a photoconversion unit 350, and a second layer 353of the photoconversion unit 350, an organic semiconductor layer 260 which is in particular an electron transport layer or hole blocking layer, and a cathode layer 290. The first layer 352 of the photoconversion unit 350 may comprise the electron donor compound, the second layer 353 of the photoconversion unit 350 may comprise the electron acceptor compound.

The first layer 352 of the photoconversion unit 350 may comprise the electron donor compound and an electron acceptor compound, the second layer 353 of the photoconversion unit 350 may comprise the electron acceptor compound.

The interlayer 345 comprises an interlayer compound.

The organic light-emitting device 400 includes an anode layer 420, a hole transport layer 232,a light-emitting layer 440, an organic semiconductor layer 260 which is in particular an electron transport layer or hole blocking layer, and a cathode layer 290.

The organic electronic device 200 have a common hole transport layer 232, wherein the common hole transport layer 232 is shared by the organic photodetector 300 and the organic light-emitting device 400.

The organic electronic device 200 have a common organic semiconductor layer 260 which is in particular a common electron transport layer or a common hole blocking layer, wherein the common organic semiconductor layer 260 is shared by the organic photodetector 300 and the organic light-emitting device 400.

Further, the organic electronic device 200 have a common have a common cathode layer 290, wherein the common cathode layer 290 is shared by the organic photodetector 300 and the organic light-emitting device 400.

Referring to Fig. 14 the organic electronic device in particular a light-receiving and light-emitting device or a display device especially a display device includes a substrate 210, an organic photodetector 300 and an organic light-emitting device 400, which are separated by a pixel definition layer 700.

The organic photodetector includes 300 includes an anode layer 320, a hole injection layer 231, a hole transport layer 232, an electron blocking layer 233, a interlayer 345, a first layer 352 of a photoconversion unit 350, and a second layer 353 of the photoconversion unit 350, an organic semiconductor layer 260 which is in particular an electron transport layer or hole blocking layer, and a cathode layer 290. The first layer 352 of the photoconversion unit 350 may comprise the electron donor compound, the second layer 353of the photoconversion unit 150 may comprise the electron acceptor compound.

The first layer 352 of the photoconversion unit 350 may comprise the electron donor compound and an electron acceptor compound, the second layer 353 of the photoconversion unit 350 may comprise the electron acceptor compound.

The interlayer 345 comprises an interlayer compound. The organic light-emitting device 400 includes an anode layer 420, a hole injection layer 231, a hole transport layer 232, electron blocking layer 233, and a light-emitting layer 440, an organic semiconductor layer 260 which is in particular an electron transport layer or hole blocking layer, and a cathode layer 290.

The organic electronic device 200 have a common hole injection layer 231, wherein the common hole injection layer 231 is shared by the organic photodetector 300 and the organic light-emitting device 400.

The organic electronic device 200 have a common hole transport layer 232, wherein the common hole transport

layer 232 is shared by the organic photodetector 300 and the organic light-emitting device 400.

The organic electronic device 200 have a common electron blocking layer 233, wherein the common electron blocking layer 233 is shared by at least one organic photodetector 300 and at least one organic light-emitting device 400.

The organic electronic device 200 have a common organic semiconductor layer 260 in particular a common electron transport layer or a common hole blocking layer, wherein the common organic semiconductor layer 260 is shared by the organic photodetector 300 and the organic light-emitting device 400.

Further, the organic electronic device 200 have a common have a common cathode layer 290, wherein the common cathode layer 290 is shared by the organic photodetector 300 and the organic light-emitting device 400.

Referring to Fig. 15 the organic electronic device in particular a light-receiving and light-emitting device or a display device especially a display device includes a substrate 210, an organic photodetector 300, an organic light-emitting device 400, an organic light-emitting device 500, and an organic light-emitting device 600, which are each separated by a pixel definition layer 700.

The organic photodetector includes 300 includes an anode layer 320, a interlayer 345, and a photoconversion unit 350, an organic semiconductor layer 260 which is in particular an electron transport layer or hole blocking layer, and a cathode layer 290; wherein the photoconversion unit 350 may comprise one or more layer, wherein the photoconversion unit comprises an electron donor compound and an electron acceptor compound. The photoconversion unit 350 may comprise a layer 351, wherein the layer 351 comprises the electron donor compound and the electron acceptor compound. The interlayer 345 comprises the interlayer compound.

The organic light-emitting device 400 includes an anode layer 420, a light-emitting layer 440, an organic semiconductor layer 260 which is in particular an electron transport layer or hole blocking layer, and a cathode layer 290; wherein the organic light-emitting device 400 emits green light.

The organic light-emitting device 500 includes an anode layer 520, a light-emitting layer 540, an organic semiconductor layer 260 which is in particular an electron transport layer or hole blocking layer, and a cathode layer 290; wherein the organic light-emitting device 500 emits blue light.

The organic light-emitting device 400 includes an anode layer 620, a light-emitting layer 640, an organic semiconductor layer 260 which is in particular an electron transport layer or hole blocking layer, and a cathode layer 290; wherein the organic light-emitting device 600 emits red-light.

The organic electronic device 200 have a common organic semiconductor layer 260 which is in particular a common electron transport layer or a common hole blocking layer, wherein the common organic semiconductor layer 260 is shared by the organic photodetector 300, the organic light-emitting device 400, the organic light-emitting device 500, and the organic light-emitting device 600.

Further, the organic electronic device 200 have a common have a common cathode layer 290, wherein the common cathode layer 290 is shared by the organic photodetector 300, the organic light-emitting device 400, the organic light-emitting device 500, and the organic light-emitting device 600.

Referring to Fig. 16 the organic electronic device in particular a light-receiving and light-emitting device or a display device especially a display device includes a substrate 210, an organic photodetector 300, an organic light-emitting device 400, an organic light-emitting device 500, and an organic light-emitting device 600, which are each separated by a pixel definition layer 700.

The organic photodetector includes 300 includes an anode layer 320, a hole transport layer 232, a interlayer 345, and a photoconversion unit 350, an organic semiconductor layer 260 which is in particular an electron transport layer or hole blocking layer, and a cathode layer 290; wherein the photoconversion unit 350 may comprise one or more layer, wherein the photoconversion unit comprises an electron donor compound and an electron acceptor compound. The photoconversion unit 350 may comprise a layer 351, wherein the layer 351 comprises the electron donor compound and the electron acceptor compound. The interlayer 345 comprises the interlayer compound.

The organic light-emitting device 400 includes an anode layer 420, a hole transport layer 232, a light-emitting layer 440, an organic semiconductor layer 260 which is in particular an electron transport layer or hole blocking layer, and a cathode layer 290; wherein the organic light-emitting device 400 emits green light.

The organic light-emitting device 500 includes an anode layer 520, a hole transport layer 232, a light-emitting layer 540, an organic semiconductor layer 260 which is in particular an electron transport layer or hole blocking layer, and a cathode layer 290; wherein the organic light-emitting device 500 emits blue light.

The organic light-emitting device 400 includes an anode layer 620, a hole transport layer 232, a light-emitting layer 640, an organic semiconductor layer 260 which is in particular an electron transport layer or hole blocking layer, and a cathode layer 290; wherein the organic light-emitting device 600 emits red-light.

The organic electronic device 200 have a common hole transport layer 232, wherein the common hole transport layer 232 is shared by the organic photodetector 300, the organic light-emitting device 400, the organic light-emitting device 500, and the organic light-emitting device 600.

The organic electronic device 200 have a common organic semiconductor layer 260 which is in particular a common electron transport layer or a common hole blocking layer, wherein the common organic semiconductor layer 260

is shared by the organic photodetector, the organic light-emitting device 400, the organic light-emitting device 500, and the organic light-emitting device 600.

Further, the organic electronic device 200 have a common have a common cathode layer 290, wherein the common cathode layer 290 is shared by the organic photodetector 300 the organic light-emitting device 400, the organic light-emitting device 500, and the organic light-emitting device 600.

Referring to Fig. 17 the organic electronic device in particular a light-receiving and light-emitting device or a display device especially a display device includes a substrate 210, an organic photodetector 300, an organic light-emitting device 400, an organic light-emitting device 500, and the organic light-emitting device 600, which are each separated by a pixel definition layer 700.

The organic photodetector includes 300 includes an anode layer 320, a hole injection layer 231, a hole transport layer 232, an electron blocking layer 333, a interlayer 345, and a photoconversion unit 350; wherein the photoconversion unit 350 may comprise one or more layer, wherein the photoconversion unit comprises an electron donor compound and an electron acceptor compound. The photoconversion unit 350 may comprise a layer 351, wherein the layer 351 comprises the electron donor compound and the electron acceptor compound. The interlayer 345 comprises the interlayer compound.

The organic light-emitting device 400 includes an anode layer 420, electron blocking layer 433, and a light-emitting layer 440 a hole injection layer 231, a hole transport layer 232,: wherein the organic light-emitting device 400 emits green light.

The organic light-emitting device 500 includes an anode layer 520, electron blocking layer 533, and a light-emitting layer 540 a hole injection layer 231, a hole transport layer 232,; wherein the organic light-emitting device 500 emits blue light.

The organic light-emitting device 600 includes an anode layer 620, electron blocking layer 633, and a light-emitting layer 640 a hole injection layer 231, a hole transport layer 232,; wherein the organic light-emitting device 600 emits red light.

The organic electronic device 200 have a common hole injection layer 231, wherein the common hole injection layer 231 is shared by the organic photodetector 300, the organic light-emitting device 400, the organic light-emitting device 500, and the organic light-emitting device 600.

The organic electronic device 200 have a common hole transport layer 232, wherein the common hole transport layer 232 is shared by the organic photodetector 300, the organic light-emitting device 400, the organic light-emitting device 500, and the organic light-emitting device 600.

The organic electronic device 200 have a common organic semiconductor layer 260 which is in particular a common electron transport layer or a common hole blocking layer, wherein the common organic semiconductor layer 260 is shared by the organic photodetector 300, the organic light-emitting device 400, the organic light-emitting device 500, and the organic light-emitting device 600.

Further, the organic electronic device 200 have a common have a common cathode layer 290, wherein the common cathode layer 290 is shared by the organic photodetector 300, the organic light-emitting device 400, the organic light-emitting device 500, and the organic light-emitting device 600.

Referring to Fig. 18 the organic electronic device in particular a light-receiving and light-emitting device or a display device especially a display device includes a substrate 210, an organic photodetector 300, an organic light-emitting device 400, an organic light-emitting device 500, and an organic light-emitting device 600, which are each separated by a pixel definition layer 700.

The organic photodetector includes 300 includes an anode layer 320, a interlayer 345, a first layer 352 of a photoconversion unit 350, and a second layer 353 of the photoconversion unit 350, an organic semiconductor layer 260 which is in particular an electron transport layer or hole blocking layer, and a cathode layer 290. The first layer 352 of the photoconversion unit 350 may comprise the electron donor compound, the second layer 353 of the photoconversion unit 150 may comprise the electron acceptor compound.

The first layer 352 of the photoconversion unit 350 may comprise the electron donor compound and an electron acceptor compound, the second layer 353 of the photoconversion unit 350 may comprise the electron acceptor compound.

The interlayer 345 comprises an interlayer compound.

The organic light-emitting device 400 includes an anode layer 420, a light-emitting layer 440, an organic semiconductor layer 260 which is in particular an electron transport layer or hole blocking layer, and a cathode layer 290; wherein the organic light-emitting device 400 emits green light.

The organic light-emitting device 500 includes an anode layer 520, a light-emitting layer 540, an organic semiconductor layer 260 which is in particular an electron transport layer or hole blocking layer, and a cathode layer 290; wherein the organic light-emitting device 500 emits blue light.

The organic light-emitting device 400 includes an anode layer 620, a light-emitting layer 640, an organic semiconductor layer 260 which is in particular an electron transport layer or hole blocking layer, and a cathode layer

290; wherein the organic light-emitting device 600 emits red-light.

The organic electronic device 200 have a common organic semiconductor layer 260 which is in particular a common electron transport layer or a common hole blocking layer, wherein the common organic semiconductor layer 260 is shared by the organic photodetector 300, the organic light-emitting device 400, the organic light-emitting device 500, and the organic light-emitting device 600.

Further, the organic electronic device 200 have a common have a common cathode layer 290, wherein the common cathode layer 290 is shared by the organic photodetector 300, the organic light-emitting device 400, the organic light-emitting device 500, and the organic light-emitting device 600.

Referring to Fig. 19 the organic electronic device in particular a light-receiving and light-emitting device or a display device especially a display device includes a substrate 210, an organic photodetector 300, an organic light-emitting device 400, an organic light-emitting device 500, and an organic light-emitting device 600, which are each separated by a pixel definition layer 700.

The organic photodetector includes 300 includes an anode layer 320, a hole transport layer 232, a interlayer, a first layer 352 of a photoconversion unit 350, and a second layer 353 of the photoconversion unit 350, an organic semiconductor layer 260 which is in particular an electron transport layer or hole blocking layer, and a cathode layer 290.

The first layer 352 of the photoconversion unit 350 may comprise the electron donor compound, the second layer 353 of the photoconversion unit 150 may comprise the electron acceptor compound.

The first layer 352 of the photoconversion unit 350 may comprise the electron donor compound and an electron acceptor compound, the second layer 353 of the photoconversion unit 350 may comprise the electron acceptor compound.

The interlayer 345 comprises an interlayer compound.

The organic light-emitting device 400 includes an anode layer 420, a hole transport layer 232, a light-emitting layer 440, an organic semiconductor layer 260 which is in particular an electron transport layer or hole blocking layer, and a cathode layer 290; wherein the organic light-emitting device 400 emits green light.

The organic light-emitting device 500 includes an anode layer 520, a hole transport layer 232, a light-emitting layer 540, an organic semiconductor layer 260 which is in particular an electron transport layer or hole blocking layer, and a cathode layer 290; wherein the organic light-emitting device 500 emits blue light.

The organic light-emitting device 400 includes an anode layer 620, a hole transport layer 232, a light-emitting layer 640, an organic semiconductor layer 260 which is in particular an electron transport layer or hole blocking layer, and a cathode layer 290; wherein the organic light-emitting device 600 emits red-light.

The organic electronic device 200 have a common hole transport layer 232, wherein the common hole transport layer 232 is shared by the organic photodetector 300, the organic light-emitting device 400, the organic light-emitting device 500, and the organic light-emitting device 600.

The organic electronic device 200 have a common organic semiconductor layer 260 which is in particular a common electron transport layer or a common hole blocking layer, wherein the common organic semiconductor layer 260 is shared by the organic photodetector the organic light-emitting device 400, the organic light-emitting device 500, and the organic light-emitting device 600.

Further, the organic electronic device 200 have a common have a common cathode layer 290, wherein the common cathode layer 290 is shared by the organic photodetector 300, the organic light-emitting device 400, the organic light-emitting device 500, and the organic light-emitting device 600.

Referring to Fig. 20 the organic electronic device in particular a light-receiving and light-emitting device or a display device especially a display device includes a substrate 210, an organic photodetector 300, an organic light-emitting device 400, an organic light-emitting device 500, and the organic light-emitting device 600, which are separated by a pixel definition layer 700.

The organic photodetector includes 300 includes an anode layer 320, a hole injection layer 231, a hole transport layer 232, an electron blocking layer 333, a interlayer 345, a first layer 352 of a photoconversion unit 350, and a second layer 353 of the photoconversion unit 350, an organic semiconductor layer 260 which is in particular an electron transport layer or hole blocking layer, and a cathode layer 290.

The first layer 352 of the photoconversion unit 350 may comprise the electron donor compound, the second layer 353 of the photoconversion unit 150 may comprise the electron acceptor compound.

The first layer 352 of the photoconversion unit 350 may comprise the electron donor compound and an electron acceptor compound, the second layer 353 of the photoconversion unit 350 may comprise the electron acceptor compound.

The interlayer 345 comprises an interlayer compound.

The organic light-emitting device 400 includes an anode layer 420, a hole injection layer 231, a hole transport layer 232, electron blocking layer 433, and a light-emitting layer 440, an organic semiconductor layer 260 which is in particular an electron transport layer or hole blocking layer, and a cathode layer 290; wherein the organic light-emitting device 400 emits green light.

The organic light-emitting device 500 includes an anode layer 520, a hole injection layer 231, a hole transport layer 232, electron blocking layer 533, and a light-emitting layer 540, an organic semiconductor layer 260 which is in particular an electron transport layer or hole blocking layer, and a cathode layer 290; wherein the organic light-emitting device 500 emits blue light.

The organic light-emitting device 600 includes an anode layer 620, a hole injection layer 231, a hole transport layer 232, electron blocking layer 633, and a light-emitting layer 640, an organic semiconductor layer 260 which is in particular an electron transport layer or hole blocking layer, and a cathode layer 290; wherein the organic light-emitting device 600 emits red light.

The organic electronic device 200 have a common hole injection layer 231, wherein the common hole injection layer 231 is shared by the organic photodetector 300, the organic light-emitting device 400, the organic light-emitting device 500, and the organic light-emitting device 600.

The organic electronic device 200 have a common hole transport layer 232, wherein the common hole transport layer 232 is shared by the organic photodetector 300, the organic light-emitting device 400, the organic light-emitting device 500, and the organic light-emitting device 600.

The electron blocking layer 333 of the organic photodetector 300, and the electron blocking layer 433 of the organic light-emitting device 400 is a common electron blocking layer shared by the organic photodetector 300 and the organic light-emitting device 400.

The organic electronic device 200 have a common organic semiconductor layer 260 which is in particular a common electron transport layer or a common hole blocking layer, wherein the common organic semiconductor layer 260 is shared by the organic photodetector 300, the organic light-emitting device 400, the organic light-emitting device 500, and the organic light-emitting device 600.

Further, the organic electronic device 200 have a common have a common cathode layer 290, wherein the common cathode layer 290 is shared by the organic photodetector 300, , the organic light-emitting device 400, the organic light-emitting device 500, and the organic light-emitting device 600.

Referring to Fig. 21 the organic electronic device in particular a light-receiving and light-emitting device or a display device especially a display device includes a substrate 210, an organic photodetector 300, an organic light-emitting device 400, an organic light-emitting device 500, and the organic light-emitting device 600, which are each separated by a pixel definition layer 700.

The organic photodetector includes 300 includes an anode layer 320, a hole injection layer 231, a hole transport layer 232, an interlayer 345, and a photoconversion unit 350; wherein the photoconversion unit 350 may comprise one or more layer, wherein the photoconversion unit comprises an electron donor compound and an electron acceptor compound. The photoconversion unit 350 may comprise a layer 351, wherein the layer 351 comprises the electron donor compound and the electron acceptor compound. The interlayer 345 comprises the interlayer compound.

The organic light-emitting device 400 includes an anode layer 420, electron blocking layer 433, and a light-emitting layer 440 a hole injection layer 231, a hole transport layer 232,: wherein the organic light-emitting device 400 emits green light.

The organic light-emitting device 500 includes an anode layer 520, electron blocking layer 533, and a light-emitting layer 540 a hole injection layer 231, a hole transport layer 232,; wherein the organic light-emitting device 500 emits blue light.

The organic light-emitting device 600 includes an anode layer 620, electron blocking layer 633, and a light-emitting layer 640 a hole injection layer 231, a hole transport layer 232,; wherein the organic light-emitting device 600 emits red light.

The organic electronic device 200 have a common hole injection layer 231, wherein the common hole injection layer 231 is shared by the organic photodetector 300, the organic light-emitting device 400, the organic light-emitting device 500, and the organic light-emitting device 600.

The organic electronic device 200 have a common hole transport layer 232, wherein the common hole transport layer 232 is shared by the organic photodetector 300, the organic light-emitting device 400, the organic light-emitting device 500, and the organic light-emitting device 600.

The organic electronic device 200 have a common organic semiconductor layer 260 which is in particular a common electron transport layer or a common hole blocking layer, wherein the common organic semiconductor layer 260 is shared by the organic photodetector 300, the organic light-emitting device 400, the organic light-emitting device 500, and the organic light-emitting device 600.

Further, the organic electronic device 200 have a common have a common cathode layer 290, wherein the common cathode layer 290 is shared by the organic photodetector 300, the organic light-emitting device 400, the organic light-emitting device 500, and the organic light-emitting device 600.

In this Fig. 21 as already mentioned above, the organic light-emitting device 400 comprises among others an electron blocking layer 433, the organic light-emitting device 500 comprises among others an electron blocking layer 533, and the organic light-emitting device 600 comprises among others an electron blocking layer 633, while the organic

photodetector 300 does not comprise an electron blocking layer.

Referring to Fig. 22 the organic electronic device in particular a light-receiving and light-emitting device or a display device especially a display device includes a substrate 210, an organic photodetector 300, an organic light-emitting device 400, an organic light-emitting device 500, and the organic light-emitting device 600, which are separated by a pixel definition layer 700.

The organic photodetector includes 300 includes an anode layer 320, a hole injection layer 231, a hole transport layer 232, an interlayer 345, a first layer 352 of a photoconversion unit 350, and a second layer 353 of the photoconversion unit 350, an organic semiconductor layer 260 which is in particular an electron transport layer or hole blocking layer, and a cathode layer 290.

The first layer 352 of the photoconversion unit 350 may comprise the electron donor compound, the second layer 353 of the photoconversion unit 150 may comprise the electron acceptor compound.

The first layer 352 of the photoconversion unit 350 may comprise the electron donor compound and an electron acceptor compound, the second layer 353 of the photoconversion unit 350 may comprise the electron acceptor compound.

The interlayer 345 comprises an interlayer compound.

The organic light-emitting device 400 includes an anode layer 420, a hole injection layer 231, a hole transport layer 232, electron blocking layer 433, and a light-emitting layer 440, an organic semiconductor layer 260 which is in particular an electron transport layer or hole blocking layer, and a cathode layer 290; wherein the organic light-emitting device 400 emits green light.

The organic light-emitting device 500 includes an anode layer 520, a hole injection layer 231, a hole transport layer 232, electron blocking layer 533, and a light-emitting layer 540, an organic semiconductor layer 260 which is in particular an electron transport layer or hole blocking layer, and a cathode layer 290; wherein the organic light-emitting device 500 emits blue light.

The organic light-emitting device 600 includes an anode layer 620, a hole injection layer 231, a hole transport layer 232, electron blocking layer 633, and a light-emitting layer 640, an organic semiconductor layer 260 which is in particular an electron transport layer or hole blocking layer, and a cathode layer 290; wherein the organic light-emitting device 600 emits red light.

The organic electronic device 200 have a common hole injection layer 231, wherein the common hole injection layer 231 is shared by the organic photodetector 300, the organic light-emitting device 400, the organic light-emitting device 500, and the organic light-emitting device 600.

The organic electronic device 200 have a common hole transport layer 232, wherein the common hole transport layer 232 is shared by the organic photodetector 300, the organic light-emitting device 400, the organic light-emitting device 500, and the organic light-emitting device 600.

The organic electronic device 200 have a common organic semiconductor layer 260 which is in particular a common electron transport layer or a common hole blocking layer, wherein the common organic semiconductor layer 260 is shared by the organic photodetector 300, the organic light-emitting device 400, the organic light-emitting device 500, and the organic light-emitting device 600.

Further, the organic electronic device 200 have a common have a common cathode layer 290, wherein the common cathode layer 290 is shared by the organic photodetector 300, , the organic light-emitting device 400, the organic light-emitting device 500, and the organic light-emitting device 600.

In this Fig. 22 as already mentioned above, the organic light-emitting device 400 comprises among others an electron blocking layer 433, the organic light-emitting device 500 comprises among others an electron blocking layer 533, and the organic light-emitting device 600 comprises among others an electron blocking layer 633, while the organic photodetector 300 does not comprise an electron blocking layer.

Fig. 23 is a schematic view of an organic photodetector device, used to determine dark and photo current, according to an exemplary embodiment of the present invention.

Referring to Fig. 23 the organic photodetector device includes a substrate 210, an anode layer 320, a pixel definition layer 700 defining the area size of the organic photodetector device, an organic semiconductor layer stack 800 and a cathode layer.

Fig. 24 is a schematic top view of an organic photodetector device, used to determine dark and photo current, according to an exemplary embodiment of the present invention.

Referring to Fig. 24 the organic photodetector device includes a substrate 210, an anode layer 320, a pixel definition layer 700 defining the area size 710 of the organic photodetector device, an organic semiconductor layer stack 800 and a cathode layer.

## Detailed discussion

The invention is furthermore illustrated by the following examples which are illustrative only and non-binding.

Thermogravimetric analysis

The term "TGA5%" denotes the temperature at which 5 % weight loss occurs during thermogravimetric analysis and is measured in °C.

The TGA5% value may be determined by heating a 9-11 mg sample in a thermogravimetric analyzer at a heating rate of 10 K/min in an open 100 μL aluminum pan, under a stream of nitrogen at a flow rate of 20 mL/min in the balance area and of 30 mL/min in the oven area.

The TGA5% value may provide an indirect measure of the volatility and/or decomposition temperature of a compound. In first approximation, the higher the TGA5% value the lower is the volatility of a compound and/or the higher the decomposition temperature.

According to one embodiment, the TGA5% value of the interlayer compound is given as the difference between the interlayer compound and 2,2'-(perfluorocyclohexa-2,5-diene-1,4-diylidene)dimalononitrile ($F_4$-TCNQ; [29261-33-4]) as reference compound, wherein said difference is in the range of ≥15°C to <250°C; preferably ≥25°C to ≤225°C; more preferably ≥30°C to 200°C; and most preferably ≥35°C to 175°C.

A TGA5% value within this range implies a sufficiently low volatility enabling precisely controlled evaporation and a sufficiently high volatility limiting thermal stress during the evaporation, respectively.

Rate onset temperature

The rate onset temperature ($T_{RO}$) is determined by loading 100 mg compound into a VTE source. As VTE source a point source for organic materials may be used as supplied by Kurt J. Lesker Company (www.lesker.com) or CreaPhys GmbH (http://www.creaphys.com). The VTE source is heated at a constant rate of 15 K/min at a pressure of less than $10^{-5}$ mbar and the temperature inside the source measured with a thermocouple. Evaporation of the compound is detected with a QCM detector which detects deposition of the compound on the quartz crystal of the detector. The deposition rate on the quartz crystal is measured in Ångstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

According to one embodiment, the rate onset value of the interlayer compound is given as the difference between the interlayer compound and 2,2'-(perfluorocyclohexa-2,5-diene-1,4-diylidene)dimalononitrile ($F_4$-TCNQ; [29261-33-4]) as reference compound, wherein said difference is in the range of ≥5°C to ≤250°C; preferably ≥10°C to ≤225°C; more preferably ≥12°C to 200°C; and most preferably ≥15°C to 175°C.

If the rate onset temperature is below 110 °C the evaporation may be too rapid and therefore difficult to control. If the rate onset temperature is above 280 °C the evaporation rate may be too low which may result in low tact time and decomposition of the organic compound in VTE source may occur due to prolonged exposure to elevated temperatures.

The rate onset temperature is an indirect measure of the volatility of a compound. The higher the rate onset temperature the lower is the volatility of a compound.

Calculated HOMO and LUMO

The HOMO energy evel, the LUMO energy level, the energy gap (Egap) between the LUMO energy level and the HOMO energy level are calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) wherein the optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

General procedure for fabrication of organic photodetectors

For inventive examples and comparative examples in Table 4, a glass substrate with an anode layer comprising a first anode sub-layer of 120 nm Ag, a second anode sub-layer of 8 nm ITO and a third anode sub-layer of 7 nm ITO was cut to a size of 25 mm × 25 mm × 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then N-(9,9-diphenyl-9H-fluoren-2-yl)-N,9-diphenyl-9H-carbazol-2-amine ([1607480-22-7]) was vacuum co-deposited with 3 wt% of 4,4',4"-((1E,1'E,1"E)-cyclopropane-1,2,3-triylidenetris(cyanomethanylylidene))tris(2,3,5,6-tetrafluorobenzonitrile) ([1224447-88-4]) to form a hole injection layer having a thickness of 10 nm.

Then N-(9,9-diphenyl-9H-fluoren-2-yl)-N,9-diphenyl-9H-carbazol-2-amine ([1607480-22-7]) was vacuum deposited on the hole injection layer, to form a hole transport layer having a thickness of 135 nm.

Then N-([1,1'-biphenyl]-4-yl)-9,9-dimethyl-N-(3-(9-phenyl-9H-fluoren-9-yl)phenyl)-9H-fluoren-2-amine ([2226747-62-0]) was vacuum co-deposited with 0.5 wt% 4,4',4"-((1E,1'E,1"E)-cyclopropane-1,2,3-triylidenetris(cyanomethanylylidene))tris(2,3,5,6-tetrafluorobenzonitrile) ([1224447-88-4]) on the hole transport layer, to form an electron blocking layer/hole extraction layer having a thickness of 5 nm.

Then (except for Comparative Example 1) an interlayer compound according to the invention or a comparative compound as shown in Table **4** was vacuum deposited on the electron blocking layer/hole extraction layer, to form an interlayer having a thickness of 20 nm. In Comparative Example 1 this layer was omitted.

Then Zinc phthalocyanine (ZnPc, [14320-04-8]), and Fullerene-C60 ([99685-96-8]) in a volume ratio of 1:1 were vacuum co-deposited on the interlayer, to form layer of the photoconversion unit having a thickness of 40 nm.

Then 4-([1,1'-biphenyl]-4-yl)-6-(3'-(9,9-dimethyl-9H-fluoren-4-yl)-[1,1'-biphenyl]-4-yl)-2-phenylpyrimidine ([1955546-40-3]) was vacuum deposited to form the organic semiconductor layer which is a hole blocking layer on the photoconversion layer having a thickness of 5 nm.

Then, 50 vol.-% 6,6'-(naphthalene-1,2-diylbis(4,1-phenylene))bis(2,4-diphenyl-1,3,5-triazine) and 50 vol.-% LiQ ([850918-68-2]) were vacuum co-deposited on the hole blocking layer to form an electron transport layer having a thickness of 21 nm.

Then Yb was vacuum deposited at a rate of 0.01 to 1 Å/s at $10^{-7}$ mbar on the electron transport layer to form an electron injection layer having a thickness of 1.3 nm.

Ag/Mg (90 vol% Ag) was vacuum deposited at a rate of 0.01 to 1 Å/s at $10^{-7}$ mbar to form a cathode having a thickness of 75 nm.

Then, N-(1[1,1-'biphenyl]-4-yl)-9,9,dimethyl-N-(4-(9-phenyl-9H-carbazol-3-yl)phenyl)-9H-fluoren-2-amine} (N-1) was vacuum deposited on the cathode layer to form a capping layer with a thickness of 75 nm.

Substrate temperature during deposition process is at room temperature. Waiting time in between individual layers is less than 60 minutes. Deposition is done in the dark.

The device stack is protected from ambient conditions by encapsulation of the device with a glass lid. The glass lid provides a cavity, which includes a getter material for further protection.

**Measurement of the photocurrent by illumination of the organic photodetector**

The photocurrent by illumination of the organic photodetector having an area size of 6.35 $mm^2$ is measured in a box under illumination by applying a voltage of -3V$\pm$0.05 at 22°C.

The voltage is applied by means of Keithley SM2635B and the current density is determined by means of Keithley SM2635B. The positive pol of current-voltage measuring device (source measure unit) Keithley SM2635B is connected to the anode layer of the organic photodetector, and the negative pol of source measure unit Keithley SM2635B is connected to the cathode layer of the organic photodetector. The voltage is applied for a period (duration) of at least one second before the current is measured with a measurement time of 5 NPLC (Number of Power Line-Cycles).

For device illumination 2 sets of RGB LEDs (Cree CLIX6F-FKC-CKNNQDGBB7A363) are used. In total 6 LEDs: 2x red, 2x blue, 2x green, while each is driven with 0.63mA. LEDs are circular arranged and have lateral distance of 7.6mm to each other. Distance each diode to center is 3.8mm, respectively. Vertical distance from center to organic photodetector is 13mm. The area size of the organic photodetector is determined by the area wherein the anode layer, cathode layer, and the layers between the anode layer and the cathode layer overlaps.

In the overlap of the area anode layer, cathode layer, and the layer between the anode layer and cathode layer are stacked on top of each other. The anode layer area may be defined by a pixel definition layer aperture like shown in figures 21/22.

**Measurement of the dark current (current under dark conditions) of the organic photodetector**

The dark current of the organic photodetector having an area size of 6.35 $mm^2$ is measured in a box in dark conditions by applying a voltage from -3V$\pm$0.05 at 22°C.

The voltage is applied by means of Keithley SM2635B and the current density is determined by means of Keithley SM2635B. The positive pol of source measure unit Keithley SM2635B is connected to the anode layer of the organic photodetector, and the negative pol of source measure unit Keithley SM2635B is connected to the cathode layer of the organic photodetector. The voltage is applied for a period (duration) of at least one second before the current is measured with a measurement time of 5 NPLC (Number of Power Line-Cycles).

The structures of some of the compounds used can be seen in the following Table 1:

Table 1: Structures of some of the compounds used in the experimental section

| | | | |
|---|---|---|---|
| | [1607480 -22-7] | N-(9,9-diphenyl-9H-fluoren-2-yl)-N,9-diphenyl-9H-carbazol-2-amine | 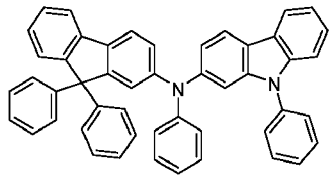 |
| | [1224447 -88-4] | 4,4',4"-((1E,1'E,1"E)-cyclopropane-1,2,3-triylidenetris(cyanomethanylylidene))tris(2,3,5 ,6-tetrafluoro-benzonitrile) | 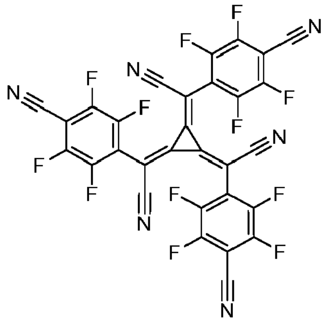 |
| | [2226747 -62-0] | N-([1,1'-biphenyl]-4-yl)-9,9-dimethyl-N-(3-(9-phenyl-9H-fluoren-9-yl)phenyl)-9H-fluoren-2-amine | 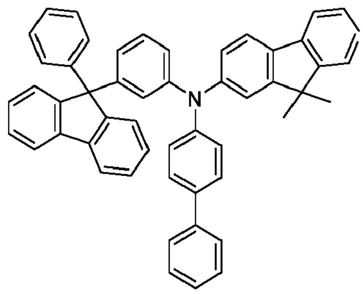 |
| ZnPc | [14320-04-8] | Zinc phthalocyanine | 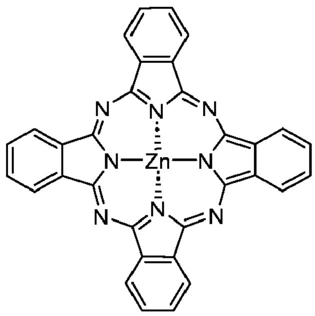 |
| C60 | [99685-96-8] | Fullerene-C60 | 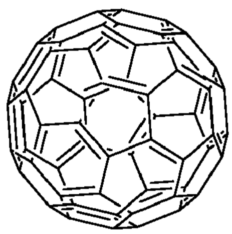 |
| | [1955546 -40-3] | 4-([1,1'-biphenyl]-4-yl)-6-(3'-(9,9-dimethyl-9H-fluoren-4-yl)- [1,1'-biphenyl] -4-yl)-2-phenylpyrimidine | 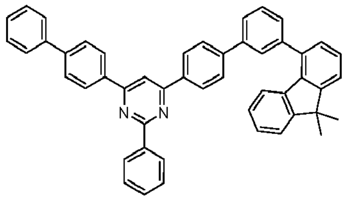 |

(continued)

| | | | |
|---|---|---|---|
| | [2244287 -14-5] | 6, 6'-(naphthalene-1, 2-diylbis(4,1-phenylene)) bis(2,4-diphenyl-1,3,5-triazine) | 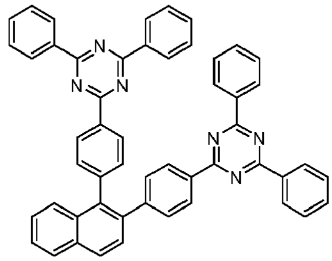 |
| LiQ | [850918-68-2] | (8-Hydroxyquinolinato)lithium; | 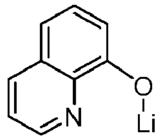 |

**Technical effect of the invention**

The properties of selected interlayer compounds used in devices according to the invention and in a comparative device can be obtained in Table 3 below (LUMO, HOMO and $E_{gap}$ only for the interlayer compounds used in inventive devices). RMS and enthalpy of fusion $\Delta H_{fus}$ were measured as described above.

Additionally the molecular weight, TGA 5% and Rate onset for the interlayer compounds used in the inventive devices and a comparativ compounds can be seen in Table 2 below:

Table 2: Molecular weight, TGA 5% and Rate onset for compounds used in the inventive devices and a comparative compound

| **Compound** | **Molecular weight [g/mol]** | **TGA5% [°C]** | **Rate onset [°C]** |
|---|---|---|---|
| F4-TCNQ | 276,15 | 272 | 102 |
| A1 | 312,32 | 322 | 138 |
| A2 | 340,37 | 318 | 142 |
| A50 | 311,94 | 318 | 139 |
| A72 | 578,78 | 419 | 223 |
| A73 | 294,22 | 336 | 157 |

It can been seen that the compounds used in the inventive device exhibit a good TGA5% value.

A good TGA5% (suitable volatility) may be beneficial for better controlling the processing of the organic electronic device by a thermal evaporation process, in particular in mass production.

It can been seen that the compounds used in the inventive device exhibit a good rate onset temperature value.

A good rate onset temperature may be beneficial for better controlling the processing of the organic electronic device by a thermal evaporation process, in particular in mass production.

Table 4 shows the setup and properties of several comparative and inventive devices. The dark current of the organic photodetector (OPD) refers to the current density of the OPD when no light (dark conditions) is applied on the OPD. The illumination of the OPD, refers to a state when light is applied on the OPD.

The photocurrent density Jph refers to the current density of the OPD when light is applied on the OPD. The signal to noise ratio (SNR) is the ratio between the dark current density (current density of the OPD when no light (dark conditions) is applied on the OPD) and the photocurrent (current density of the OPD when light is applied on the OPD).

For the nomenclature and structure of the compounds used in the comparative examples, it is referred to Table 3.

Table 4: Setup and properties of several comparative and inventive examples.

| | Interlayer Compound | Illumination of the OPD Photocurrent density $J_{ph}$ at -3V [mA/cm$^2$] | Ilumination of the OPD Photocurrent density Rel. to comparative example 1 [%] | Current density of OPD under dark conditions (Dark current) at at -3V [mA/cm$^2$] | Signal to noise ratio (SNR) |
|---|---|---|---|---|---|
| *Comparative example 1* | | -1.88E-03 | 100% | | 9 |
| Comparative example 2 | C1 | -1.25E-03 | 66% | | 13 |
| Inventive example 1 | A1 | -3.59E-02 | 1910% | -1.35E-04 | 266 |
| Inventive example 2 | A2 | -5.48E-02 | 2915% | -3.56E-04 | 154 |
| Inventive example 3 | A50 | -1.16E-02 | 617% | -7.06E-05 | 164 |
| Inventive example 4 | A72 | -3.13E-02 | 1665% | -6.96E-05 | 450 |
| Inventive example 5 | A73 | -3.79E-02 | 2016% | -3.29E-04 | 115 |
| *Jph = Photocurrent, | | | | | |

In comparative example 1, which is also used as reference example, the first layer of the photoconversion unit comprises an electron donor compound and an electron acceptor compound. The comparative example 1 does not comprise an interlayer comprising an interlayer compound.

In the comparative example 2, the interlayer comprises C1 as an interlayer compound. C1 has a root mean square roughness measured by atomic force microscopy of 0.27 nm and an enthalpy of fusion ΔHfus measured by differential scanning calorimetry of 101 J/g.

In the inventive example 1, the interlayer comprises A1 as an interlayer compound. A1 has a root mean square roughness measured by atomic force microscopy of 47 nm and an enthalpy of fusion ΔHfus measured by differential scanning calorimetry of 130 J/g.

In the inventive example 2, the interlayer comprises A2 as an interlayer compound. A2 has a root mean square roughness measured by atomic force microscopy of 57 nm and an enthalpy of fusion ΔHfus measured by differential scanning calorimetry of 124 J/g.

In the inventive example 3, the interlayer comprises A50 as an interlayer compound. A50 has a root mean square roughness measured by atomic force microscopy of 30 nm and an enthalpy of fusion ΔHfus measured by differential scanning calorimetry of 130 J/g.

In the inventive example 4, the interlayer comprises A72 as an interlayer compound. A72 has a root mean square roughness measured by atomic force microscopy of 43 nm and an enthalpy of fusion ΔHfus measured by differential scanning calorimetry of 79 J/g.

In the inventive example 5, the interlayer comprises A73 as an interlayer compound. A73 has a root mean square roughness measured by atomic force microscopy of 37 nm and an enthalpy of fusion ΔHfus measured by differential scanning calorimetry of 170 J/g.

It is apparent that the comparative example 1 without an interlayer compound or the comparative example 2 with compound which has not a root mean square roughness measured by atomic force microscopy equal or above 7 nm and an enthalpy of fusion ΔHfus measured by differential scanning calorimetry equal or above 60 J/g exhibit a lower photocurrent than the inventive examples 1 to 5 comprising an interlayer compound having a root mean square roughness measured by atomic force microscopy equal or above 7 nm and an enthalpy of fusion ΔHfus measured by differential scanning calorimetry equal or above 60 J/g. The Comparative Example 1 even shows a lower photocurrent than comparative Example 1, i.e. a device where no interlayer is used at all.

A good photocurrent density may be beneficial for the responsitivity of an organic photodetector.

It is apparent that the comparative example 1 without an interlayer compound or the comparative example 2 with compound which has not a root mean square roughness measured by atomic force microscopy equal or above 7 nm and an enthalpy of fusion ΔHfus measured by differential scanning calorimetry equal or above 60 J/g exhibit a higher signal to noise ratio than the inventive examples 1 to 5 comprising an interlayer compound having a root mean square roughness measured by atomic force microscopy equal or above 7 nm and an enthalpy of fusion ΔHfus measured by differential scanning calorimetry equal or above 60 J/g.

A high signal to noise ratio may be beneficial for the sensitivity of an organic photodetector.

Table 3: Data for compounds used in comparatives and inventive devices

| Compound | Structure | LUMO [eV] | HOMO [eV] | Egap [eV] | RMS roughness (nm)* | Enthalpy of fusion $\Delta H_{fus}$ [J/g] |
|---|---|---|---|---|---|---|
| C1 | 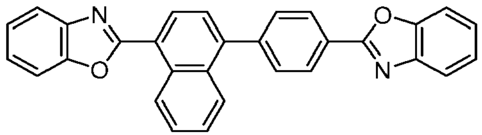 | -1.98 | -5.61 | 3.63 | 0.27 | 101 |
| A1 | 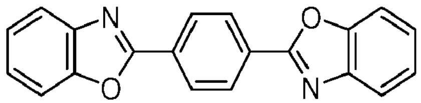 | -2.07 | -5.89 | 3.82 | 47 | 130 |
| A2 | 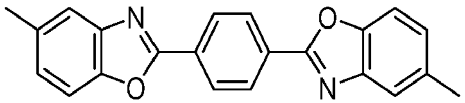 | -2.00 | -5.78 | 3.78 | 57 | 124 |
| A50 | 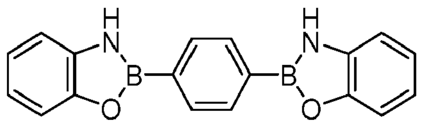 | -0.82 | -5.29 | 4.47 | 30 | 130 |
| A72 | 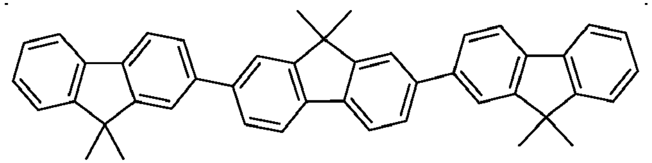 | -1.38 | *-5.19* | 3.81 | 43 | 79 |
| A73 | 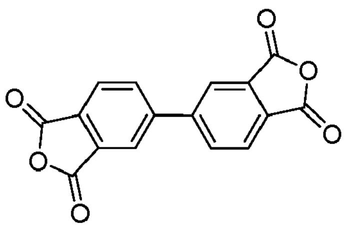 | -3.25 | -7.76 | 4.51 | 37 | 170 |

*RMS roughness=Root Mean Square roughness measured by atomic force microscopy (AFM)

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. An organic photodetector comprising

an anode layer, a cathode layer, photoconversion unit comprising one or more layer, an interlayer, and an organic semiconductor layer;
wherein the photoconversion unit comprises a donor compound, and an acceptor compound,
wherein the photoconversion unit is arranged between the anode layer and the organic semiconductor layer,
wherein the organic semiconductor layer is arranged between the photoconversion unit and the cathode layer,
wherein the interlayer is arranged between the anode layer and the photoconversion unit; wherein the interlayer is in direct contact to the photoconversion unit;
wherein the interlayer comprises an interlayer compound that either

◦ has a root mean square roughness measured by atomic force microscopy of ≥7 nm and an enthalpy of fusion $\Delta H_{fus}$ measured by differential scanning calorimetry of ≥ 60 J/g; or

- is a compound of formula (I) :

$$Ar^1\text{-}L\text{-}Ar^2 \qquad (I)$$

wherein $Ar^1$, and $Ar^2$ are independently selected from formula (II)

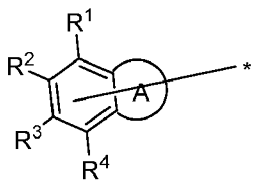
(II),

wherein the asterisk "*" denotes the binding position to L;
wherein L can be bound to A or one of $R^1$ to $R^4$;
wherein
A is a substituted or unsubstituted 5-membered carbocycle or a substituted or unsubstituted 5-membered heterocycle; wherein optionally one or more additional rings can be fused to A to form a ring system;
L is independently selected from a bond, a substituted or unsubstituted $C_6$ to $C_{30}$ aryl, a substituted or unsubstituted $C_2$ to $C_{24}$ heteroaryl,
wherein one or more substituents on L are independently selected from D, halogen, F, nitro, CN, a substituted or unsubstituted branched or unbranched $C_1$ to $C_{20}$ alkyl, a substituted or unsubstituted $C_6$ to $C_{12}$ aryl, a substituted or unsubstituted $C_3$ to $C_{12}$ heteroaryl, a substituted or unsubstituted $C_3$ to $C_{12}$ carbocyclyl, a substituted or unsubstituted $C_2$ to $C_{12}$ heterocyclyl,
wherein the one or more substituents of the one or more substituent on $L^1$ or $L^2$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^1$ to $R^4$ are independently selected from H, D, a substituted or unsubstituted branched or unbranched $C_1$ to

$C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen, F, nitro, or CN,

wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN; with the proviso that when L is bound to one of $R^1$ to $R^4$, then said one of $R^1$ to $R^4$ to which L is bound to is a bond.

**2.** The organic photodetector of the claim 1, wherein the interlayer compound has a root mean square roughness measured by atomic force microscopy of ≥7 nm and an enthalpy of fusion of $\Delta H_{fus}$ measured by differential scanning calorimetry of ≥ 60 J/g and is a compound of formula (I).

**3.** The organic photodetector of claim 1 or 2 whereby the interlayer is an electron extraction layer and/or the interlayer compound is an electron extraction material.

**4.** The organic photodetector of any of the claims 1 to 3, whereby the organic semiconductor layer is a hole blocking layer and/or electron transport layer or comprises a hole blocking material and/or an electron transport material.

**5.** The organic photodetector of any of the claims 1 to 4 wherein the interlayer compound has a LUMO energy level in the range of ≥ -3.10 eV to ≤ -0.6eV

**6.** The organic photodetector of any of the claims 1 to 5, whereby the interlayer compound has an energy gap $E_{gap}$ between its LUMO energy level and its HOMO energy level of ≥2.6 eV.

**7.** The organic photodetector of any of the claims 1 to 6, whereby the interlayer compound has a molecular weight of 200 g/mol to 650 g/mol.

**8.** The organic photodetector of any of the claims 1 to 7, wherein the additional compound has $C_{2h}$-symmetry.

**9.** The organic photodetector of any of the claims 1 to 8, whereby in in formula (I) $Ar^1$ and $Ar^2$ are selected the same.

**10.** The organic photodetector of any of the claims 1 to 9, wherein formula (I), $Ar^1$ and $Ar^2$ are independently selected from formula (III)

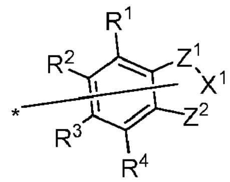

(III)

wherein the asterisk "*" denotes the binding position to L;
wherein L can be bound to A or one of $R^1$ to $R^4$;
wherein
$Z^1$ is selected from N, $NR^a$, C=O, C, $C(R^b)$,
$Z^2$ is selected from S, O, C=O, $C(R^c)_2$, NH, ND, $NR^a$,;
$X^1$ is selected from B, C, N, O;
$Z^2$ and $X^1$ or $Z^1$ and $X^1$ may form a six membered aromatic ring or six membered heteroaromatic ring;
$Z^1$ and $X^1$ or $Z^2$ and $X^1$ can form a double bond;
$R^a$ is selected from H, D, a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,
wherein the one or more substituents on $R^a$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;
$R^b$ is selected from a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,

wherein the one or more substituents on $R^b$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;

each $R^c$ is independently selected from a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,

wherein the one or more substituents on $R^c$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;

$R^1$ to $R^4$ are independently selected from H, D, a substituted or unsubstituted branched or unbranched $C_1$ to $C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen, F, nitro, or CN,

wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN. with the proviso that when L is bound to one of $R^1$ to $R^4$, then said one of $R^1$ to $R^4$ to which L is bound to is a bond.

**11.** The organic photodetector of any of the claims 1 to 10, wherein the interlayer essentially consists of the interlayer compound.

**12.** An organic electronic device comprising

a substrate, an organic photodetector, an organic light-emitting device;

wherein the organic photodetector and the organic light-emitting device is disposed on the substrate;

wherein the organic photodetector is an organic photodetector according to any of the claims 1 to 11.

wherein the organic light-emitting device comprises

an anode layer, a cathode layer, an organic semiconductor layer, a light-emitting layer a cathode layer;

wherein the organic semiconductor layer and the light-emitting layer are arranged between the anode layer and the cathode layer;

wherein the organic semiconductor layer is arranged between the cathode layer and the organic light-emitting layer;

**13.** The organic electronic device according to Claim 12 whereby the organic electronic device is a display device.

**14.** Use of a compound having a root mean square roughness measured by atomic force microscopy of ≥7 nm and an enthalpy of fusion $\Delta H_{fus}$ measured by differential scanning calorimetry of ≥ 60 J/g for photo detection and/or a compound of formula (I) for photo detection.

**15.** Use of a compound of formula (I), whereby $Ar^1$ and $Ar^2$ are independently selected from formula (XI):

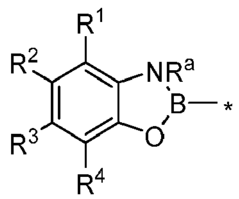

(XI),

wherein

$R^a$ is selected from H, D, a substituted or unsubstituted branched or unbranched $C_1$ to $C_{20}$ alkyl, a substituted or unsubstituted $C_6$ to $C_{20}$ aryl, a substituted or unsubstituted $C_5$ to $C_{20}$ heteroaryl, a substituted or unsubstituted $C_3$ to $C_{20}$ carbocyclyl, a substituted or unsubstituted $C_2$ to $C_{20}$ heterocyclyl,

wherein the one or more substituents on $R^a$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN;

$R^1$ to $R^4$ are independently selected from H, D, a substituted or unsubstituted branched or unbranched $C_1$ to $C_{20}$ alkyl, a substituted or unsubstituted $C_6$ to $C_{20}$ aryl, a substituted or unsubstituted $C_3$ to $C_{20}$ heteroaryl, a substituted or unsubstituted $C_3$ to $C_{20}$ carbocyclyl, a substituted or unsubstituted $C_2$ to $C_{20}$ heterocyclyl, halogen, F, nitro, or CN,

wherein the one or more substituents on $R^1$ to $R^4$ are independently selected from D, branched or unbranched $C_1$ to $C_{20}$ alkyl, $C_6$ to $C_{20}$ aryl, $C_5$ to $C_{20}$ heteroaryl, $C_3$ to $C_{20}$ carbocyclyl, $C_2$ to $C_{20}$ heterocyclyl, halogen, F, nitro, or CN in an organic electronic device and/or for light emission and/or for photodetection.

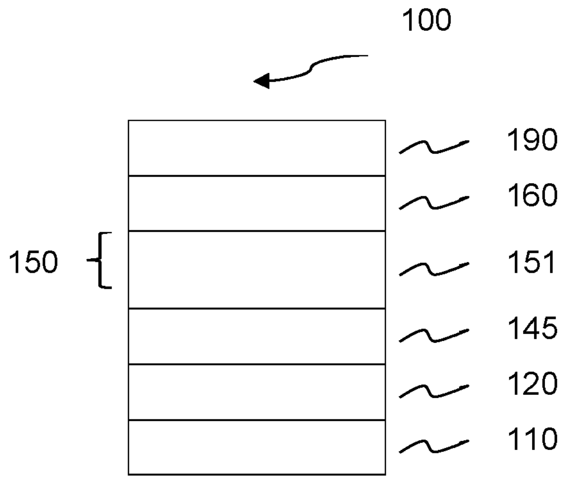
100
190
160
150
151
145
120
110

Fig. 1

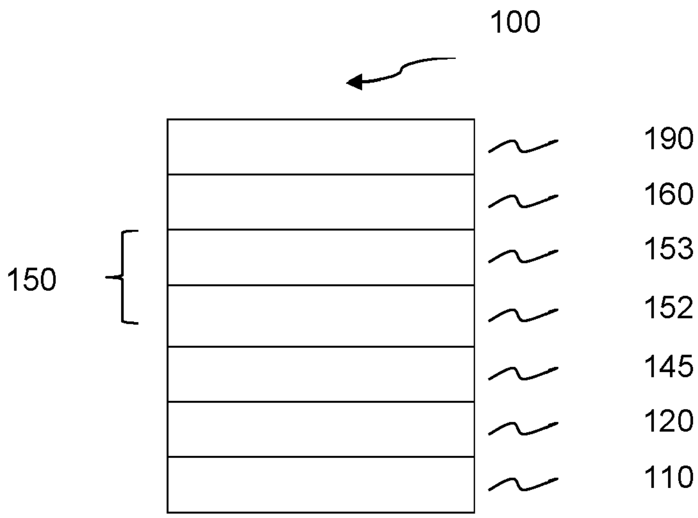
100
190
160
150
153
152
145
120
110

Fig. 2

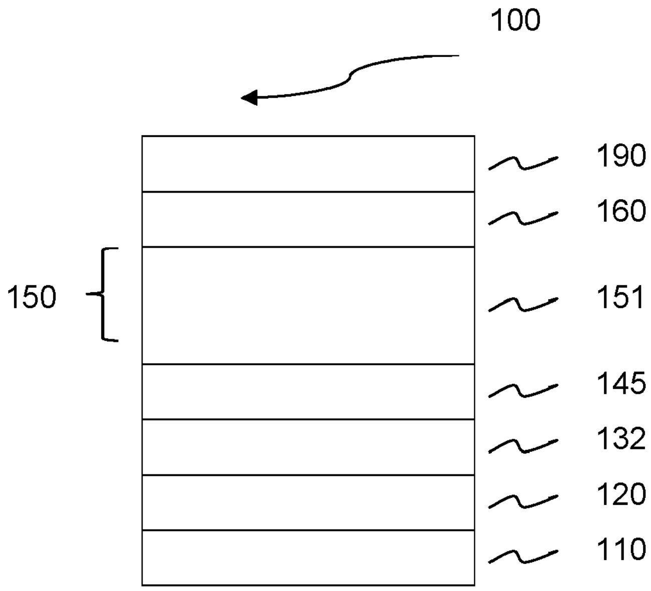
100
190
160
150
151
145
132
120
110

Fig. 3

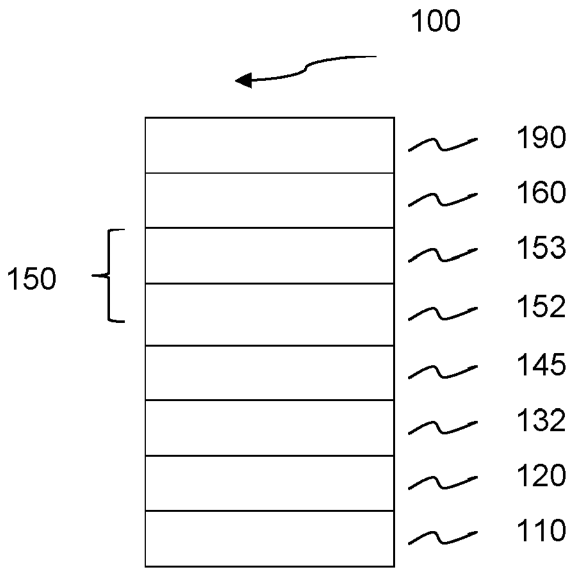
100
190
160
150
153
152
145
132
120
110

Fig. 4

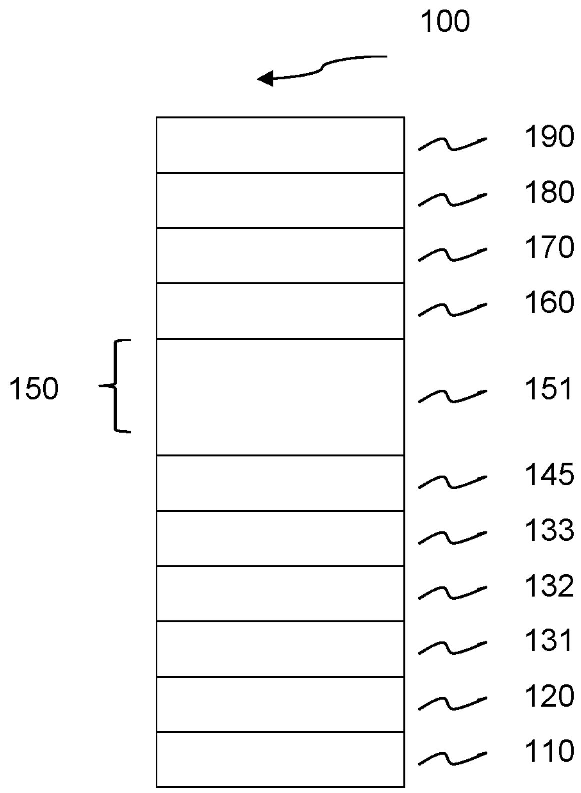


Fig. 5

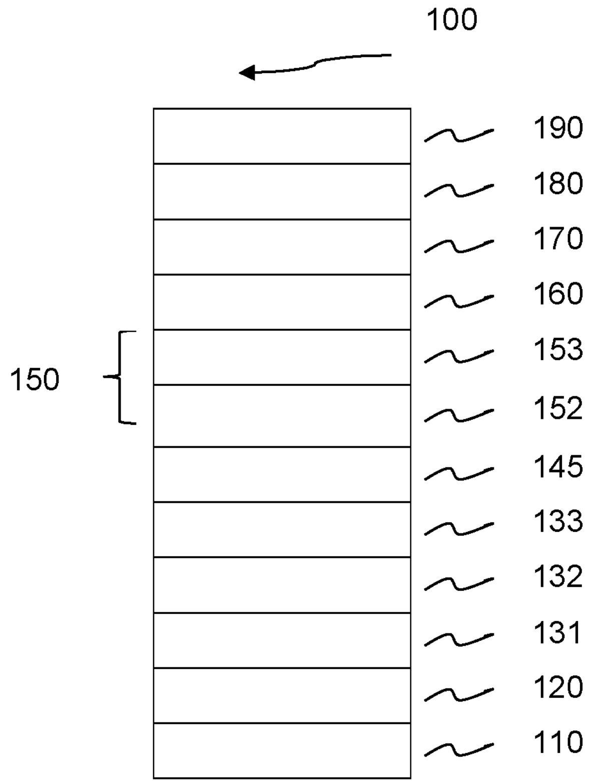


Fig. 6

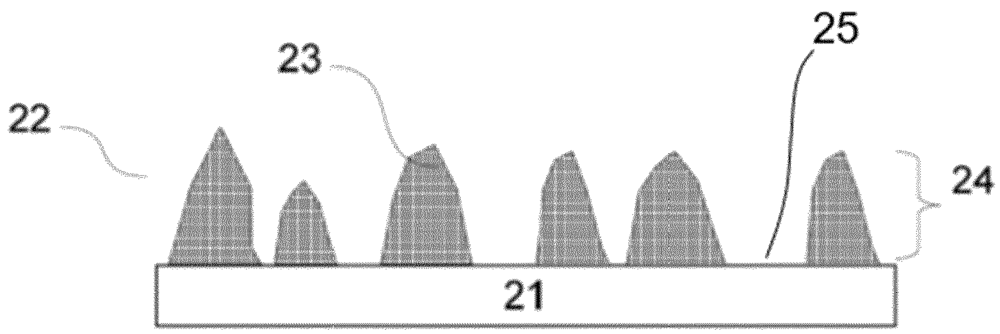


Fig. 7

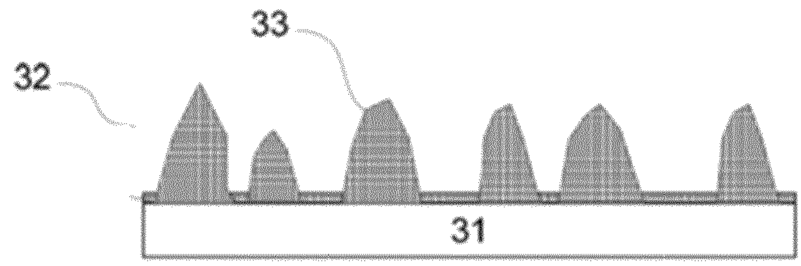


Fig. 8

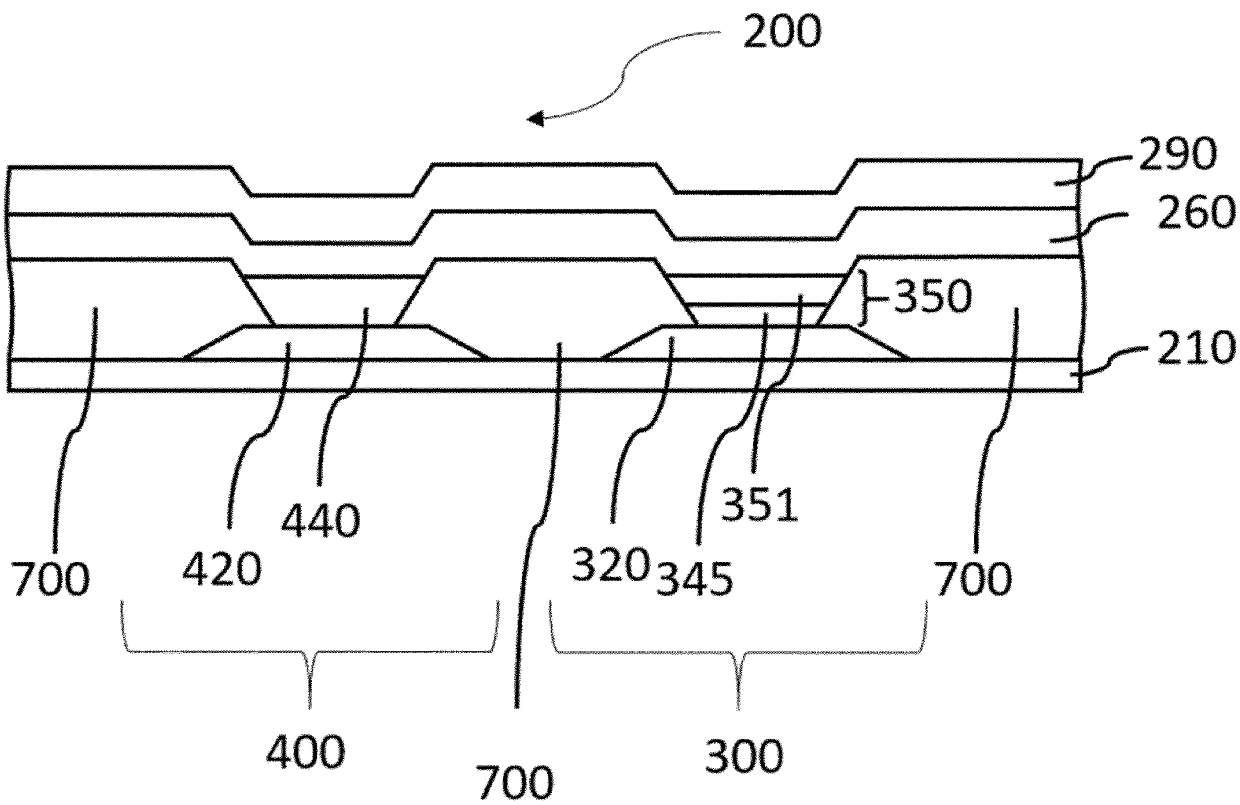


Fig. 9

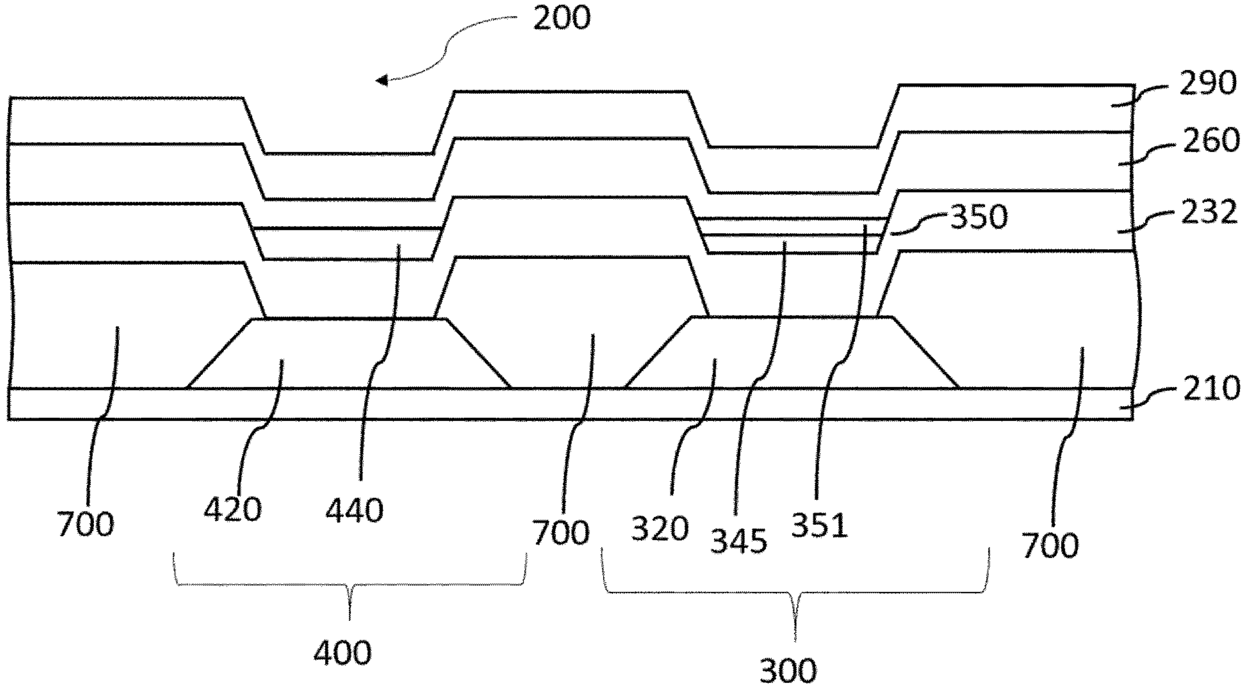


Fig. 10

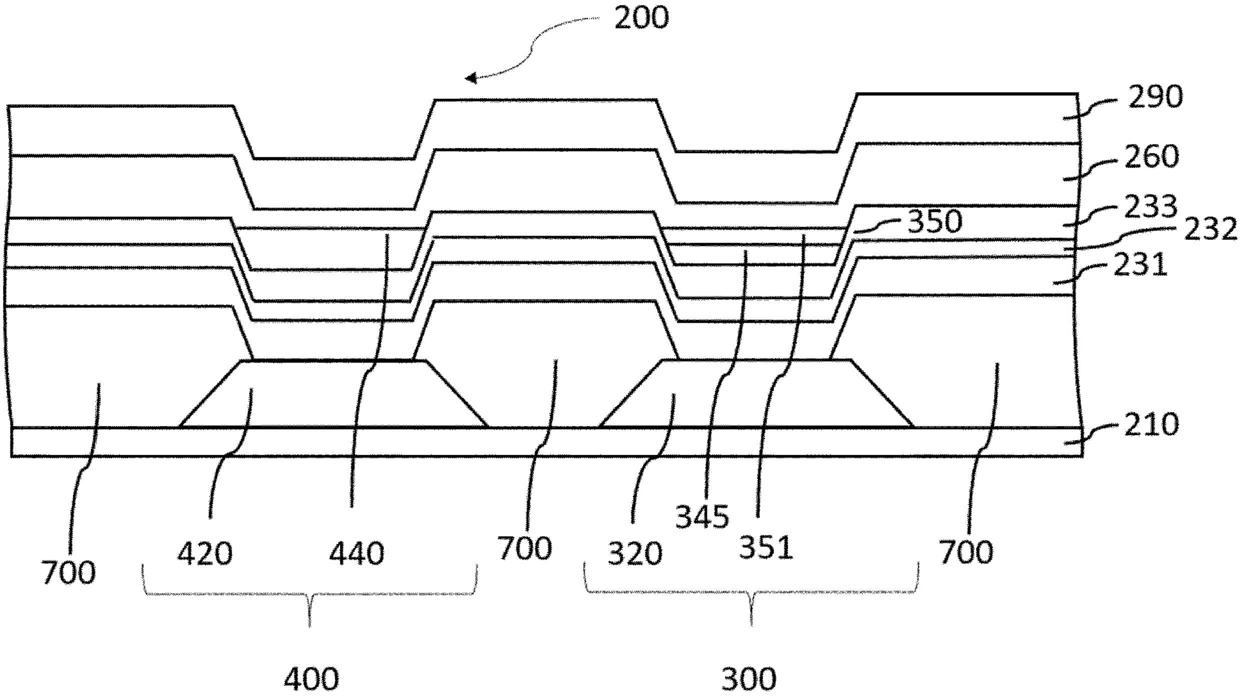
200
290
260
233
350
232
231
210
700
420
440
700
320
345
351
700
400
300

Fig. 11

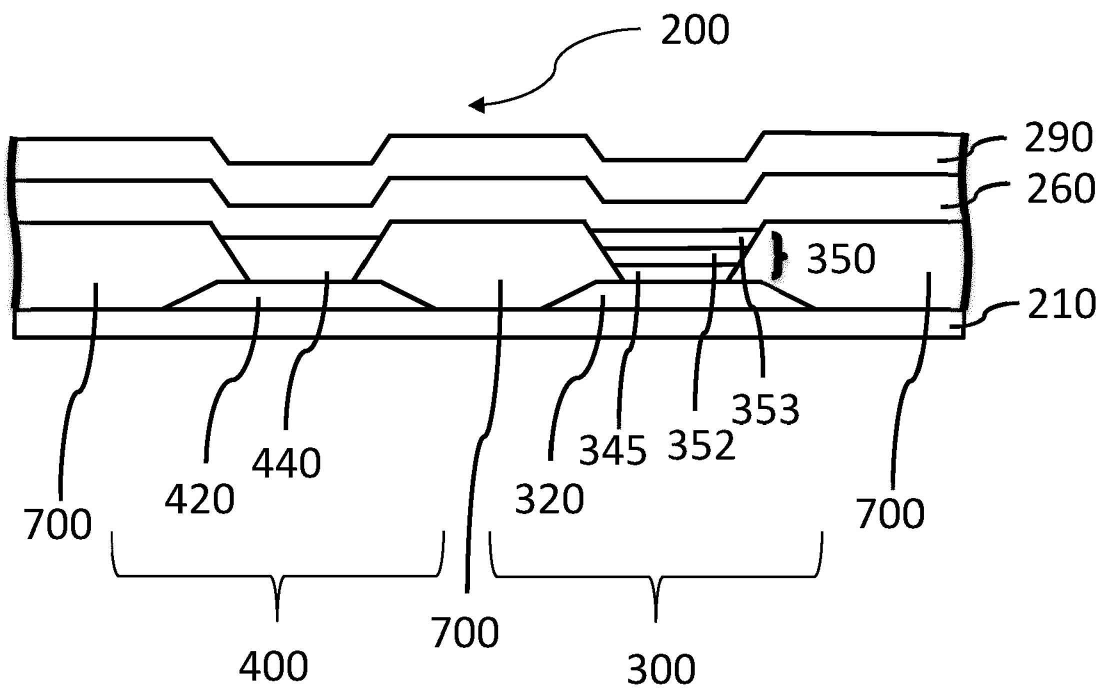


Fig. 12

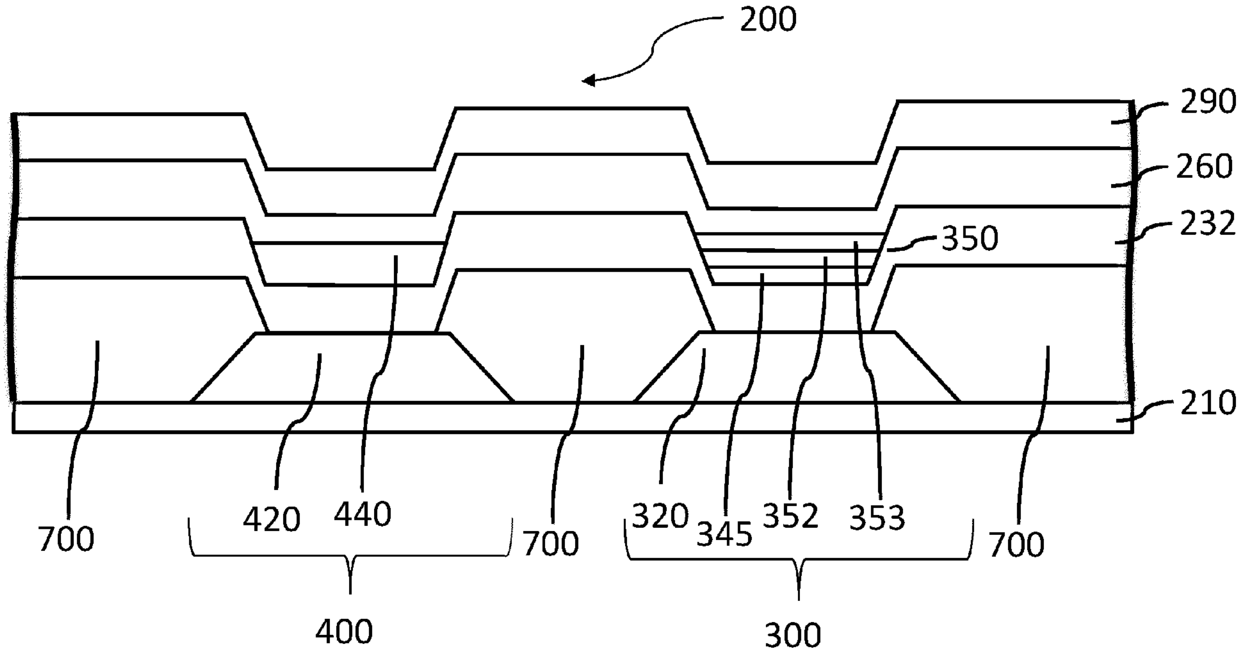
200
290
260
232
350
210
700
420
440
700
320
345
352
353
700
400
300

Fig. 13

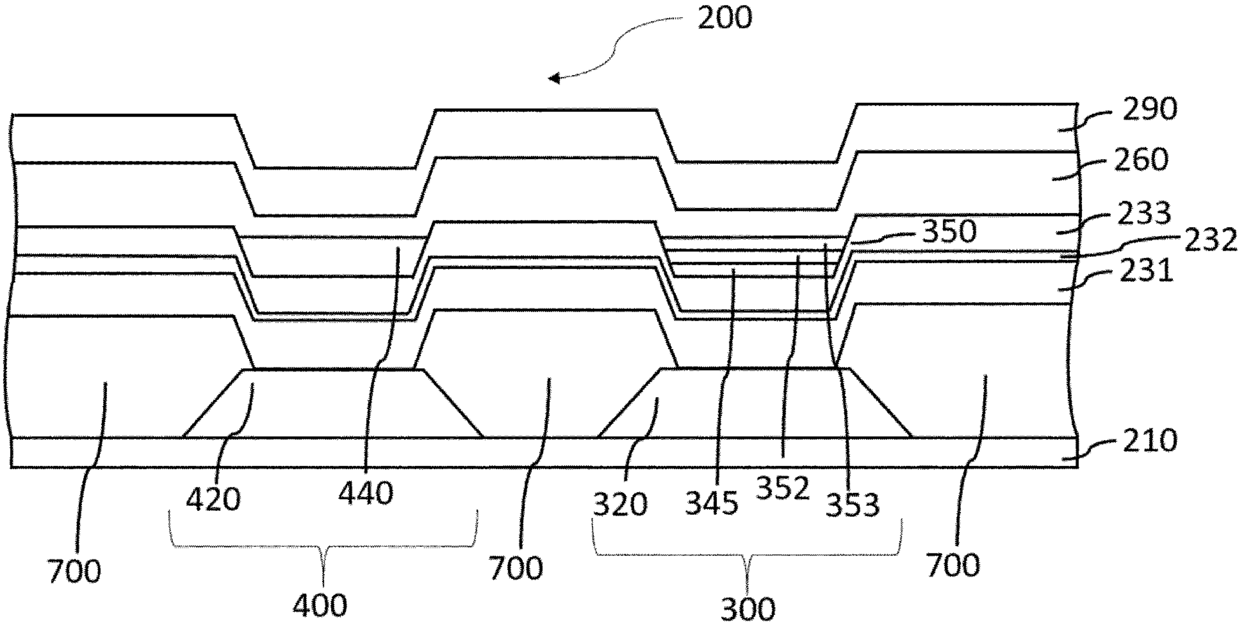
200
290
260
233
350
232
231
210
700
420
440
700
320
345
352
353
700
400
300

Fig. 14

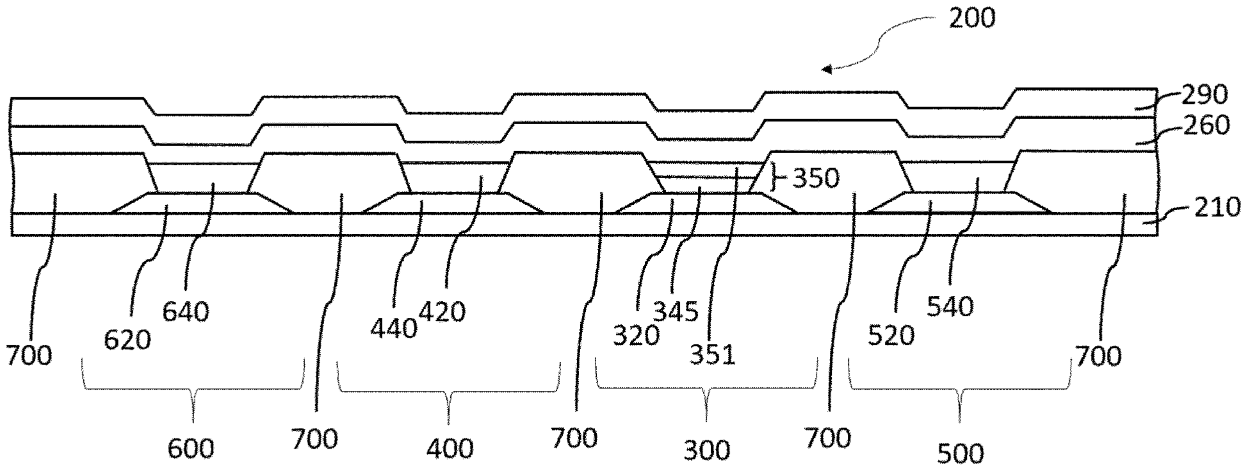
200
290
260
350
210
700
620
640
440
420
320
345
351
520
540
700
600
700
400
700
300
700
500

Fig. 15

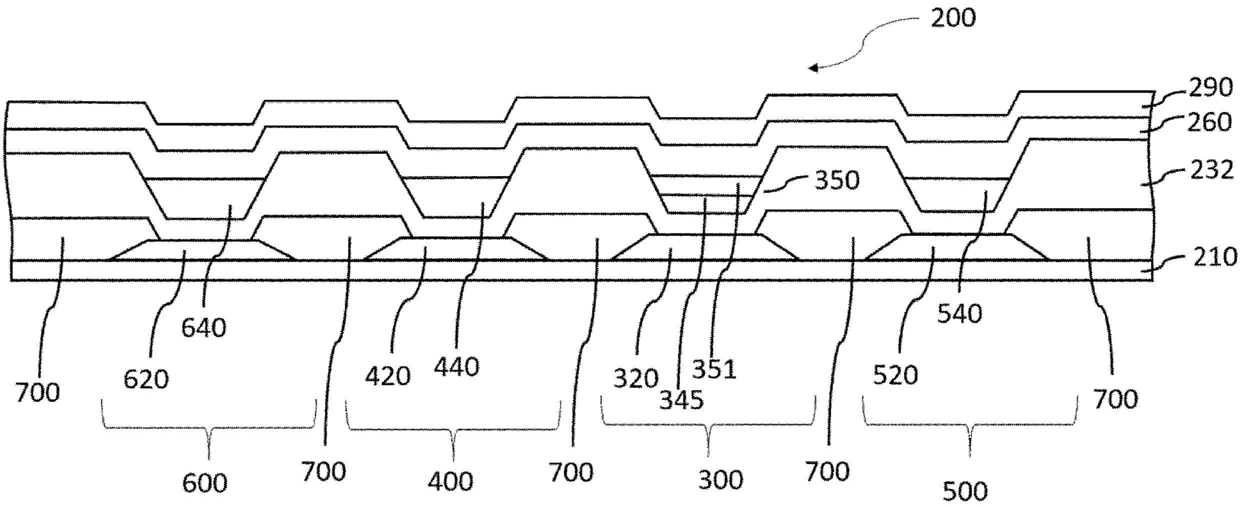
200
290
260
232
350
210
640
540
700
620
420
440
320
351
520
345
700
600
700
400
700
300
700
500

Fig. 16

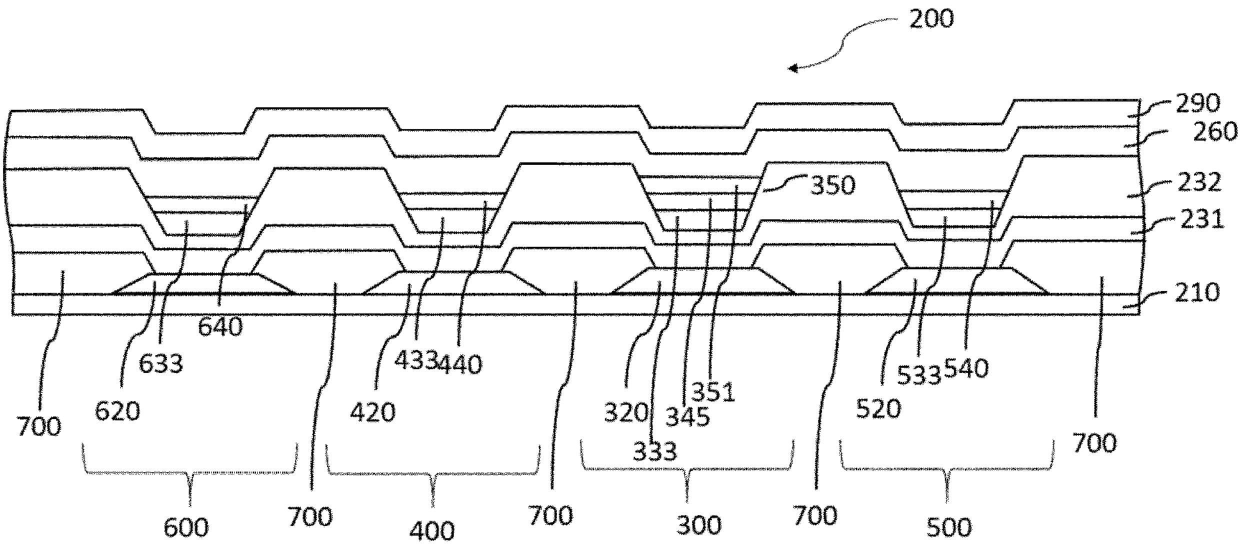
200
290
260
232
231
210
350
640
633
620
700
433
440
420
351
320
345
333
533
540
520
700
600
700
400
700
300
700
500

Fig. 17

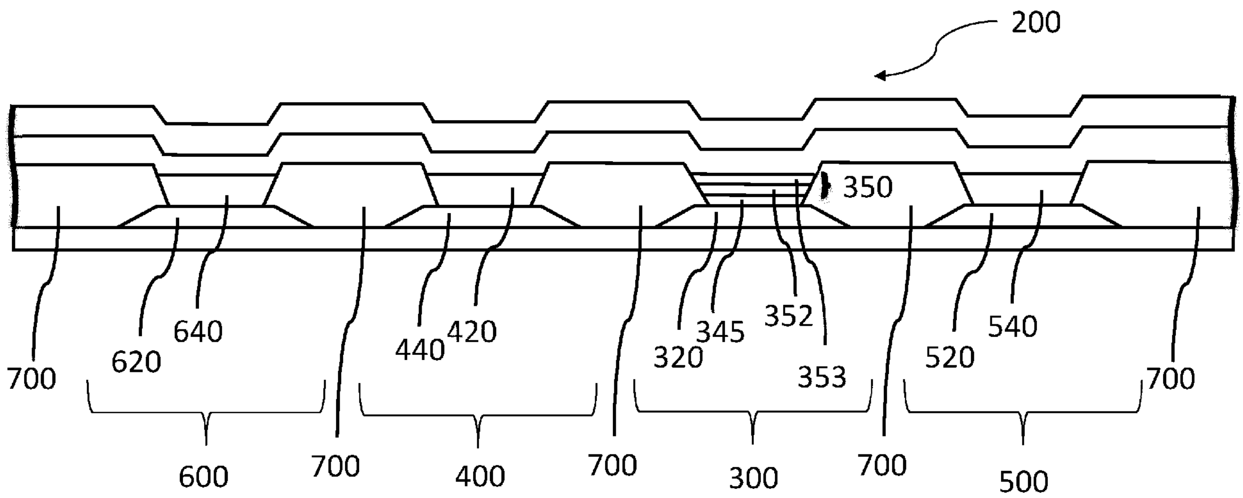
200
350
700
620
640
440
420
320
345
352
353
520
540
700
600
700
400
700
300
700
500

Fig. 18

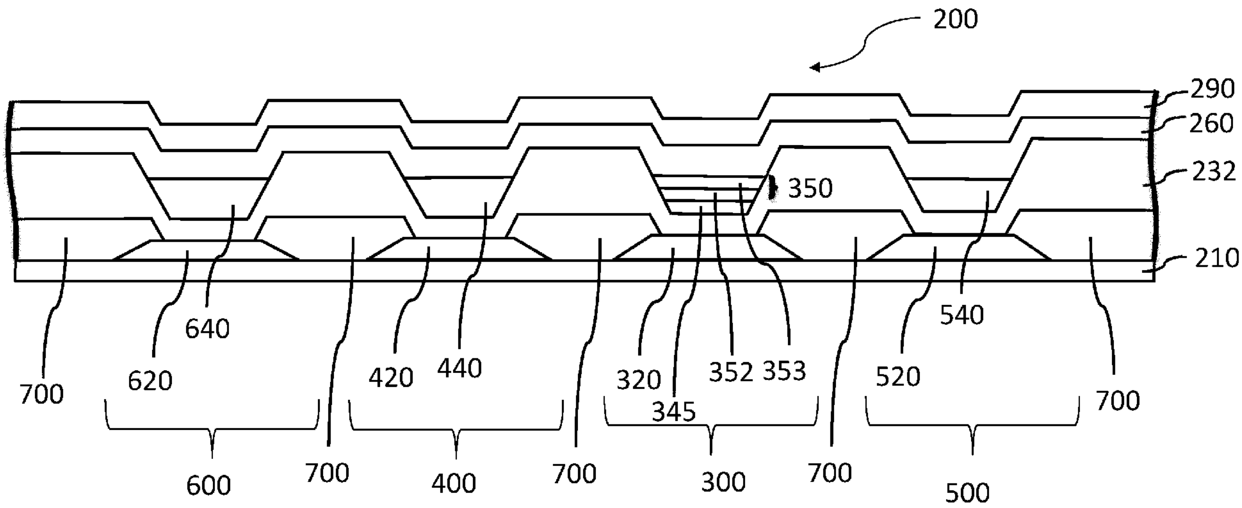
200
290
260
232
350
210
640
540
700
620
420
440
320
352
353
520
700
345
600
700
400
700
300
700
500

Fig. 19

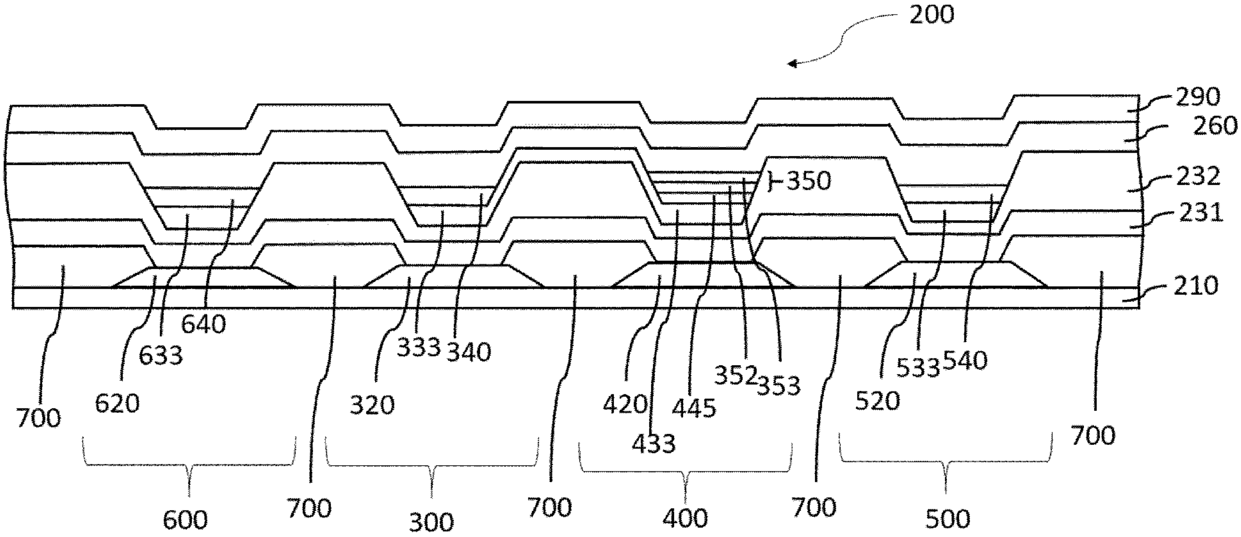
200
290
260
232
231
210
350
640
633
620
700
333
340
320
420
433
445
352
353
520
533
540
600
300
400
500

Fig. 20

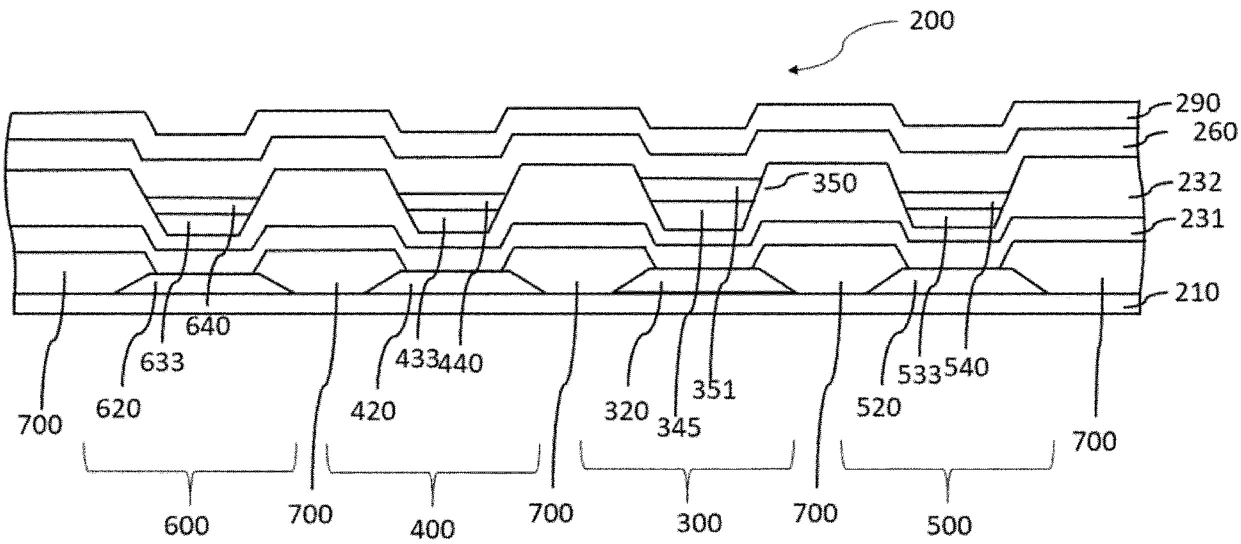
200
290
260
232
350
231
210
640
633
620
700
433
440
420
351
320
345
533
540
520
700
600
700
400
700
300
700
500

Fig. 21

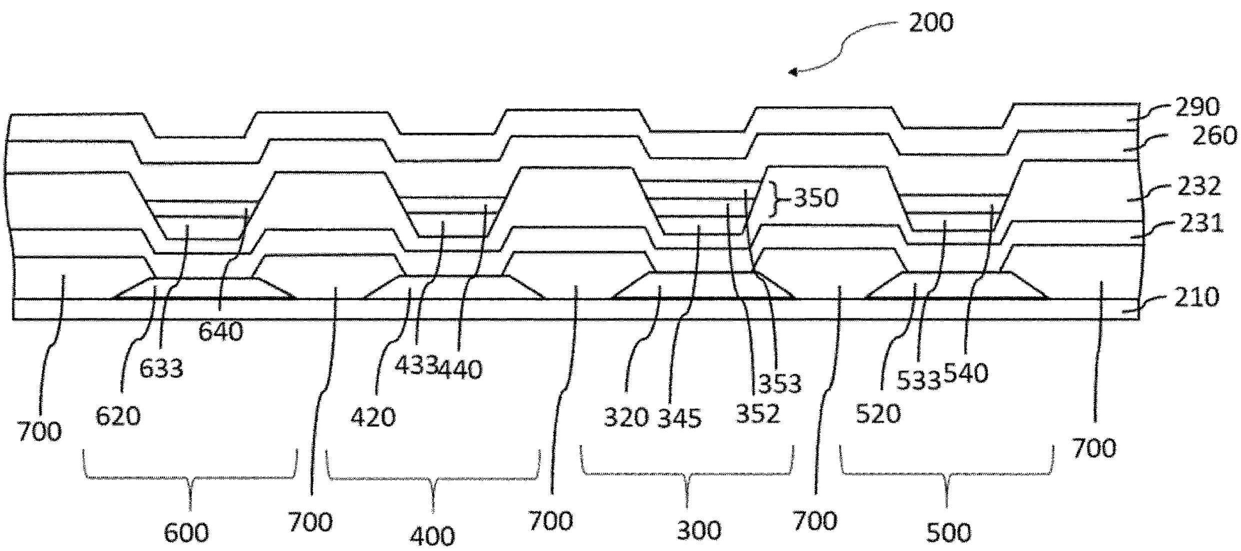
200
290
260
232
350
231
210
640
633
620
700
433
440
420
320
345
353
352
533
540
520
700
600
700
400
700
300
700
500

Fig. 22

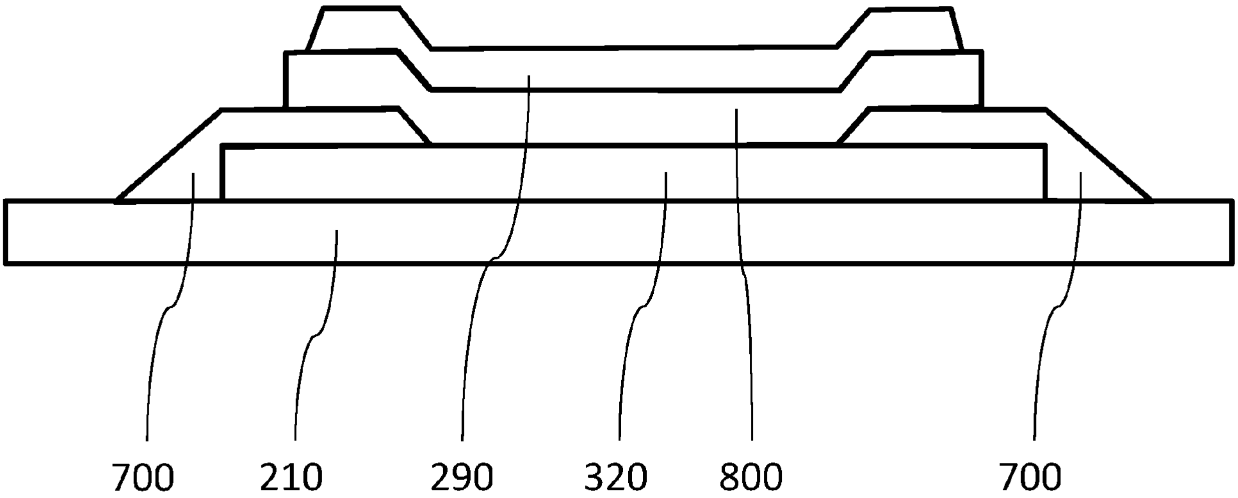


Fig. 23

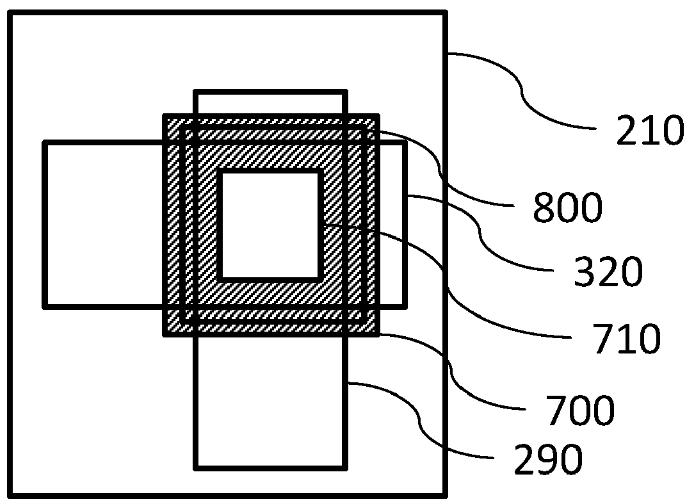


Fig. 24

Europäisches Patentamt
European Patent Office
Office européen des brevets

# EUROPEAN SEARCH REPORT

Application Number
EP 24 17 3160

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 2021/313531 A1 (YAMAGUCHI TOMONA [JP] ET AL) 7 October 2021 (2021-10-07)<br>* compounds EB-1 * | 1,3-11, 14<br>12,13 | INV.<br>H10K30/30<br>H10K30/86<br>H10K85/60 |
| X<br><br>Y | GRIGALEVICIUS SAULIUS ET AL: "Hole-transporting molecular glasses based on carbazole and diphenylamine moieties", MATERIALS CHEMISTRY AND PHYSICS, vol. 72, no. 3, 1 December 2001 (2001-12-01), pages 395-400, XP085617181, ISSN: 0254-0584, DOI: 10.1016/S0254-0584(01)00335-2<br>* compound 9 * | 1-11,14<br><br>12,13 | |
| X | US 2016/322570 A1 (STOESSEL PHILIPP [DE] ET AL) 3 November 2016 (2016-11-03)<br>* compounds 92,97,105,116,144 * | 15 | |
| Y | EP 4 358 683 A1 (SAMSUNG DISPLAY CO LTD [KR]) 24 April 2024 (2024-04-24)<br>* figures 4,5 * | 12,13 | TECHNICAL FIELDS SEARCHED (IPC)<br>H10K |

The present search report has been drawn up for all claims

| Place of search | Date of completion of the search | Examiner |
|---|---|---|
| Munich | 29 August 2024 | Wolfbauer, Georg |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO.

EP 24 17 3160

This annex lists the patent family members relating to the patent documents cited in the above-mentioned European search report. The members are as contained in the European Patent Office EDP file on
The European Patent Office is in no way liable for these particulars which are merely given for the purpose of information.

29-08-2024

| Patent document cited in search report | Publication date | Patent family member(s) | Publication date |
|---|---|---|---|
| US 2021313531 A1 | 07-10-2021 | JP 7516094 B2 | 16-07-2024 |
| | | JP 2021166242 A | 14-10-2021 |
| | | US 2021313531 A1 | 07-10-2021 |
| US 2016322570 A1 | 03-11-2016 | CN 101171320 A | 30-04-2008 |
| | | CN 103204996 A | 17-07-2013 |
| | | EP 1888706 A1 | 20-02-2008 |
| | | JP 5242380 B2 | 24-07-2013 |
| | | JP 2008541417 A | 20-11-2008 |
| | | KR 20080012337 A | 11-02-2008 |
| | | TW 200710198 A | 16-03-2007 |
| | | US 2009134384 A1 | 28-05-2009 |
| | | US 2015322091 A1 | 12-11-2015 |
| | | US 2016322570 A1 | 03-11-2016 |
| | | WO 2006117052 A1 | 09-11-2006 |
| EP 4358683 A1 | 24-04-2024 | CN 117915673 A | 19-04-2024 |
| | | EP 4358683 A1 | 24-04-2024 |
| | | KR 20240055181 A | 29-04-2024 |
| | | US 2024155864 A1 | 09-05-2024 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2722908 A1

### Non-patent literature cited in the description

- *CHEMICAL ABSTRACTS*, 207739-72-8